# EUROPEAN PATENT SPECIFICATION

(11) **EP 1 739 486 B1**
(45) Date of publication and mention of the grant of the patent: **03.06.2015**
(21) Application number: 06013473.1
(22) Date of filing: 29.06.2006
(51) Int. Cl.: G03F 7/09, B41C 1/10

(54) **Photosensitive lithographic printing plate**
Lichtempfindliche Lithografiedruckform
Plaque d'impression lithographique photosensible

(30) Priority: 29.06.2005 JP 2005189908; 20.09.2005 JP 2005272298
(43) Date of publication of application: 03.01.2007
(73) Proprietor: FUJIFILM Corporation, Minato-ku Tokyo (JP)
(72) Inventor: Nagase, Hiroyuki, Yoshida-cho Haibara-gun, Shizuoka (JP)
(74) Representative: Hoffmann Eitle

(56) References cited:
- EP-A- 1 273 971
- EP-A- 1 296 187
- US-A- 3 895 949
- US-A1- 2004 154 488
- DATABASE WPI Week 200063 Derwent Publications Ltd., London, GB; AN 2000-651047 XP002403531 & JP 2000 267292 A (FUJI PHOTO FILM CO LTD) 29 September 2000 (2000-09-29) & JP 2000 267292 A (FUJI PHOTO FILM CO., LTD.) 29 September 2000 (2000-09-29)

## Description

### FIELD OF THE INVENTION

This invention relates to a photosensitive lithographic printing plate whereby plate making can be directly conducted by scanning laser beams in accordance with digital data from computers, etc.

### BACKGROUND OF THE INVENTION

In a negative working photosensitive lithographic printing plate, in general, the image formation is carried out in a process for coating a photosensitive composition on a support such as a roughed aluminum plate, exposing a desired image, polymerizing or crosslinking a light irradiated area of the photosensitive layer to make it insoluble in a developing solution, and eluting out an unirradiated area with the developing solution. As the photosensitive composition to be used for such a purpose, photopolymerizable compositions have hitherto been well known, and a part thereof has been provided for practical use. Furthermore, recent photopolymerizable polymers with high sensitivity to visible light employing a technology of the photoinitiation system, which is of high sensitization to a region where they are used for direct plate making with a visible laser, become widespread as a so-called CTP plate.

As typical examples of recording materials compatible with ultraviolet rays or visible light laser, there are known photosensitive lithographic printing plates with the use of radical polymerization type compositions in photosensitive layers (see, for example, JP-A-8-220758 and JP-A-2000-35673).

However, a composition of the radical polymerization system suffers from a large reduction of the sensitivity by polymerization hindrance of oxygen in the atmosphere. For the purpose of preventing it, a photosensitive photographic printing plate with the use of a composition of the radical polymerization is usually provided with an oxygen-blocking protective layer. In the case where such a protective layer has a high oxygen-blocking performance, however, it has an elevated sensitivity. As a result, there arises a problem that an non-image area also hardens due to radical generated in a minor amount by scattered light during the light exposure, which causes stains in printing, i.e., a so-called flare. To overcome this problem, it is proposed that the problem of flare is ameliorated by using a low oxygen-blocking protective layer and lowering in the sensitivity caused by the low oxygen-blocking properties can be prevented by elevating the content of a polymerizable compound in a photosensitive layer (see JP-A-2003-98674). In the case of a protective layer having high oxygen-blocking properties, it is feared that the storage stability is deteriorated because of fogging caused by dark polymerization. To prevent this phenomenon, it has been a common practice to add a polymerization inhibitor to the photosensitive layer. However, it is highly difficult by the existing techniques to achieve a high sensitivity, a high printing resistance and a high storage stability at the same time.

One characteristic of the CTP system resides in that when the plate is fed into a cassette of an exposure system (a plate setter), a laminated board is automatically separated and the plate is exposed to light by the autoloader function of the plate setter. Concerning a factor required in this step, it is important that the laminate board would not stick to the protective layer but misaligned within an appropriate scope of coefficient of friction. At a high humidity, however, the laminated board is liable to stick to the protective layer, which brings about a problem that these members stick together in the course of the autoloading. That is, it is highly difficult by the existing techniques to achieve a high sensitivity, a high printing resistance, a high storage stability and a favorable autoloader suitability at the same time.

US-A-3 895 949 discloses photosensitive elements for printing comprising, in order; a support, a layer of photosensitive material and a protective layer. The protective layer prevents scratching and unwanted reactions with the photosensitive layer under conditions of humidity or temperature changes. Further, the tendency of these elements to adhere to interleaving paper is eliminated. The protective layer of this document comprises a copolymer obtained by reaction of an unsaturated carboxylic acid and a mixture of ethylenically unsaturated compounds.

JP-A-2000 267292 discloses a photosensitive lithographic printing plate comprising a support provided with a photosensitive layer, a protective overlying layer thereon and a back coating layer supplied to the opposite side of the support to the photosensitive layer. The coefficient of friction of the protective and back layers is 0.2-0.6 which reduces damage which may occur when lithographic printing plates overlap. Damaged plates tend to suffer from developmental problems and a poor printing ability. The low coefficient of friction is achieved by the inclusion of a surfactant in the compositions of the protective and back layers. Suitable surfactants include inter alia fluorine-containing surfactants.

US 2004/0154488 A discloses a lithographic printing plate support comprising a substrate having thereon a porous layer comprising metal oxide particles, the same representing a hydrophilic support. It further discloses a photosensitive layer comprising a compound having at least one ethylenically unsaturated bond and a polymer binder, and a protective layer or overcoat layer which may comprise copolymers of water-soluble 2-acrylamido-2-methyl-1-propansulfonic acid and an alkali metal salt thereof.

### SUMMARY OF THE INVENTION

An object of the invention is to provide a photosensitive lithographic printing plate which is excellent in sensitivity and printing resistance and has a high storage stability. Another object of the invention is to provide a photosensitive lithographic printing plate which is excellent in sensitivity and printing resistance and has a high storage stability and a favorable autoloader suitability.

As the results of extensive studies, the inventor has found out that the above objects can be achieved by adding a specific water-soluble poly(meth)acrylic ester in the protective layer and, moreover, by adding a fluorine-containing surfactant thereto. Accordingly, the invention is as follows.
1. A photosensitive lithographic printing plate comprising a hydrophilic support, a photosensitive layer, and a protective layer, provided in this order; the photosensitive layer comprising a compound having an ethylenically unsaturated double bond and a polymer binder, and the protective layer containing a water-soluble poly(meth)acrylic ester; characterised in that the water-soluble poly(meth)acrylic ester is a compound represented by the following formula (P): 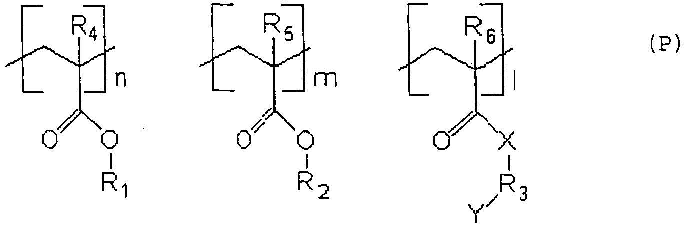 wherein R₁ and R₂ each independently represents an alkyl group having not more than 5 carbon atoms; R₃ represents a linking group; R₄, R₅ and R₆ each independently represents a hydrogen atom or a methyl group; X represents an oxygen atom, a sulphur atom or NH; Y represents -SO₃M, -PO₃M or -COOM; M represents an alkali metal or ammonium; and the indices n, m and l represent the ratios of the three units constituting the ester (P) with the proviso that either n or m may be 0.
2. A photosensitive lithographic printing plate as described in the above 1 wherein the protective layer further contains a fluorine-containing surfactant.
3. A photosensitive lithographic printing plate as described in the above 2 wherein the fluorine-containing surfactant is a compound having a perfluoroalkyl group.
4. A photosensitive lithographic printing plate as described in the above 1 to 3 wherein the water-soluble poly(meth)acrylic ester has at least one group capable of imparting water solubility which is a sulfonic acid salt, a phosphoric acid salt or a carboxylic acid salt.

According to the invention, it is possible to provide a photosensitive lithographic printing plate which is excellent in sensitivity and printing resistance and has a high storage stability and, moreover, a photosensitive lithographic printing plate which is excellent in sensitivity and printing resistance and has a high storage stability and a favorable autoloader suitability.

### DETAILED DESCRIPTION OF THE INVENTION

Next, the invention will be described in greater detail.

### <Protective layer>

The protective layer according to the invention is characterized by containing a water-soluble poly(meth)acrylic ester. By adding a water-soluble poly(meth)acrylic ester to a protective layer comprising polyvinyl alcohol, etc., the storage stability can be remarkably improved. By further using a fluorine-containing surfactant, the coefficient of surface friction can be lowered and, in its turn, the autoloader suitability can be remarkably improved even at a high humidity.

Fundamental characteristics required for the protective layer include: having a regulated oxygen permeability, being excellent, not substantially hindering the transmission of light to be used for exposure, being excellent in adhesion to the photosensitive layer, and being easily removed in a development step after exposure. Devices regarding such a protective layer have hitherto been made, and details thereof are described in U.S. Patent No. 3,458,311 and JP-A-55-49729.

As materials which can be used in the protective layer, for example, it is preferred to use a water-soluble high molecular compound having relatively excellent crystallinity. Specifically, there are enumerated water-soluble polymers such as polyvinyl alcohol, vinyl alcohol/vinyl phthalate copolymers, vinyl acetate/vinyl alcohol/vinyl phthalate copolymers, vinyl acetate/crotonic acid copolymers, polyvinylpyrrolidone, acidic celluloses, gelatin, gum arabic, polyacrylic acid, polyacrylamide polyeser and polyurethane. Such compounds can be used either singly or as a mixture. Among all, use of polyvinyl alcohol as the major component brings the most satisfactory results in view of basic characteristics such as oxygen-blocking properties and development eliminating properties.

With respect to the polyvinyl alcohol which is used in the protective layer, so far as an unsubstituted vinyl alcohol unit for having necessary oxygen-blocking properties and water solubility is contained, a part thereof may be substituted with an ester, an ether or an acetal. Similarly, a part of the polyvinyl alcohol may have other copolymerization component.

As specific examples, there can be enumerated polyvinyl alcohols which are hydrolyzed to an extent of from 71 to 100 % by mole and which have a molecular weight in the range of from 300 to 2,400. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, L-8, KL-506, KL-318, KL-118, KM-618, KM-118, C-506, R-2105, R-1130, R-2130, M-205, MP-203, LM15, LM20, LM25 and so on all of which are manufactured by Kuraray Co., Ltd. Such compounds can be used either singly or as a mixture. In a preferred embodiment, the content of the polyvinyl alcohol in the protective layer is preferably from 20 to 95 % by weight, and more preferably from 30 to 90 % by weight.

It is preferable that the water-soluble poly(meth)acrylic ester, according to the first statement of invention, to be used in the protective layer has at least one group capable of imparting water solubility which is selected from the group consisting of a sulfonate group, a phosphate group and a carboxylate group. Such a water-soluble poly(meth)acrylic ester can be obtained by copolymerizing a (meth)acrylic ester with a monomer having a sulfonate group, a phosphate group or a carboxylate group and a polymerizable unsaturated double bond (a monomer having a group capable of imparting water solubility). The content of the monomer having the group capable of imparting water solubility is preferably from about 5 to 50% based on the total monomers.

As specific examples of the (meth)acrylic ester in the water-soluble poly(meth)acrylic ester to be used in the invention, there can be enumerated alkyl (meth)acrylates, aralkyl (meth)acrylates, aryl (meth)acrylates and so on. Among all, alkyl (meth)acrylates are preferred. As the alkyl group, alkyl groups having not more than 10 carbon atoms are preferred and alkyl groups having not more than 5 carbon atoms are more preferred.

The monomer having a group capable of imparting water solubility to be used in the water-soluble poly(meth)acrylic ester in the invention is not particularly restricted, so long as it has a sulfonate group, a phosphate group or a carboxylate group and a polymerizable unsaturated double bond and can be copolymerized with a (meth)acrylic ester compound. As examples of particularly preferable monomers having a group capable of imparting water solubility, monomers represented by the following formula can be cited.

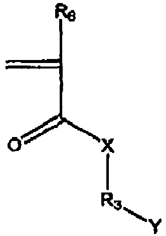

In the above formula, R₆ represents a hydrogen atom or a methyl group. X represents an oxygen atom, a sulfur atom or NH; Y represents -SO₃M, -PO₃M or -COOM; and M represents an alkali metal or ammonium.

As the water-soluble poly(meth)acrylic ester of the invention, use can be made of two or more of the (meth)acrylic ester compounds as described above. It is also possible to use two or more of monomers having a group capable of imparting water solubility. Furthermore, the water-soluble poly(meth)acrylic ester of the invention may be copolymerized with a monomer other than the (meth)acrylic ester compounds and the monomers having a group capable of imparting water solubility as described above.

The water-soluble poly(meth)acrylic ester of the invention is represented by the following formula (P).

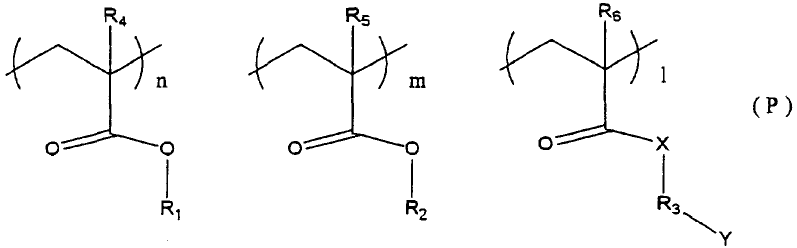

In the above formula, R₁ and R₂ each independently represents an alkyl group having not more than 5 carbon atoms; R₃ represents a linking group; and R₄ to R₆ each independently represents a hydrogen atom or a methyl group. X represents an oxygen atom, a sulfur atom or NH; Y represents -SO₃M, -PO₃M or -COOM; M represents an alkali metal or ammonium; and n, m and l represent the copolymerization ratio. Either n or m may be 0.

R₁ and R₂, preferably are selected from a methyl group, an ethyl group and a propyl group. As the linking group R₃, a divalent linking group having not more than 10 carbon atoms are preferable, an allcylene group, an arylene group and an aralkylene group are more preferable and an alkylene group having not more than 5 carbon atoms is more preferable.

Examples of the water-soluble poly(meth)acrylic ester of the invention include the following compounds, though the invention is not construed as being restricted thereto.

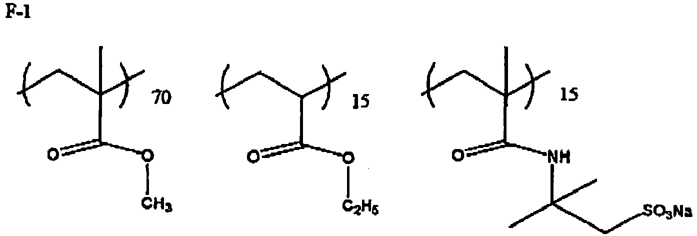

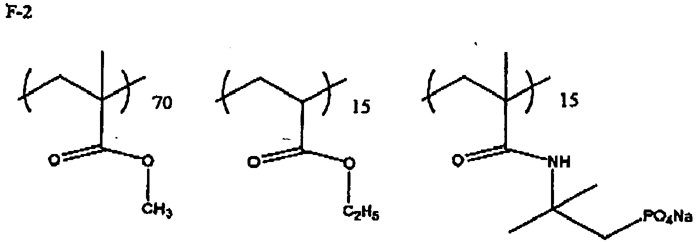

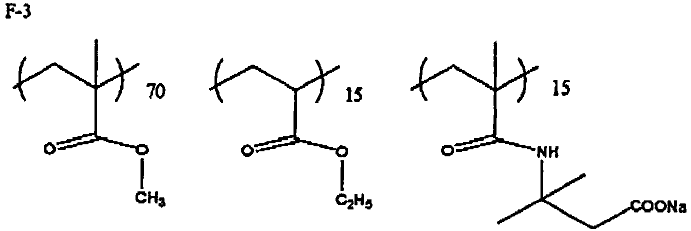

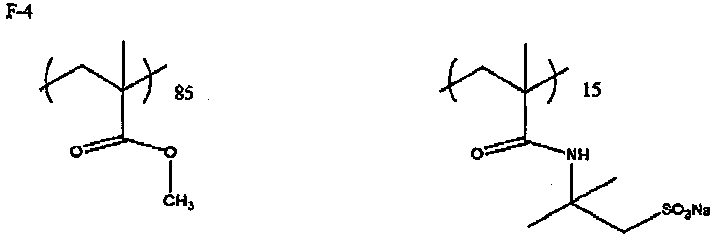

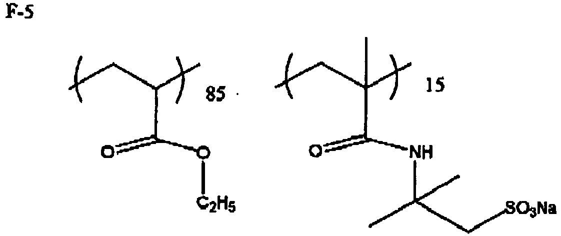

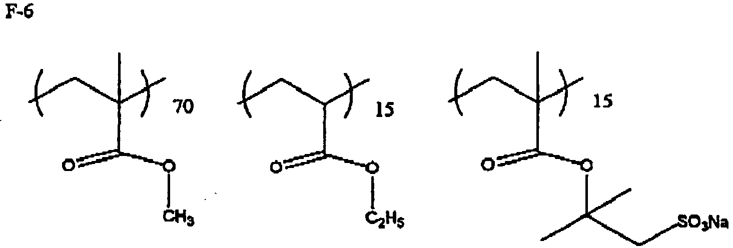

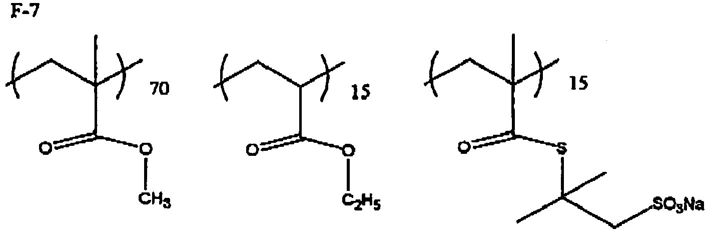

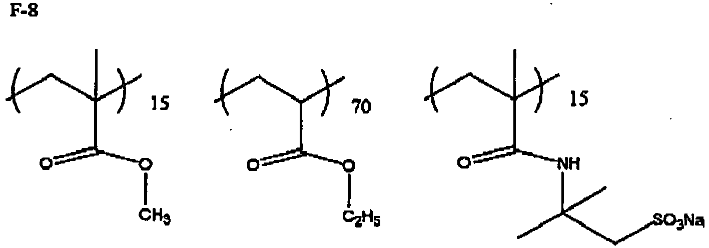

It is preferable that the weight-average molecular weight (GPC method, polystyrene-converted) of the water-soluble poly(meth)acrylic ester of the invention is form 5000 to 100,000, more preferably from 10,000 to 50,000.

It is preferably added to the protective layer in an amount of from 3 to 50% by weight, more preferably from 5 to 40% by weight, based on the whole of solids contained in the protective layer.

The compounds represented by the formula (P) can be commercially available in genera. Examples of the marketed products include those manufactured by TOAGOSEI Co., Ltd., Sanyo Chemical Industries, Ltd., DAIICHI KOGYO SEIYAKU Co., Ltd. and so on.

It is preferable that the protective layer of the invention further contains a fluorine-containing surfactant (hereinafter also called "a fluorinated surfactant").

As the fluorinated surfactant, one having a perfluoroalkyl group is preferred. For example, there can be enumerated anionic surfactants such as perfluoroalkylcarboxylic acid salts and perfluoroalkylphosphoric esters, cationic surfactants such as perfluoroalkyltrimethylammonium salts, ampholytic surfactants such as perfluoroalkylbetaines, and nonionic surfactants such as perfluoroalkylamine oxides and perfluoroalkyl ethylene oxide adducts.

It is preferably added to the protective layer in an amount of from 0.01 to 5% by weight, more preferably from 0.1 to 3% by weight, based on the whole of solids contained in the protective layer. These compounds can be commercially available in genera. Examples of the marketed products include MEGAFAC F113, MEGAFAC F120, MEGAFAC F171 and MEGAFAC F177 (manufactured by Dainippon Ink and Chemicals, Incorporated), SURFLON S-111N, SURFLON S-112, SURFLON S-113, SURFLON S-131 and SURFLON S-141 (manufactured by SEIMI CHEMICAL Co., Ltd.) and so on.

In addition to the water-soluble poly(meth)acrylic ester and polyvinyl alcohol as described above, other compounds may be used in the protective layer of the invention. As examples of compounds usable herein, there are enumerated water-soluble polymers such as vinyl alcohol/vinyl phthalate copolymer, vinyl acetate/vinyl alcohol/vinyl phthalate copolymer, vinyl acetate/crotonic acid copolymer, polyvinylpyrrolidone, acidic celluloses, gelatin, acacia, polyacrylic acid, polyacrylamide, polyester and polyurethane. Such compounds can be used either singly or as a mixture.

It is also possible to add an inorganic layered compound such as silica gel or mica to thereby modify the surface properties.

The inorganic layered compound to be used in the invention is in the form of grains in the shape of thin plates. Examples thereof include micas such as natural micas represented by the formula A(B,c)₂₋₅D₄O)₁₀(OH, F, o)₂ (wherein A represents any one of K, Na and Ca; B and C each represents any one of Fe(II), Fe(III). Mn, Al, Mg and V; and D represents Si or Al) and synthetic micas, talc represented by the formula 3MgO·4SiO·H₂, tainiolite, montmorillonite, saponite, hectorite, zirconium phosphate and so on.

In the above micas, examples of the natural micas include muscovite, paragonite, phlogopite, biotite and lepidorite. Examples of the synthetic micas include nonswelling micas such as fluorinated phlogopite KMg₃(AlSi₃O₁₀)F₂ and potassium tetrasilicon mica KMg_{2.5}(Si₄O₁₀)F₂ and swelling micas such as Na tetrasilylic mica NaMg_{2.5}(Si₄O₁₀)F₂, Na or Li tainiolite (Na, Li) Mg₂Li(Si₄O₁₀)F₂, montmorillonite-type Na or Li hectorite (Na, Li)_{1/8}Mg_{2/5}Li_{1/8}(Si₄O₁₀)F₂ and so on. Also, synthetic smectite is useful.

Concerning the grain diameter of the inorganic layered compound to be used in the invention, the major diameter ranges from 0.3 to 20 µm, preferably from 0.5 to 10 µm and particularly preferably form 1 to 5 µm, The average thickness of the grains is 0.1 µm or less, preferably 0.05 µm or less and particularly preferably 0.01 µm or less. For example, a swelling synthetic mica which is a typical compound of the inorganic layered compounds has a thickness of from 1 to 50 nm and a planar size of about 1 to 20 µm.

It is preferable that the protective layer has an oxygen permeability A at 25 °C under one atmosphere of 1.0 ≤ A ≤ 20 (cm³/m²·day). So long as the oxygen permeability A is controlled within the range as defined above, unnecessary polymerization reaction would not arise at the time of production and unprocessed stock storage and the problem of the generation of unnecessary fog or thickening of image lines would not occur at the time of image exposure, thereby achieving a high sensitivity.

The protective layer to be used in the invention may further contain a surfactant other than the fluorinated surfactant as described above (hereinafter referred to as a nonfluorinated surfactant too). As the nonfluorinated surfactant, use can be made of nonionic surfactants, for example, polyoxyethylene alkyl ethers such as polyoxyethylene castor oil ether, polyoxyethylene lauryl ether, polyoxyethylene cetyl ether and polyoxyethylene stearyl ether, polyoxyethylene alkyl allyl ethers such as polyoxyethylene octyl phenyl ether and polyoxyethylene nonyl phenyl ether, polyoxyethylene alkyl esters such as polyoxyethylene stearate, sorbitan alkyl esters such as sorbitan monolaurate, sorbitan monostearate, sorbitan distearate, sorbitan monooleate, sorbitan sesquioleate and sorbitan trioleate, and monoglyceride alkyl esters such as glycerol monostearate and glycerol monooleate; anionic surfactants, for example, alkylbenzenesulfonic acid salts such as sodium dodecylbenzenesulfonate, alkylnaphthalenesulfonic acid salts such as sodium butylnaphthalenesulfonate, sodium pentylnaphthalenesulfonate, sodium hexylnaphthalenesulfonate and sodium octylnaphthalenesulfonate, alkylsulfuric acid salts such as sodium laurylsulfate, alkylsulfonic acid salts such as soda dodecylsulfonate, and sulfosuccinic ester salts such as sodium dilaurylsulfosuccinate; and ampholytic surfactants, for example, alkyl betaines such as lauryl betaine and stearyl betaine and amino acids.

As a particularly preferable nonfluorinated surfactant, a polyoxyethylene caster oil ether-based surfactant may be cited. Castor oil, which is the main component of the polyoxyethylene caster oil ether-based surfactant, is a vegetable non-drying oil obtained from the seeds of *Ricinus communis L. Euphorbiaceae* by the pressing method. The oil content amounts to 35 to 57% by weight of the whole seeds. Castor oil contains about 85% by weight of ricinolic acid which is an unsaturated carboxylic acid. Ricinolic acid is a derivative of stearic acid having a terminal carboxyl group, a hydroxyl group at the 12-position and an unsaturated double bond at the 9-position. "Polyoxyethylene caster oil ether-based surfactant" is a generic term for nonionic surfactants which are synthesized by adding ethylene oxide to ricinolic acid, i.e., the main component of castor oil. Depending on the conditions in the course of the addition reaction, the hydroxyl group of the ricinolic acid reacts with the carboxylate group to form a polyester. Thus, a surfactant having a high molecule of from 10,000 to 20,000 in molecular weight can be obtained.

Further, surfactants wherein ethylene oxide is added to glycerol in ricinolic acid also fall within this category.

The polyoxyethylene caster oil ether-based surfactant appropriately usable in the invention has an HLB of from 10.0 to 16.0, preferably from 11.0 to 15.0. The weight-average molecular weight of the polyoxyethylene caster oil ether-based surfactant ranges from 800 to 5000, preferably from 1000 to 3000.

As specific examples of such a polyoxyethylene caster oil ether-based surfactant, there can be enumerated PIONIN D-225, PIONIND-240-W, PIONIN D-230, PIONIN D-236 and PIONIN D-225-K (manufactured by TAKEMOTO YUSHI Co., Ltd.) and EMANON CH-25, EMANON CH-40 and EMANON CH-60 (manufactured by KAO Corporation) and so on.

The polyoxyethylene caster oil ether-based surfactant is added in an amount of from 1.0 to 10% by weight, preferably from 2.0 to 6.0% by weight, based on the whole of solids contained in the protective layer.

The coating amount of the protective layer generally ranges from 0.1 to 10 g/m², preferably from 0.5 to 5 g/m² on the dry basis. As the coating method, use can be made of publicly known methods described in JP-B-55-49729. US Patent No.3,458,311 and so on.

### <Photosensitive layer>

The photosensitive layer of the invention contains an ethylenically unsaturated double bond-containing compound (a compound having an ethylenically unsaturated double bond) (hereinafter referred to as "an ethylenically unsaturated bond-containing compound") and a polymer binder. The polymer binder is an alkaline water-soluble or swelling binder, preferably an alkaline water-soluble or swelling polymer binder having a crosslinking group. It is preferable that the photosensitive layer of the invention contains a polymerization-initiating system and it may further contain variety of compounds such as a coloring agent, a plasticizer, and a thermal polymerization inhibitor, if desired.

### [Ethylenically unsaturated bond-containing compound]

The ethylenically unsaturated bond-containing compound as referred to herein is a compound containing at least one ethylenically unsaturated bond and when the photosensitive layer is irradiated with active rays, causes addition polymerization by the action of a photopolymerization initiator, thereby contributing to crosslinking and curing.

The ethylenically unsaturated double bond-containing compound can be arbitrarily chosen among, for example, compounds containing at least one, preferably two or more, and more preferably from 2 to 6 terminal ethylenically unsaturated bonds. The ethylenically unsaturated double bond-containing compound has a chemical morphology such as monomers and prepolymers, namely dimers, trimers and oligomers, or mixtures thereof, and copolymers thereof.

Examples of monomers and copolymers thereof include esters of an unsaturated carboxylic acid (for example, acrylic acid, methacrylic acid, itaconic acid, crotonic acid, isocrotonic acid, and maleic acid) and an aliphatic polyhydric alcohol compound and amides of an unsaturated carboxylic acid and an aliphatic polyhydric amine compound.

With respect to specific examples of the monomer of the ester between an aliphatic polyhydric alcohol compound and an unsaturated carboxylic acid, examples of acrylic esters include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri-(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, and polyester acrylate oligomers.

Examples of methacrylic esters include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)phenyl]dimethylmethane, and bis[p-(methacryloxyethoxy)phenyl]dimethylmethane.

Examples of itaconic esters include ethylene glycol diitaconate, propylene glycol diitaconate, 1,5-butanediol diitaconate, 1,4-butanediol diitaconate, tetramethylene glycol diitaconate, pentaerythritol diitaconate, and sorbitol tetraitaconate. Examples of crotonic esters include ethylene glycol dicrotonate, tetramethylene glycol dicrotonate, pentaerythritol dicrotonate, and sorbitol tetra-dicrotonate. Examples of isocrotonic esters include ethylene glycol diisocrotonate, pentaerythritol diisocrotonate, and sorbitol tetraisocrotonate.

Examples of maleic esters include ethylene glycol dimaleate, triethylene glycol dimaleate, pentaerythritol dimaleate, and sorbitol tetramaleate. In addition, mixtures of the foregoing ester monomers can be enumerated. Furthermore, specific examples of the monomer of the amide between an aliphatic polyhydric amine compound and an unsaturated carboxylic acid include methylene bisaoylamide, methylene bismethacrylamide, 1,6-hcxamethylene bisacrylamide, 1,6-hexamethylene bismethacrylamide, diethylenetriamine trisacrylamide, xylylene bisacrylamdie, and xylylene bismethacrylamide.

Other examples include vinyl urethane compounds containing two or more polymerizable vinyl groups in one molecule thereof resulting from adding a hydroxyl group-containing vinyl monomer represented by the following formula (m) to a polyisocyanate compound containing two or more isocyanate groups in one molecule thereof as described in JP-B-48-41708.

CH₂C(R)COOCH₂CH(R')OH (m)

In the above formula (m), R and R' each represents H or CH₃.

Furthermore, use can be also made of urethane acrylates as described in JP-A-51-37193 and JP-B-2-32293; polyester acrylates as described in JP-A-48-64183, JP-B-49-43191, and JP-13-52-30490; and polyfunctional acrylates or methacrylates such as epoxy acrylates obtained by reaction between an epoxy resin and (meth)acrylic acid. Photocurable monomers and oligomers as introduced in Journal of the Adhesion Society of Japan, Vol. 20, No. 7, pages 300 to 308 (1984) can also be used. Incidentally, the amount of such an ethylenically unsaturated bond-containing compound to be used is usually in the range of from 5 to 80 % by weight, and preferably from 30 to 70 % by weight based on the total weight of the photosensitive layer.

### [Polymer binder]

In the photosensitive layer used in the invention, a polymer binder, preferably a polymer binder containing a crosslinking group in the side chain thereof is used.

The crosslinking group as referred to herein means a group for crosslinking a polymer binder in the process of radical polymerization reaction which is caused in the photosensitive layer during exposing the photosensitive lithographic printing plate. The crosslinking group is not particularly limited so far as it has such a function. Examples of a functional group which can be subjected to addition polymerization reaction include an ethylenically unsaturated bond group, an amino group, and an epoxy group. Furthermore, the crosslinking group may be a functional group which can become a radical upon irradiation with light. Examples of such a crosslinking group include a thiol group, a halogen group, and an onium salt structure. Above all, an ethylenically unsaturated bond group is preferable, and functional groups represented by the following formulae (1) to (3) are especially preferable.

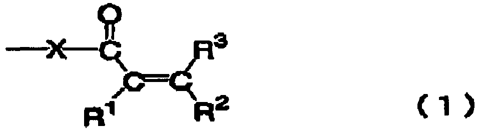

In the foregoing formula (1), R¹ to R³ each independently represents a monovalent organic group. Preferred examples of R¹ include a hydrogen atom and an optionally substituted alkyl group; and above all, a hydrogen atom and a methyl group are preferable because of having high radical reactivity. Examples of each of R² and R³ include a hydrogen atom, a halogen atom, an amino group, a carboxyl group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group, and an optionally substituted arylsulfonyl group; and above all, a hydrogen atom, a carboxyl group, an alkoxycarbonyl group, an optionally substituted alkyl group, and an optionally substituted aryl group are preferable because of having high radical reactivity.

X represents an oxygen atom, a sulfur atom, or -N(R¹²)-; and R¹² represents a hydrogen atom or a monovalent organic group. Here, examples of R¹² include an optionally substituted alkyl group; and above all, a hydrogen atom, a methyl group, an ethyl group, and an isopropyl group are preferable because of having high radical reactivity.

Here, examples of the substituent which can be introduced include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amide group, an alkylsulfonyl group, and an arylsulfonyl group.

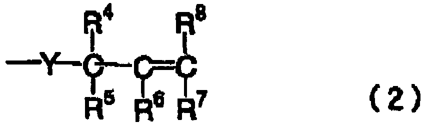

In the foregoing formula (2), R⁴ to R⁸ each independently represents a hydrogen atom or a monovalent organic group. Preferred examples of each of R⁴ to R⁸ include a hydrogen atom, a halogen atom, an amino group, a dialkylamino group, a carboxyl group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group, and an optionally substituted arylsulfonyl group; and above all, a hydrogen atom, a carboxyl group, an alkoxycarbonyl group, an optionally substituted alkyl group, and an optionally substituted aryl group are preferable. As the substituent which can be introduced, those which are the same as in the formula (1) are enumerated.

Y represents an oxygen atom, a sulfur atom, or -N(R¹²)-. R¹² has the same meaning as R¹² in the formula (1), and preferred examples thereof are also the same.

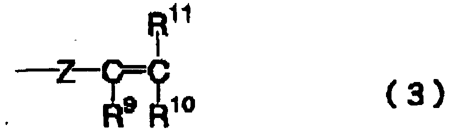

In the foregoing formula (3), R⁹ to R¹¹ each independently represents a hydrogen atom or a monovalent organic group. Preferred examples of R⁹ include a hydrogen atom or an optionally substituted alkyl group. Above all, a hydrogen atom and a methyl group are preferable because of having high radical reactivity. R¹⁰ and R¹¹ each independently represents a hydrogen atom, a halogen atom, an amino group, a dialkylamino group, a carboxyl group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group, or an optionally substituted arylsulfonyl group. Above all, a hydrogen atom, a carboxyl group, an alkoxycarbonyl group, an optionally substituted alkyl group, and an optionally substituted aryl group are preferable because of having high radical reactivity.

As the substituent which can be introduced, those which are the same as in the formula (1) are enumerated. Furthermore, Z represents an oxygen atom, a sulfur atom, -N(R¹³)-, or an optionally substituted phenylene group. Examples of R¹³ include an optionally substituted alkyl group. Above all, a methyl group, an ethyl group, and an isopropyl group are preferable because of having high radical reactivity.

Since the foregoing polymer binder containing a crosslinking group in the side chain thereof is required such that not only it functions as a film forming agent of the photosensitive layer, but also it is soluble in a developing solution, preferably an alkaline developing solution, it is preferably an alkaline water-soluble or swelling organic high molecular polymer. For that reason, it is preferable that the polymer binder used in the invention contains, in addition to a crosslinking group, an alkali-soluble group, for example, a carboxyl group in the side chain thereof

In the case where the polymer binder containing a crosslinking group in the side chain thereof is a water-soluble organic high-molecular polymer, water development becomes possible.

Examples of the foregoing polymer binder used in the invention include those as described in JP-A-59-53836 and JP-A-59-71048, namely (meth)acrylic acid copolymers, itaconic acid copolymers, crotonic acid copolymers, maleic acid copolymers, and partially esterified maleic acid copolymers, each containing a crosslinking group (for example, an allyl group or a (meth)acryloyl group) in the side chain thereof.

As the polymer binder used in the invention, polyurethanes, acidic cellulose derivatives, adducts resulting from addition of a cyclic acid anhydride to a hydroxyl group-containing addition polymer, and the like are also useful.

Above all, polyurethane resins and (meth)acrylic acid resins containing a crosslinking group in the side chain thereof are more preferable. Polyurethane resins are especially preferable because nevertheless an acid value of the photosensitive layer is low, they can inhibit development damage in an exposed area without reducing developability in an unexposed area and have both good stainproof properties and high printing resistance.

The polyurethane resin containing a crosslinking group in the side chain thereof will be hereunder described in more detail.

The polyurethane resin containing a crosslinking group in the side chain thereof which is especially preferably used in the invention can be obtained by polyaddition reaction of (i) a diisocyanate compound, (ii) a diol compound containing at least one carboxyl group and (iii) a crosslinking group-containing diisocyanate compound, and optionally, (iv) a carboxyl group-free diol compound.

The diisocyanate compound and the diol compound which are the raw materials of the foregoing polyurethane resin will be hereunder described.

### (i) Diisocyanate compound

Examples of the diisocyanate compound include a diisocyanate compound represented by the formula (4).

OCN-L-NCO (4)

In the foregoing formula, L represents an optionally substituted divalent aliphatic or aromatic hydrocarbon group. If desired, L may contain another functional group which does not react with the isocyanate group, for example, a carbonyl, ester, urethane, amide, or ureido group. More specifically, L represents a single bond or an optionally substituted divalent aliphatic or aromatic hydrocarbon group (preferred examples of the substituent include an alkyl group, an aralkyl group, an aryl group, an alkoxy group, and a halogeno group). Above all, an alkylene group having from 1 to 20 carbon atoms and an arylene group having from 6 to 15 carbon atoms are preferable; and an alkylene group having from 1 to 8 carbon atoms is more preferable. Furthermore, if desired, L may contain another functional group which does not react with the isocyanate group, such as a carbonyl, ester, urethane, amide, ureido or ether group.

Specific examples thereof are as follows: aromatic diisocyanate compounds such as 2,4-tolylene diisocyanate, a dimer of 2,4-tolylene diisocyanate, 2,6-tolylene diisocyanate, p-xylylene diisocyanate, m-xylylene diisocyanate, 4,4'-diphenylmethane diisocyanate, 1,5-naphthylene diisocyanate, and 3,3'-dimethylbiphenyt-4,4'-diisocyanate; aliphatic diisocyanate compounds such as hexamethylene diisocyanate, trimethylhexamethylene diisocyanate, lysine diisocyanate, and dimeric acid diisocyanate; alicyclic diisocyanate compounds such as isophorone diisocyanate, 4,4'-methylenebis(cyclohexyl isocyanate), methylcyclohexane-2,4-(or 2,6-)diisocyanate, and 1,3-(isocyanatomethyl)cyclohexane; and diisocyanate compound which is a reaction product between a diol and a diisocyanate such as an adduct of one mole of 1,3-butylene glycol and 2 moles of tolylene diisocyanate.

The diisocyanate compound may be used either singly or in combination of two or more kinds thereof. In view of a balance between printing resistance and stainproof properties, it is preferred to use a combination of two or more kinds thereof It is especially preferred to use at least one kind of each of an aromatic diisocyanate compound (wherein L represents an aromatic group) and an aliphatic diisocyanate compound (wherein L represents an aliphatic group).

The amount of the diisocyanate to be used is preferably from 0.8 to 1.2, and more preferably from 0.9 to 1.1 in terms of a molar ratio to the diol compound. In the case where an excess of the diisocyanate compound is used against the diol compound so that the isocyanate group remains in the polymer terminals, it is preferable that after completion of urethanization reaction, the reaction product is treated with an alcohol or an amine so that the polyurethane resin is finally synthesized in the form that no isocyanate group remains.

### (ii) Diol compound containing at least one carboxyl group

Examples of the diol compound containing at least one carboxyl group include diol compounds represented by the formulae (5), (6) and (7) and/or compounds resulting from ring opening of a tetracarboxylic dianhydride with a diol compound. The diol compound which is used for ring opening of a tetracarboxylic dianhydride can be used.

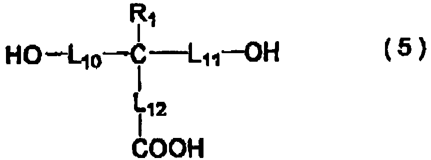

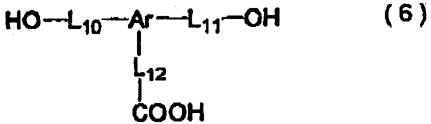

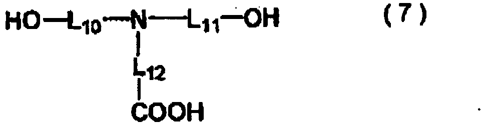

In the foregoing formulae, R₁ represents a hydrogen atom or an optionally substituted alkyl group, aralkyl group, aryl group, alkoxy group or aryloxy group (examples of the substituent include cyano, nitro, a halogen atom (for example, -F, -Cl, -Br, and -I), -CONH₂, -COOR₁₁₃, -OR₁₁₃, -NHCONHR₁₁₃, -NHCOOR₁₁₃, -NHCOR₁₁₃ and-OCONHR₁₁₃ (wherein R₁₁₃ represents an alkyl group having from 1 to 10. carbon atoms or an aralkyl group having from 7 to 15 carbon atoms); and preferably a hydrogen atom, an alkyl group having from 1 to 8 carbon atoms, or an aryl group having from 6 to 15 carbon atoms. L₁₀, L₁₁, and L₁₂ may be either the same or different and each represents a single bond or an optionally substituted divalent aliphatic or aromatic hydrocarbon group (examples of the substituent include an alkyl, aralkyl aryl, alkoxy and halogeno groups), preferably an alkylene group having from 1 to 20 carbon atoms or an arylene group having from 6 to 15 carbon atoms; and more preferably an alkylene group having from 1 to 8 carbon atoms. If desired, L₁₀, L₁₁, and L₁₂ may each contain a functional group which does not react with the isocyanate group (example of the functional group include carbonyl, ester, urethane, amide, ureido and ether groups). Incidentally, two or three of R₁, L₁₀, L₁₁, and L₁₂ may be bonded together to form a ring. Ar represents an optionally substituted trivalent aromatic hydrocarbon group, and preferably an aromatic group having from 6 to 15 carbon atoms.

Specific examples of the diol compound containing at least one carboxyl group represented by the formula (5), (6) or (7) include the following compounds.

Namely, examples thereof include 3,5-dihydroxybenzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl)acetic acid, bis(4-hydroxyphenyl)acetic acid, 2,2-bis(hydroxymethyl)butyric acid, 4,4-bis-(4-hydroxyphenyl)pentanoic acid, tartaric acid, N,N-dihydroxyethylglycine, and N,N-bis(2-hydroxyethyl)-3-carboxypropionamide.

Preferred examples of the tetracarboxylic dianhydride which is used for the formation of the diol compound containing at least one carboxyl group include compounds represented by the formulae (8), (9) and (10).

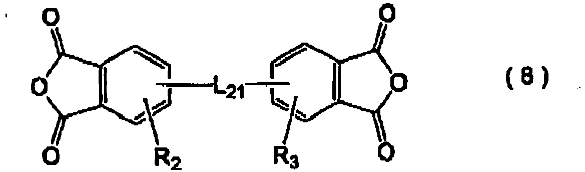

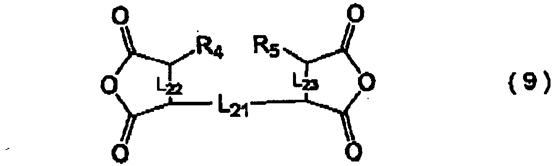

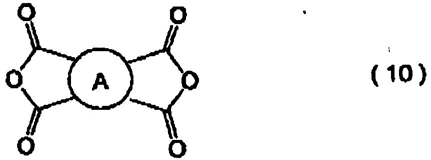

In the foregoing formulae, L₂₁ represents a single bond, an optionally substituted divalent aliphatic or aromatic hydrocarbon group (examples of the substituent include alkyl, aralkyl, aryl, alkoxy, halogeno, ester and amide groups), -CO-, -SO-, -SO₂-, -O-, or -O-; and preferably a single bond, a divalent aliphatic hydrocarbon group having from 1 to 15 carbon atoms, -CO-, -SO₂-, -O-, or -S-. R₂ and R₃ may be either the same or different and each represents a hydrogen atom, an alkyl group, an aralkyl group, an aryl group, an alkoxy group, or a halogeno group; and preferably a hydrogen atom, an alkyl group having from 1 to 8 carbon atoms, an aryl group having from 6 to 15 carbon atoms, an alkoxy group having from 1 to 8 carbon atoms, or a halogeno group. Furthermore, two of L₂₁, R₂ and R₃ may be bonded together to form a ring. R₄ and R₅ may be either the same or different and each represents a hydrogen atom, an alkyl group, an aralkyl group, an aryl group, or a halogeno group; and preferably a hydrogen atom, an alkyl group having from 1 to 8 carbon atoms, or an aryl group having from 6 to 15 carbon atoms. Moreover, two of L₂₁, R₄, and R₅ may be bonded together to form a ring. L₂₂ and L₂₃ may be either the same or different and each represents a single bond, a double bond, or a divalent aliphatic hydrocarbon group; and preferably a single bond, a double bond, or a methylene group. A represents a mononucleic or polynucleic aromatic ring, and preferably an aromatic ring having from 6 to 18 carbon atoms.

Specific examples of the compound represented by the formula (8), (9) or (10) include the following compounds.

Namely, examples thereof include aromatic tetracarboxylic anhydrides such as pyromellitic dianhydride, 3,3',4,4'-benzophenonetetracarboxylic dianhydride, 3,3',4,4'-diphenyltetracarboxylic dianhydride, 2,3,6,7-naphthalenetetracarboxylic dianhydride, 1,4,5,8-naphthalenetetracarboxylic dianhydride, 4,4'-sulfonyldiphthalic dianhydride, 2,2-bis(3,4-dicarboxyphenyl)propane dianhydride, bis(3,4-dicarboxyphenyl) ether dianhydride, 4,4'-[3,3'-(alkylphosphoryl-diphenylene)-bis(iminocarbonyl)]diphthalic dianhydride, an adduct of hydroquinone diacetate and trimellitic anhydride, and an adduct of diacetyldiamine and trimellitic anhydride; alicyclic tetracarboxylic dianhydrides such as 5-(2,5-di-oxotetrahydrofuryl)-3-methyl-3-cyclohexene-1,2-dicarboxylic anhydride (EPICLON B-4400, manufactured by Dainippon Ink and Chemicals, Incorporated), 1,2,3,4-cyclopentanetetracarboxylic dianhydride, 1,2,4,5-cydohexanctetracarboxylic dianhydride and tetrahydrofurantetracarboxylic dianhydride; and aliphatic tetracarboxylic dianhydrides such as 1,2,3,4-butanetetracarboxylic dianhydride and 1,2,4,5-pentanetetracarboxylic dianhydride.

By ring-opening such a tetracarboxylic dianhydride with a diol compound, it is possible to synthesize (ii) a diol compound containing at least one carboxyl group. However, it is also possible to synthesize the polyurethane resin used in the invention by performing a reaction between the diol compound and the diisocyanate compound (i) and allowing this reaction product to react with the foregoing tetracarboxylic dianhydride, and this method is included in the viewpoint of the invention. Namely, examples of a method for introducing a structural unit derived from the tetracarboxylic dianhydride and the diol compound into the polyurethane resin include the following methods.
a) A method of allowing an alcohol-terminated compound, which is obtained by ring-opening a tetracarboxylic dianhydride with a diol compound, to react with a diisocyanate compound.
b) A method of allowing an alcohol-terminated urethane compound, which is obtained by reacting a diisocyanate compound with an excess of a diol compound, to react with a tetracarboxylic dianhydride.

With respect to the diol compound containing at least one carboxyl group, the compound represented by the formula (5) is more preferable because it has high solubility in a solvent and can be easily synthesized. Furthermore, the diol compound containing at least one carboxyl group is introduced into the polyurethane resin binder in such an amount that the polyurethane resin binder contains a carboxyl group in an amount ranging from 0.2 to 4.0 meq/g, preferably from 0.3 to 3.0 meq/g, more preferably from 0.4 to 2.0 meq/g, especially preferably from 0.5 to 1.5 meq/g, and most preferably from 0.6 to 1.2 meq/g. Accordingly, while the content of the structure derived from the diol compound containing at least one carboxyl group in the polyurethane resin binder is properly chosen depending upon the number of carboxyl groups, what should be used as other diol components, the acid value and molecular weight of the resulting polyurethane resin binder, the composition and pH of the developing solution, and the like, it is, for example, from 5 to 45% by mole, preferably from 10 to 40% by mole, and more preferably from 15 to 35% by mole.

### (iii) Crosslinking group-containing diisocyanate compound

Examples of the crosslinking group-containing diisocyanate compound include a product which is obtained by an addition reaction between a triisocyanate compound and one equivalent of a crosslinking group-containing monofunctional alcohol or monofunctional amine compound.

Examples of the triisocyanate compound will be given below, though the invention is not construed as being limited thereto.

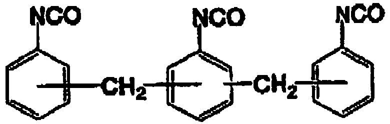

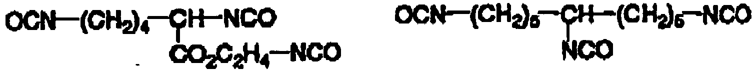

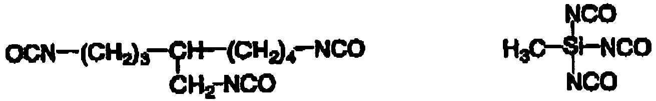

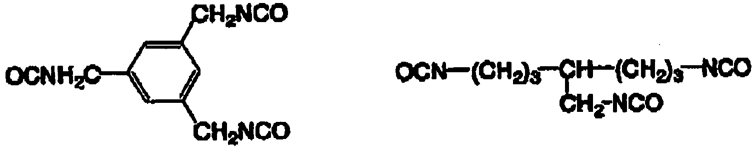

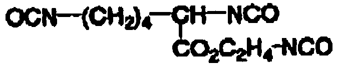

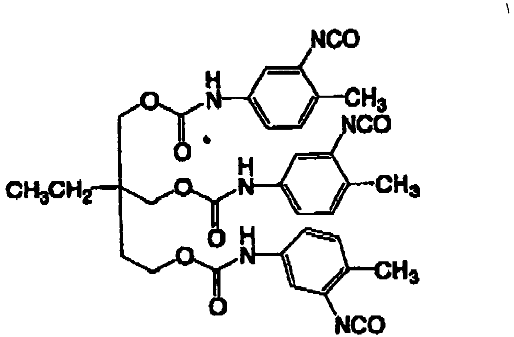

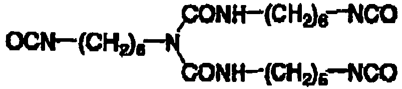

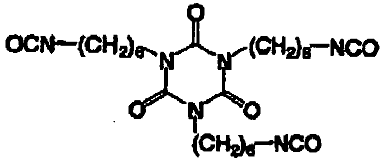

Examples of the crosslinking group-containing monofunctional alcohol or monofunctional amine compound will be given below, though the invention is not construed as being limited thereto.

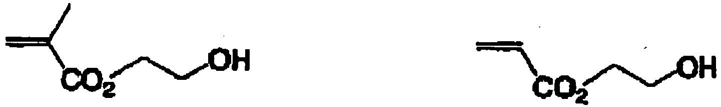

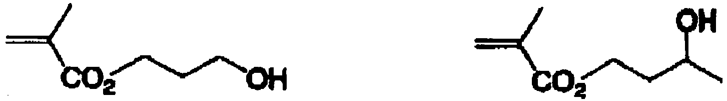

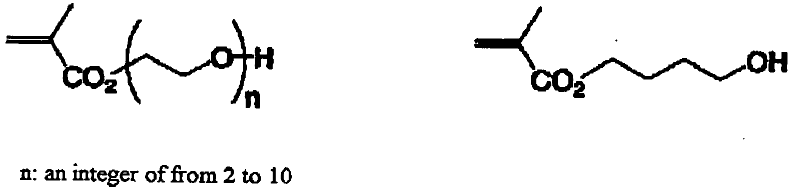

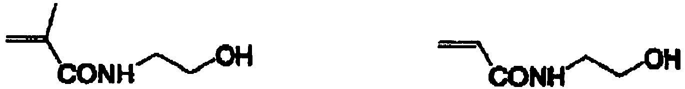

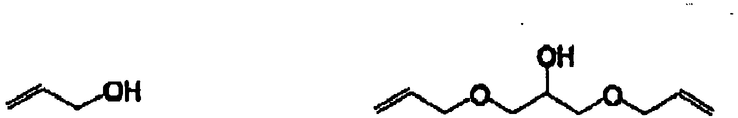

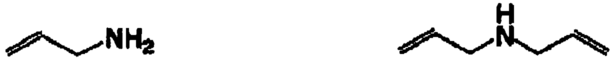

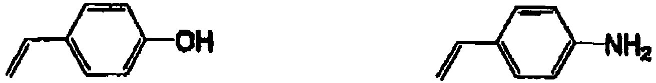

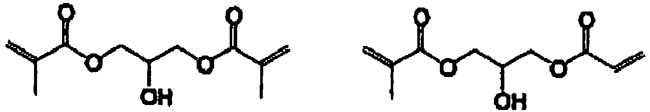

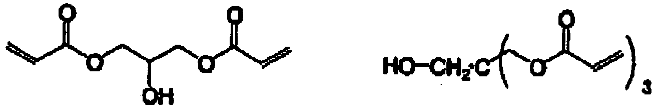

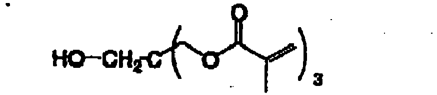

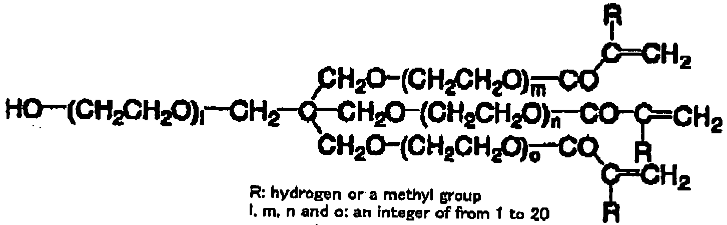

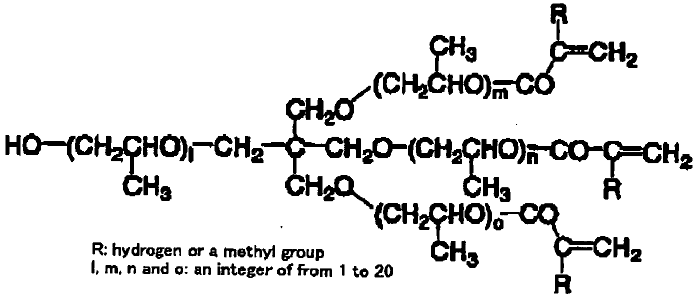

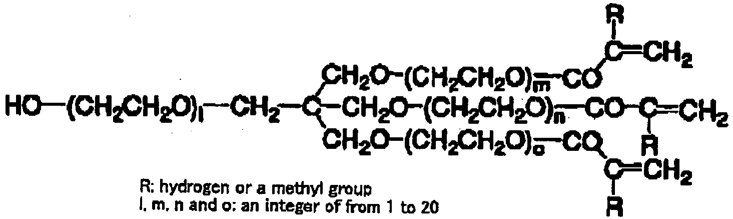

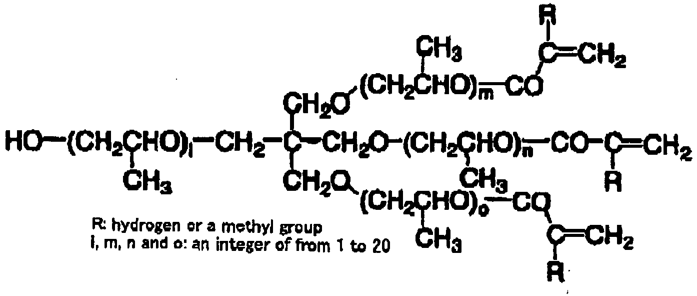

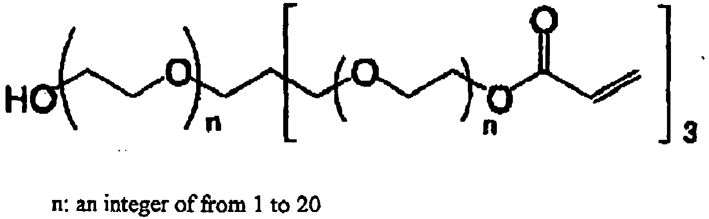

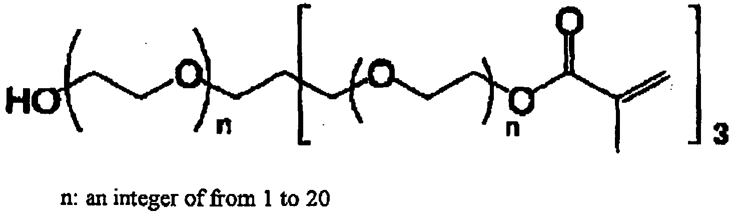

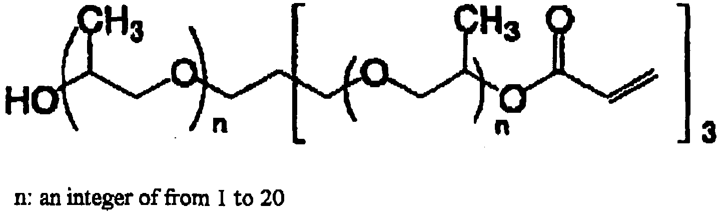

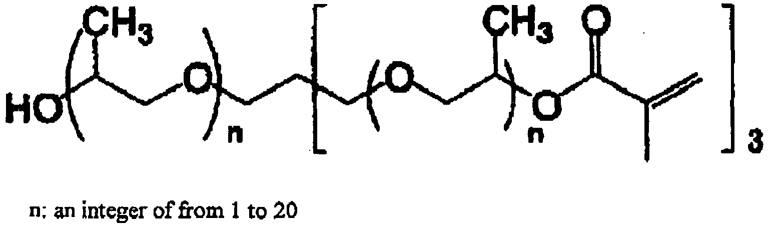

Here, as a method for introducing a crosslinking group into the side chain of the polyurethane resin, a method for using a diisocyanate compound containing a crosslinking group in the side chain thereof as the raw material for producing a polyurethane resin is suitable. Examples of a diisocyanate compound containing a crosslinking group in the side chain thereof, which can be obtained by the addition reaction between a triisocyanate compound and one equivalent of a crosslinking group-containing monofunctional alcohol or monofunctional amine compound, will be given below, though the invention is not construed as being limited thereto.

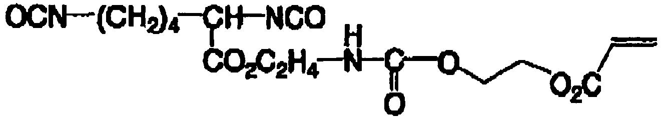

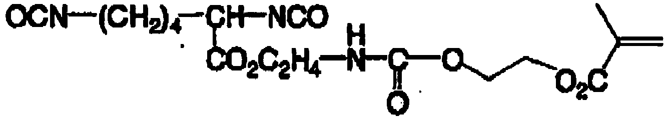

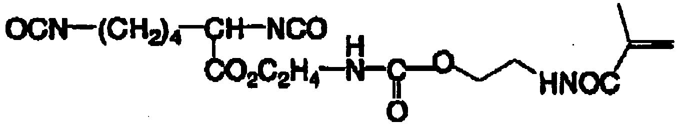

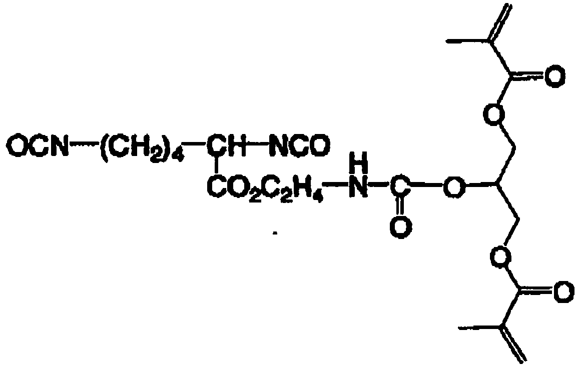

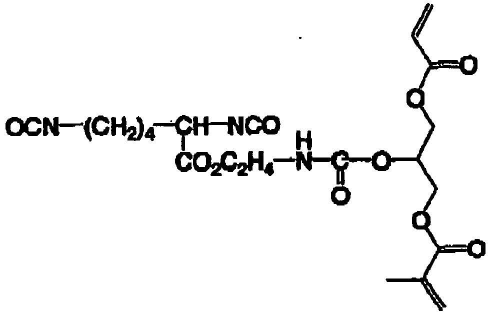

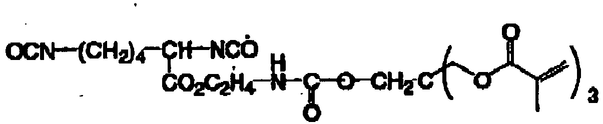

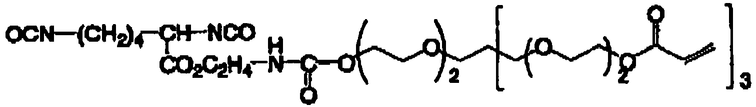

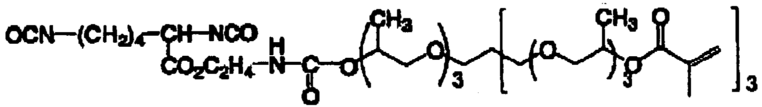

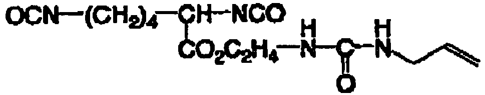

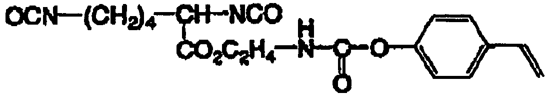

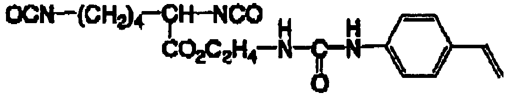

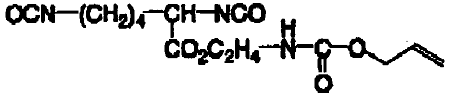

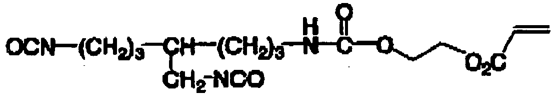

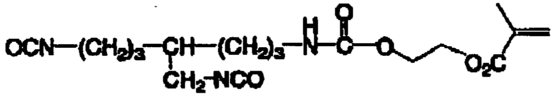

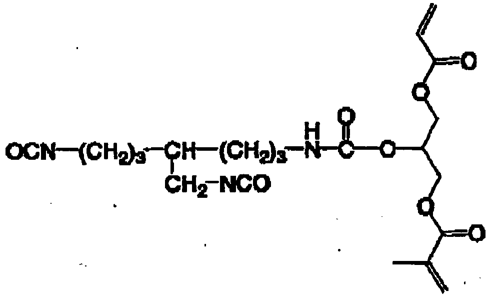

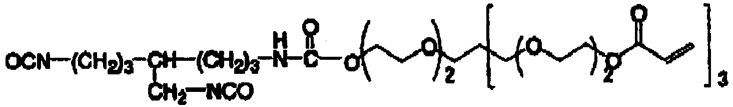

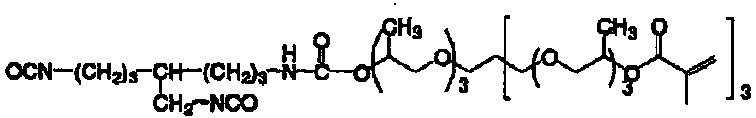

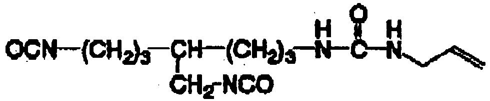

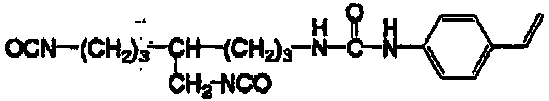

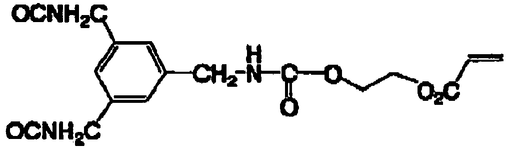

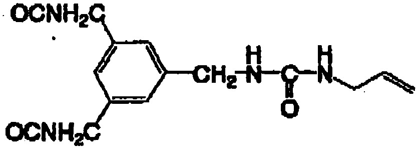

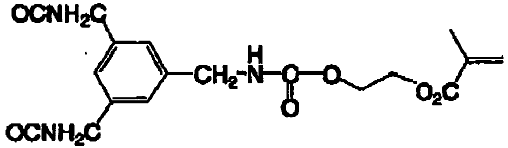

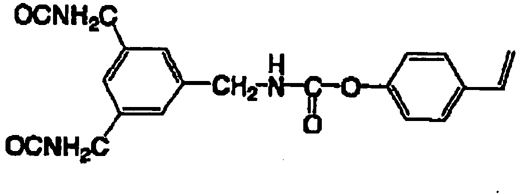

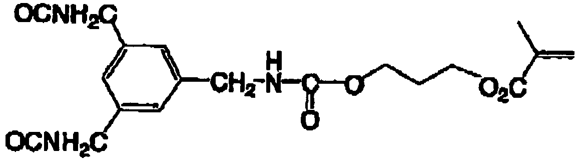

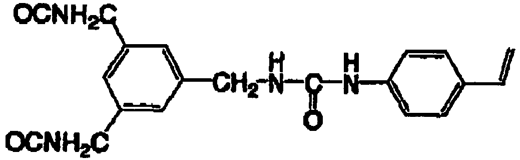

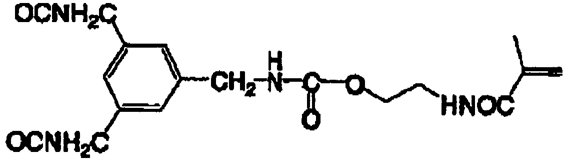

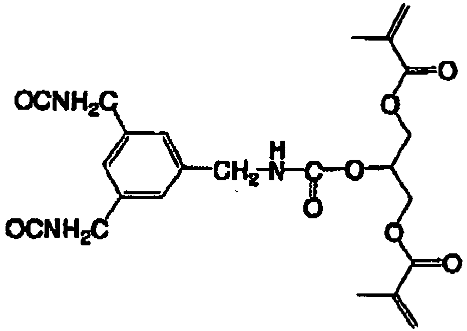

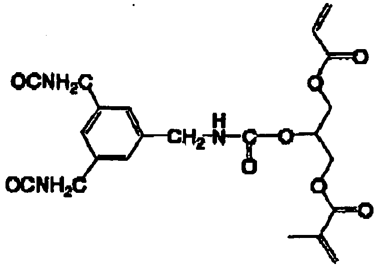

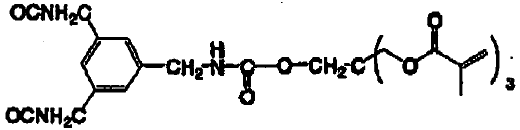

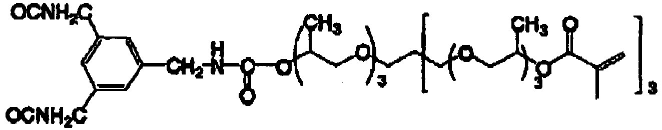

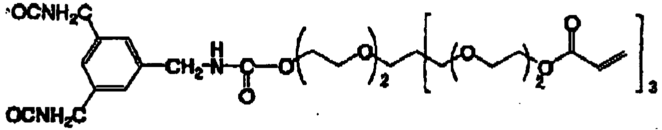

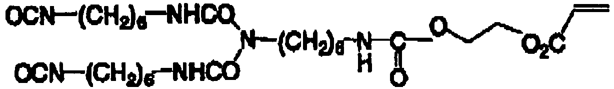

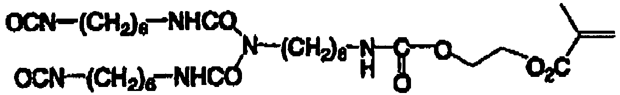

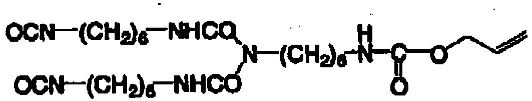

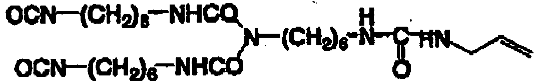

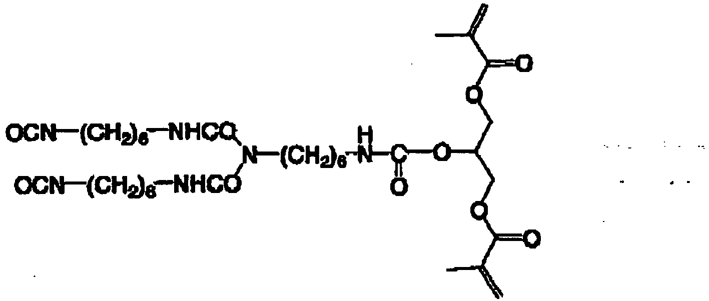

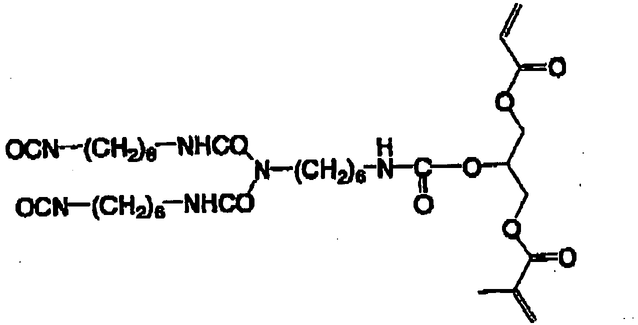

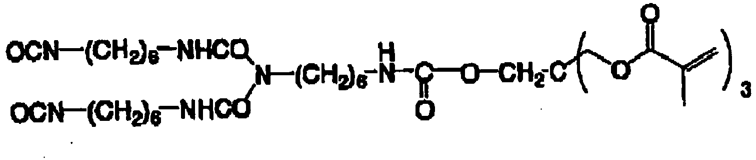

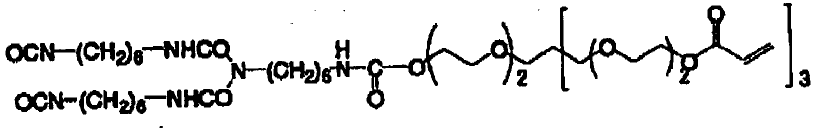

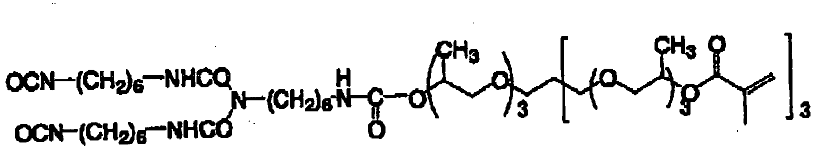

### (iv) Carboxyl group-free diol compound

As a method for introducing an unsaturated group into the side chain of the polyurethane resin, in addition to the foregoing methods, it is also suitable to use a method of using a diol compound containing an unsaturated group in the side chain thereof as the raw material for producing a polyurethane resin. As such a diol compound, commercially available products such as trimethylolpropane monoallyl ether may be employed. Compounds which are easily produced by reacting a halogenated diol compound, a triol compound or an aminodiol compound with an unsaturated group-containing carboxylic acid, acid chloride, isocyanate, alcohol, amine, thiol or halogenated alkyl compound may also be employed. Specific examples of these compounds include the following compounds, though the invention is not construed as being restricted thereto.

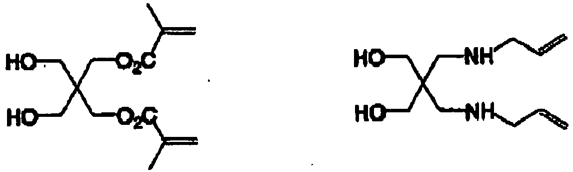

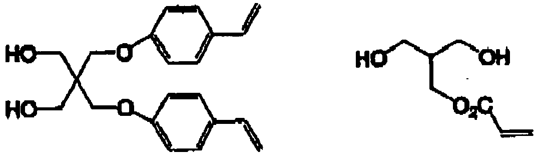

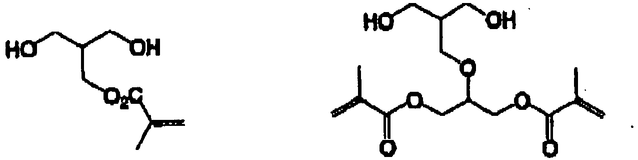

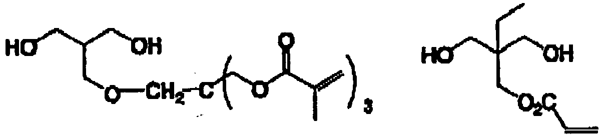

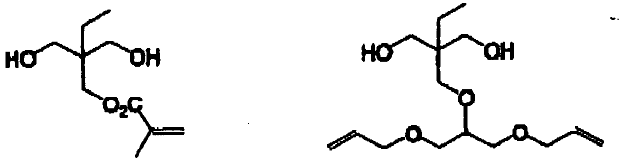

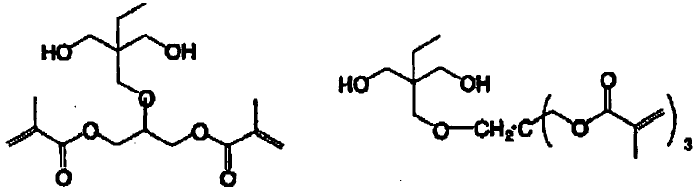

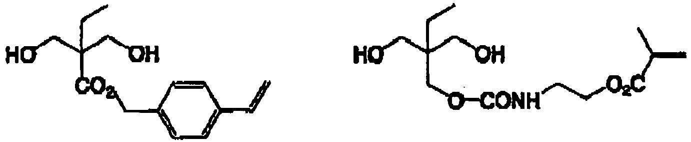

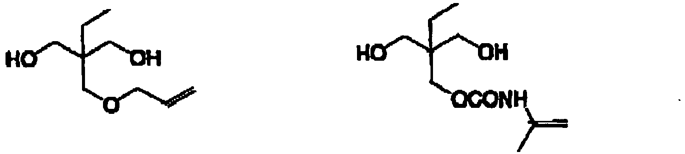

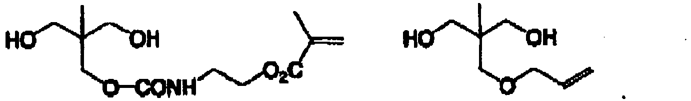

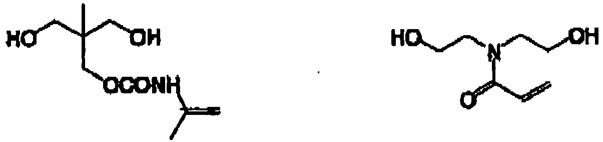

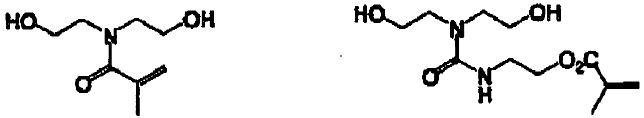

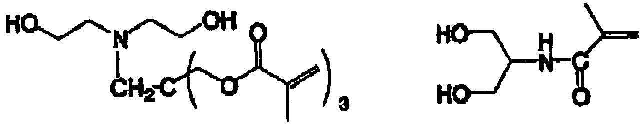

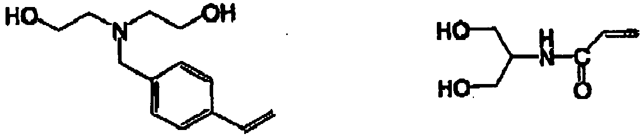

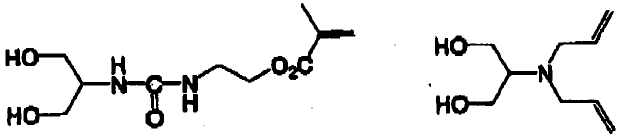

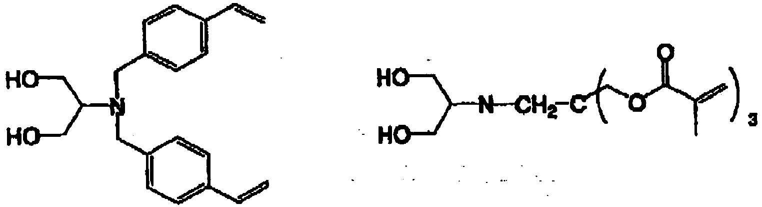

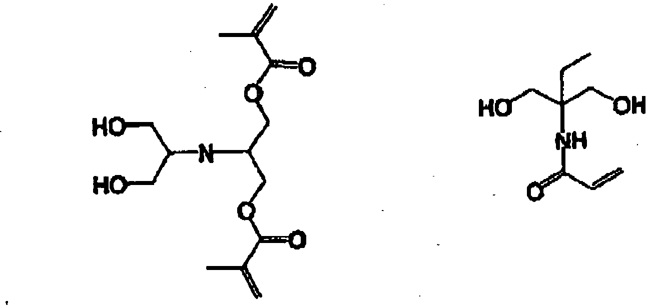

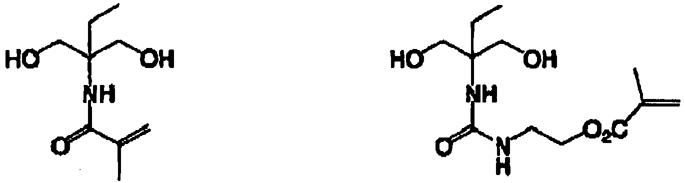

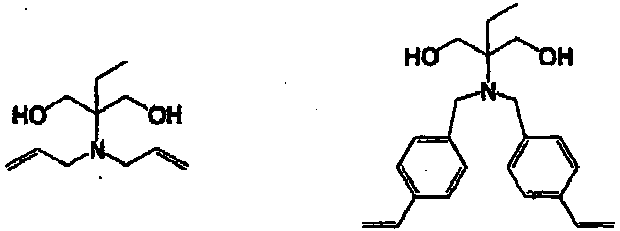

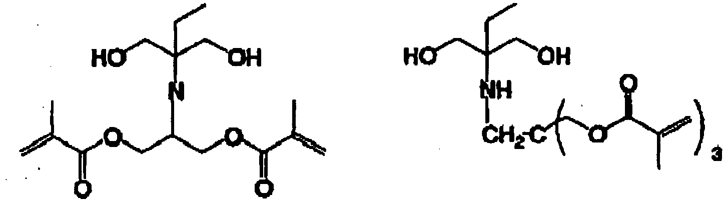

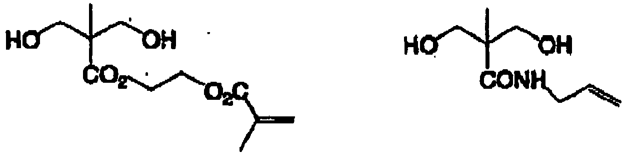

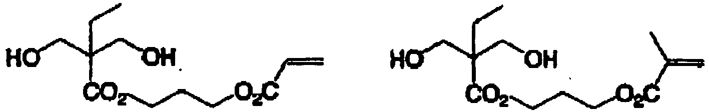

In addition, examples of still other diol compounds include ethylene glycol compounds represented by the following formula (A').

HO-(CH₂CH₂O)ₙ-H (A')

wherein n represents an integer of 1 or more.

Furthermore, there are numerated hydroxyl group-terminated random copolymers and block copolymers of ethylene oxide and propylene oxide.

In addition, use can be made of ethylene oxide adducts of bisphenol A (the number of addition of ethylene oxide is 27 or more but not more than 100), ethylene oxide adducts of bisphenol F (the number of addition of ethylene oxide is 22 or more but not more than 100), ethylene oxide adducts of hydrogenated bisphenol A (the number of addition of ethylene oxide is 23 or more but not more than 100), and ethylene oxide adducts of hydrogenated bisphenol F (the number of addition of ethylene oxide is 18 or more but not more than 100). More specifically, ethylene glycol compounds represented by the formula (A') are preferable in view of stainproof properties; ethylene glycol compounds wherein n is from 2 to 50 are more preferable; ethylene glycol compounds wherein n is from 3 to 30 are further preferable; and ethylene glycol compounds wherein n is from 4 to 10 are especially preferable.

Specific examples thereof include 1,2-propylene glycol, di-1,2-propylene glycol, tri-1,2-propylene glycol, tetra-1,2-propylene glycol, hexa-1,2-propylene glycol, 1,3-propylene glycol, di-1,3-propylene glycol, tri-1,3-propylene glycol, tetra-1,3-propylene glycol, 1,3-butylene glycol, di-1,3-butylene glycol, tri-1,3-butylene glycol, hexa-1,3-butylene glycol, polypropylene glycol having an average molecular weight of 400, polypropylene glycol having an average molecular weight of 700, polypropylene glycol having an average molecular weight of 1,000, polypropylene glycol having an average molecular weight of 2,000, polypropylene glycol having an average molecular weight of 3,000, polypropylene glycol having an average molecular weight of 4,000, neopentyl glycol, 2-butene-1,4-diol, 2,2,4-trimethyl-1,3,pentanediol, 1,4-bis-β-hydroxyethoxycyclohexane, 1,4-butanediol, 1,5-pentanediol, 1,6-hexanediol, 1,7-heptanediol, 1,8-octanediol, cyclohexanedimethanol, tricyclodecanedimethanol, hydrogenated bisphenol A, hydrogenated bisphenol F, an ethylene oxide adduct of bisphenol A (the number of addition of ethylene oxide is not more than 26), an ethylene oxide adduct of bisphenol F (the number of addition of ethylene oxide is not more than 21), an ethylene oxide adduct of hydrogenated bisphenol A (the number of addition of ethylene oxide is not more than 22), an ethylene oxide adduct of hydrogenated bisphenol F (the number of addition of ethylene oxide is not more than 17), a propylene oxide adduct of bisphenol A, a propylene oxide adduct of bisphenol F, a propylene oxide adduct of hydrogenated bisphenol A, a propylene oxide adduct of hydrogenated bisphenol F, hydroquinonedihydroxycthyl ether, p-xylylene glycol, dihydroxyethylsulfone, bis(2-hydroxyethyl)-2,4-tolylene dicarbamate, 2,4-tolylene-bis-(2-hydroxyethyl carbamide), bis(2-hydroxyethyl)-m-xylylene dicarbamate, and bis(2-hydroxyethyl) isophthalate.

Polyether diol compounds of a compound represented by the formula (A), (B), (C), (D) or (E) can also be suitably used.

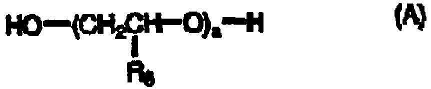

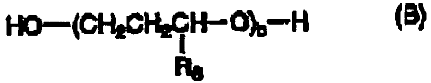

**HO-(CH₂CH₂CH₂CH₂-O)_{c}-H** (C)

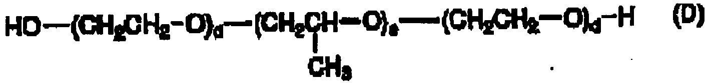

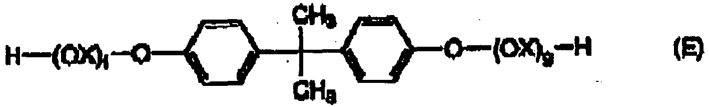

In the foregoing formulae, R₆ represents a hydrogen atom or a methyl group, provided that in the formula (A), R₆ represents a methyl group. X represents either one of the following groups.

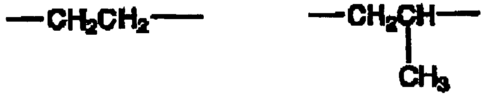

In the foregoing formulae, a, b, c, d, e, and f each represents an integer of 2 or more, and preferably an integer of from 2 to 100.

In addition, polyester diol compounds represented by the formulae (11) and (12) can be enumerated as specific examples.

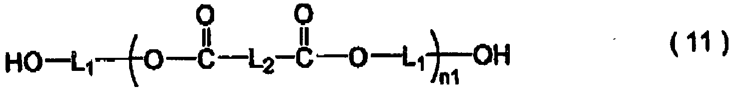

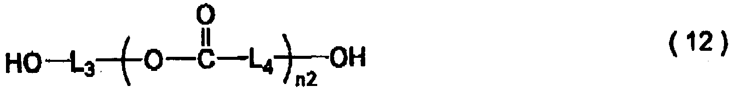

In the foregoing formulae, L₁, L₂, and L₃ may be either the same or different and each represents a divalent aliphatic or aromatic hydrocarbon group; and L₄ represents a divalent aliphatic hydrocarbon group. Preferably, L₁, L₂, and L₃ each represents an alkylene group, an alkenylene group, an alkynylene group, or an arylene group; and L₄ represents an alkylene group. Furthermore, L₁, L₂, L₃, and L₄ may contain other functional group which does not react with the isocyanate group, such as an ether, carbonyl, ester, cyano, olefin, urethane, amide or ureido group, or a halogen atom. n₁ and n₂ each represents an integer of 2 or more, and preferably an integer of from 2 to 100.

In addition, polycarbonate diol compounds represented by the formula (13) can be enumerated as specific examples.

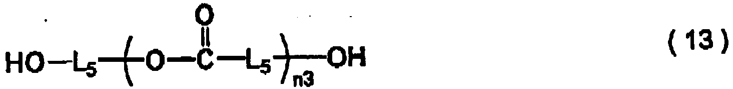

In the foregoing formula (13), L₅s may be the same or different and each represents a divalent aliphatic or aromatic hydrocarbon group. Preferably, L₅ represents an allcylene group, an alkenylene group, an alknylene group, or an arylene group. Furthermore, L₅ may contain other functional group which does not react with the isocyanate group, such as an ether, carbonyl, ester, cyano, olefin, urethane, amide or ureido group, or a halogen atom. n₃ represents an integer of 2 or more, and preferably an integer of from 2 to 100,

Specific examples of the diol compounds represented by the formulae (11), (12) and (13) include the following compounds. In the following specific examples, n represents an integer of 2 or more.

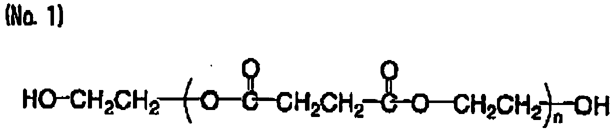

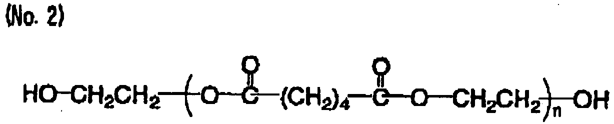

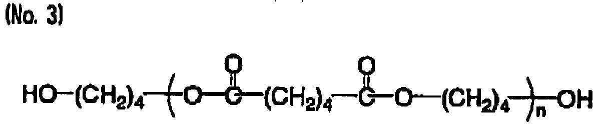

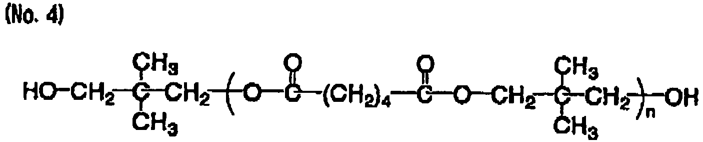

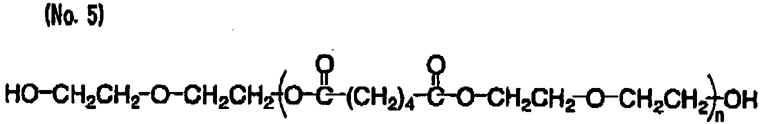

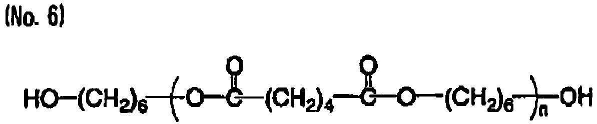

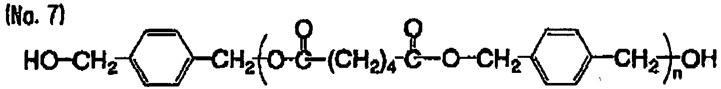

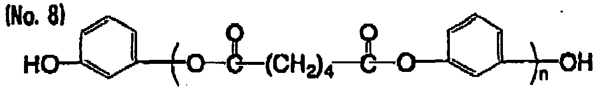

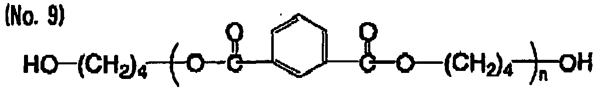

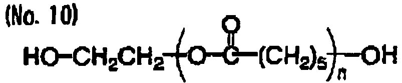

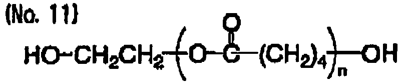

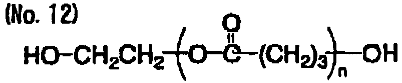

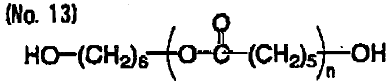

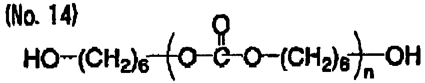

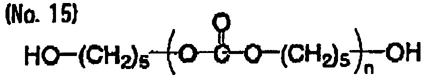

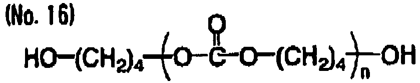

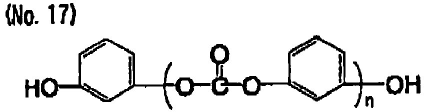

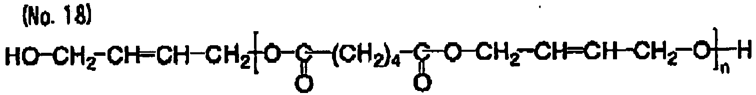

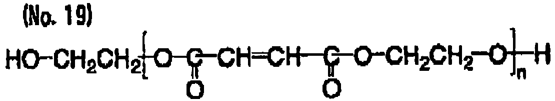

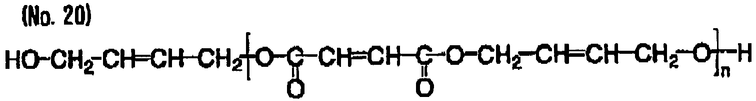

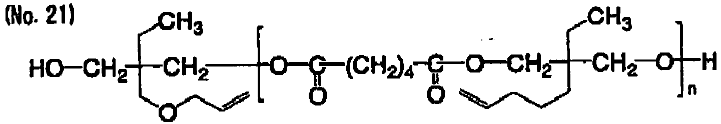

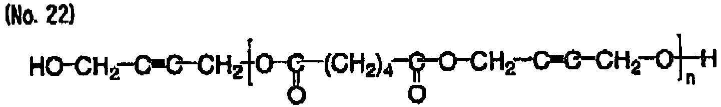

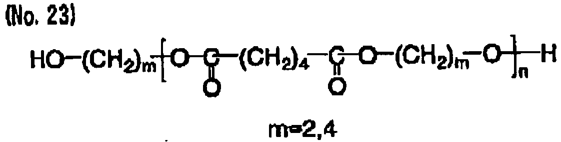

Moreover, it is also possible to use diol compounds which do not contain a carboxyl group and may contain other substituent which does not react with the isocyanate.

Such a diol compound includes the following compounds.

HO-L₆-O-CO-L₇-CO-O-L₆-OH (14)

HO-L₇-CO-O-L₆-OH (15)

In the foregoing formulae, L₆ and L₇ may be either the same or different and each represents an optionally substituted divalent aliphatic hydrocarbon group, aromatic hydrocarbon group or heterocyclic group (examples of the substituent include alkyl, aralkyl, aryl, alkoxy and aryloxy groups, and halogen atoms(for example, -F, -Cl, -Br, and -I). If desired, L₆ and L₇ may each contain other functional group which does not react with the isocyanate group, such as a carbonyl, ester, urethane, amide or ureido group. Incidentally, L₆ and L₇ may be bonded together to form a ring.

Specific examples of the compound represented by the formula (14) or (15) include the following compounds. 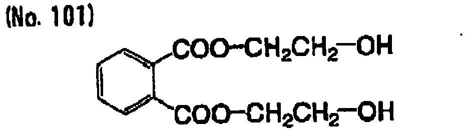 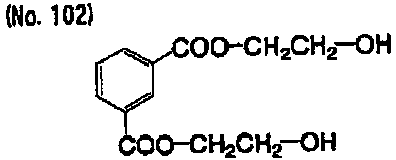 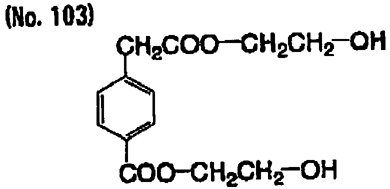 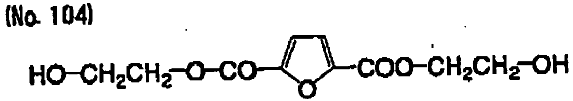 (No. 105)

HO-CH₂CH₂-O-CO-CH=CH-COO-CH₂H₂-OH

(No. 106)

HO-CH₂CH₂-O-COC₁₁H₂₂COO-CH₂OH₂-OH

(No.107)

HO-CH₂CH₂-O-COC₁₂H₂₄COO-CH₂CH₂-OH

(No. 108)

HO-CH₂CH₂O-COC₁₄H₂₈COO-CH₂CH₂-OH

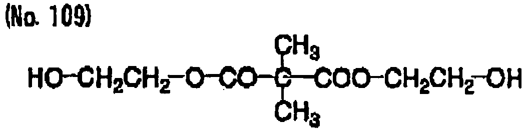

(No. 110)

NO-CH₂CH₂-O-CO-C≡C-COO-CH₂CH₂-OH

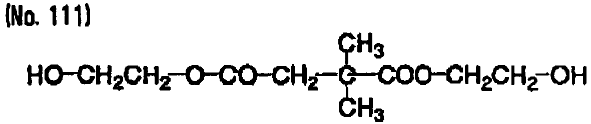

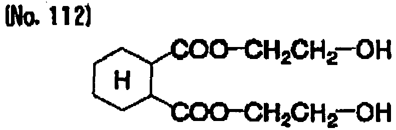

(No. 113)

HO-OH₂CH₂-O-CO-CH₂-O-CH₂-COO-CH₂CH₂-OH

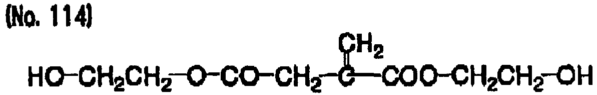

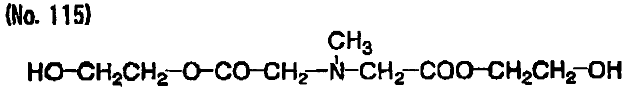

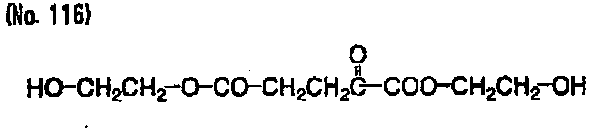

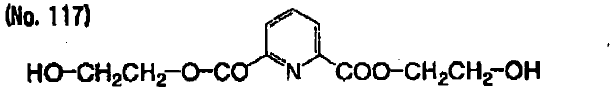

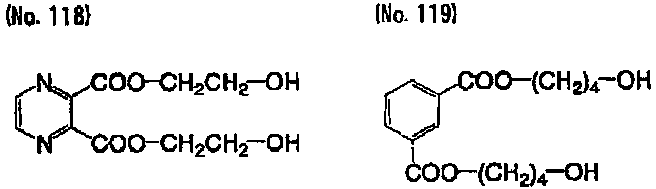

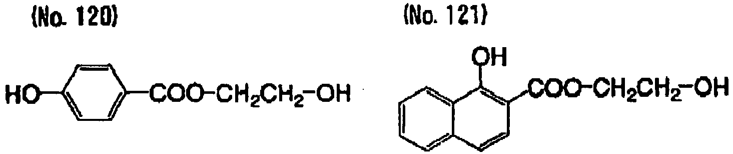

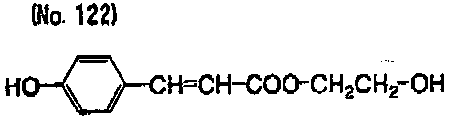

(No. 123)

HO-CH₂CH₂-COO-CH₂CH₂-OH

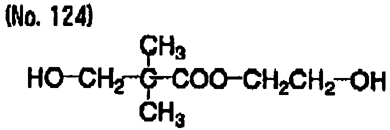

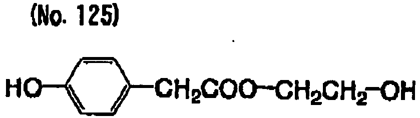

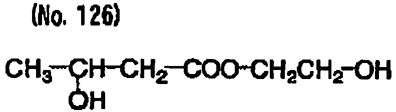

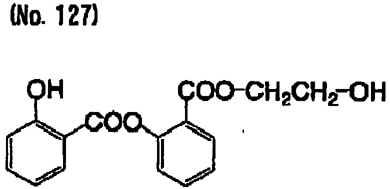

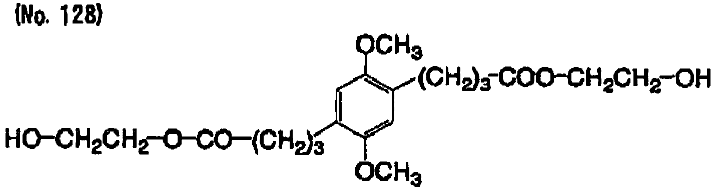

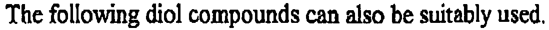

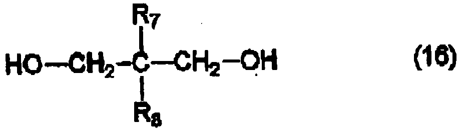

**H_{O}-CH₂-C≡C-CH₂-OH** (17)

**HO-CH₂-CH=CH-CH₂-OH** (18)

In the foregoing formulae, R₇ and R₈ may be either the same or different and each represents an optionally substituted alkyl group, and preferably an optionally substituted alkyl group having from 1 to 10 carbon atoms (examples of the substituent include cyano, nitro, a halogen atom (for example, -F, -Cl, -Br, and -I), -CONH₂, -COOR, and -OR (wherein Rs may be either the same or different and each represents an alkyl group having from 1 to 10 carbon atoms, an aryl group having from 7 to 15 carbon atoms, or an aralkyl group)).

Specific examples of the diol compound represented by the formula (16) include the following compounds.

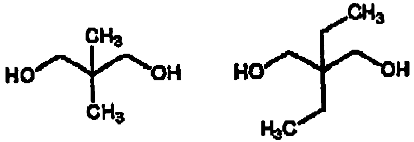

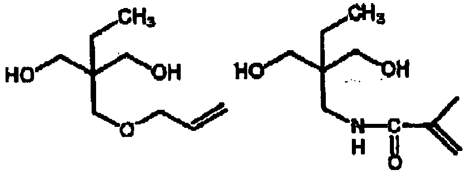

2-Butyne-1,4-diol is enumerated as the formula (17); and cis-2-butene-1,4-diol and trans-2-butene-1,4-diol are enumerated as the formula (18).

Diol compounds represented by the following formulae (19) and (20) can also be suitably used.

HO-L₈-NH-CO-L₉-CO-NH-L₈-OH (19)

HO-L₉-CO-NH-L₈-OH (20)

In the foregoing formulae, L₈ and L₉ may be either the same or different and each represents an optionally substituted divalent aliphatic hydrocarbon group, aromatic hydrocarbon group or heterocyclic group (examples of the substituent include alkyl, aralkyl, aryl, alkoxy and aryloxy groups, and halogen atoms (for example, -F, -Cl, -Br, and -I)). If desired, L₈ and L₉ may each contain other functional group which does not react with the isocyanate group, such as a carbonyl, ester, urethane, amide or ureido group. Incidentally, L₈ and L₉ may be bonded together to form a ring.

Specific examples of the compound represented by the formula (19) or (20) include the following compounds. 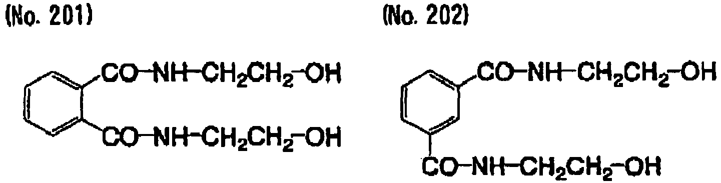 (No. 203)

HO-CH₂CH₂-NH-CO-CH=CH-CO-NH-CH₂CH₂-OH

(No. 204)

HO-CH₂CH₂-NH-CO-C≡C-CO-NH-CH₂CH₂-OH

(No. 205)

HO-CH₂CH₂-NH-CO-(CH₂)₂-CO-NH-CH₂CH₂-OH

(No. 206)

HO-CH₂CH₂-NH-CO-(CH₂)₃-CO-NH-CH₂CH₂-OH

(No. 207)

HO-CH₂CH₂-NH-CO-(CH₂)₅-CO-NH-CH₂CH₂-OH

(No. 208)

HO-CH₂CH₂-NH-CO-(CH₂)₈-CO-NH-CH₂CH₂-OH

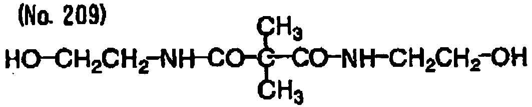

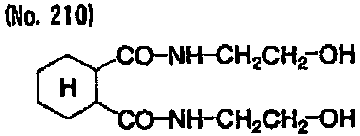

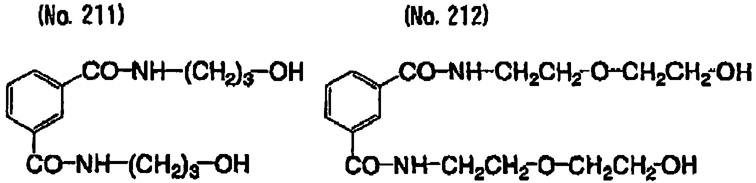

(No. 213)

HO-CH₂)₃-NH-CO-(CH₂)₃-NH-CO-(CH₂)₂-CO-NH-(CH₂)₃-OH

(No. 214)

HO-CH₂CH₂-O-CH₂CH₂-NH-CO-(CH₂)₄-CO-NH-CH₂CH₂-O-CH₂CH₂-OH

(No. 215)

HO-CH₂CH₂-NH-CO-CH₂-O-CH₂-CO-NH-CH₂CH₂-OH

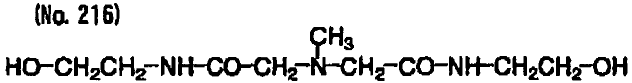

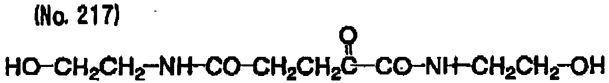

(No. 218)

HO-CH₂CH₂-NH-CO-CH₂-S-CH₂-CO-NH-CH₂CH₂OH

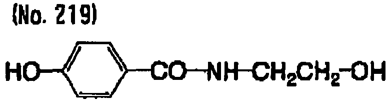

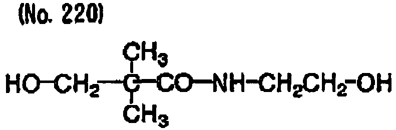

In addition, diol compounds represented by the following formulae (21) and (22) can be suitably used.

HO-Ar₂-(L₁₆-Ar₃)ₙ-OH (21)

HO-Ar₂-L₁₆-OH (22)

In the foregoing formulae, L₁₆ represents an optionally substituted divalent aliphatic hydrocarbon group (examples of the substituent include alkyl, aralkyl, aryl, alkoxy and aryloxy groups, and halogen atoms. If desired, L₁₆ may contain other functional group which does not react with the isocyanate group, such as an ester, urethane, amide or ureido group.

Ar₂ and Ar₃ may be either the same or different and each represents an optionally substituted divalent aromatic hydrocarbon group, and preferably an aromatic group having from 6 to 15 carbon atoms; and n represents an integer of from 0 to 10.

Specific examples of the diol compound represented by the formula (21) or (22) include the following compounds.

Namely, examples thereof include catechol, resorcin, hydroquinone, 4-methylcatechol, 4-t-butylcatechol, 4-acetylcatechol, 3-methoxycatechol, 4-phenylcatechol, 4-methylresorcin, 4-ethylresorcin, 4-t-butylresorcin, 4-hexylresorcin, 4-chlororesorcin, 4-benzylresorcin, 4-acetylresorcin, 4-carbomethoxyresorcin, 2-methylresorcin, 5-methylresorcin, t-butylhydroquinone, 2,5-di-t-butylhydroquinone, 2,5-di-t-amylhydroquinone, tetramethylhydroquinone, tetrachlorohydroquinone, methylcarbaminohydroquione, methylureidohydroquinone, methylthiohydroquinone, benzonorbornene-3,6-diol, bisphenol A, bisphenol S, 3,3'-dichlorobisphenol S, 4,4'-dihydroxybenzophenone, 4,4'-dihydroxybiphenyl, 4,4'-thiodiphenol, 2,2'-dihydroxydiphenylmethane, 3,4-bis(p-hydroxyphenyl)hexane, 1,4-bis(2-(p-hydroxyphenyl)propyl)benzene, bis(4-hydroxyphenyl)methylamine, 1,3-dihydroxynaphthalene, 1,4-dihydroxynaphthalene, 1,5-dihydroxynaphthalene, 2,6-dihydroxynaphthalene, 1,5-dihydroxyanthraquinone, 2-hydroxybenzyl alcohol, 4-hydroxybenzyl alcohol, 2-hydroxy-3,5-di-t-butylbenzyl alcohol, 4-hydroxy-3,5-di-t-butylbenzyl alcohol, 4-hydroxyphenethyl alcohol, 2-hydroxyethyl-4-hydroxybenzoate, 2-hydroxyethyl-4-hydroxyphenyl acetate and resorcin mono-2-hydroxyethyl ether. The following diol compounds can also be suitably used.

### (v) Other amino group-containing compound

In the polyurethane resin binder used in the invention, a structure of a polyurethane resin as prepared by combining an amino group-containing compound represented by the following formula (31) or (32) and allowing it to react with a diisocyanate compound, thereby forming a urea structure may be incorporated,

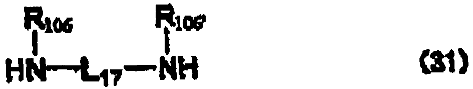

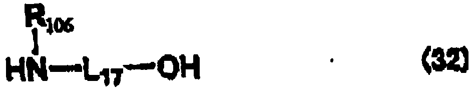

In the foregoing formulae, R₁₀₆ and R_{106'} may be either the same or different and each represents a hydrogen atom or an optionally substituted alkyl, aralkyl or aryl group (examples of the substituent include alkoxy, halogen atoms (for example, -F, -Cl, -Br, and -I), ester and carboxyl groups), and preferably a hydrogen atom or an alkyl group having from 1 to 8 carbon atoms or an aryl group having from 6 to 15 carbon atoms, each of which may contain a carboxyl group as a substituent. L₁₇ represents an optionally substituted divalent aliphatic hydrocarbon group, aromatic hydrocarbon group or heterocyclic hydrocarbon group (examples of the substituent include alkyl, aralkyl, aryl, alkoxy and aryloxy groups, halogen atoms (for example, -F, -Cl, -Br, and -I), and a carboxyl group). If desired, L₁₇ may contain other functional group which does not react with the isocyanate group, such as a carbonyl, ester, urethane or amide group. Incidentally, two of R₁₀₆, L₁₇, and R_{106'} may be bonded together to form a ring.

Specific examples of the compound represented by the formula (31) or (32) include the following compounds.

Namely, examples thereof include aliphatic diamine compounds (for example, ethylenediamine, propylenediamine, tetramethylenediamine, pentamethylenediamine, hexamethylenediamine, heptamethylencdiamine, octamethylenediamine, dodecamethylenediamine, propane-1,2-diamine, bis(3-aminopropyl)methylamine, 1,3-bis(3-aminopropyl)tetramethylsiloxane, piperazine, 2,5-dimethylpiperazine, N-(2-aminoethyl)piperazine, 4-amino-2,2,6,6-tetramethylpiperidine, N,N-dimethylethylenediamine, lysine, L-cystine, and isophoronediamine); aromatic diamine compounds (for example, o-phenyIenediamine, m-phenylenediamine, p-phenylenediamine, 2,4-tolylenediamine, benzidine, o-ditoluidine, o-dianisidine, 4-nitro-m-phenylenediamine, 2,5-dimethoxy-p-phenylenediamine, bis(4-amino-phenyl)sulfone, 4-carboxy-o-phenylenediamine, 3-carboxy-m-phenylenediamine, 4,4'-diaminophenyl ether, and 1,8-naphthalenediamine); heterocyclic amine compounds (for example, 2-aminoimidazole, 3-aminotriazole, 5-amino-1H-tetrazole, 4-aminopyrazole, 2-aminobenzimidazole, 2-amino-5-carboxy-triazole, 2,4-di-amino-6-methyl-S-triazine, 2,6-diaminopyridine, L-histidine, DL-tryptophan, and adenine); and amino alcohol or amino phenol compounds (for example, ethanolamine, N-methylethanolamine, N-ethylethanolamine, 1-amino-2-propanol, 1-amino-3-propanol, 2-aminoethoxyethanol, 2-aminothioethoxyethanol, 2-amino-2-methyl-1-propanol, p-aminophenol, m-aminophenol, o-aminophenol, 4-methyl-2-aminophenol, 2-chloro-4-aminophenol, 4-methoxy-3-aminophenol, 4-hydroxybenzylamine, 4-amino-1-naphthol, 4-aminosalicylic acid, 4-hydroxy-N-phenylglycine, 2-aminobenzyl alcohol, 4-aminophenethyl alcohol, 2-carboxy-5-amino-1-naphthol, and L-tyrosine).

In addition to the foregoing polyurethane resins as obtained by introducing a crosslinking group in the side chain thereof at the time of synthesis of polyurethane, polyurethane resins which are obtained by introducing a crosslinking group into a carboxyl group-containing polyurethane by a polymeric reaction as described in JP-A-2003-270775 can be used as the polymer binder according to the invention.

Next, the (meth)acrylic resin containing a crosslinking group in the side chain will be described in greater detail.

As the (meth)acrylic resin containing a crosslinking group in the side chain thereof which is used in the invention, a resin containing a repeating unit represented by the following formula (i) is preferable from the viewpoint of developability.

The resin containing a repeating unit represented by the formula (i) will be hereunder properly referred to as a "specific (meth)acrylic resin" and described below in detail.

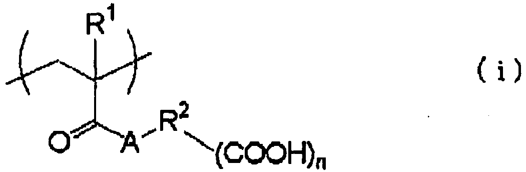

In the foregoing formula (i), R¹ represents a hydrogen atom or a methyl group; R² represents a linking group constituted of one or more atoms selected from the group consisting of a carbon atom, a hydrogen atom, an oxygen atom, a nitrogen atom, and a sulfur atom; A represents an oxygen atom or -NR³- (wherein R³ represents a hydrogen atom or a monovalent hydrocarbon group having from 1 to 10 carbon atoms); and n represents an integer of from 1 to 5.

First of all, R¹ in the formula (i) represents a hydrogen atom or a methyl group, and especially preferably a methyl group.

The linking group represented by R² in the formula (i) is constituted of one or more atoms selected from the group consisting of a carbon atom, a hydrogen atom, an oxygen atom, a nitrogen atom, and a sulfur atom, and it is preferable that the number of atoms exclusive of its substituent is from 2 to 82. Speeifcally, the number of atoms constituting the principal skeleton of the linking group represented by R² is preferably from 1 to 30, more preferably from 3 to 25, further preferably from 4 to 20, and most preferably from 5 to 10. Incidentally, the term "principal skeleton of the linking group" as referred to in the invention refers to atoms or an atomic group to be used only for connecting A to the terminal COOH in the formula (i); and in particular, when plural connecting routes are present, this term refers to atoms or an atomic group for constituting a route where the number of atoms to be used is the smallest. Accordingly, in the case where a cyclic structure is contained in the linking group, the number of atoms to be counted varies depending upon its connecting site (for example, o-, m-, and p-).

Furthermore, more specifically, examples of the linking group include alkylene, substituted alkylene, arylene, and substituted arylene groups, The linking group may have a structure in which a plural number of such divalent groups are connected to each other via an amide bond or an ester bond.

Examples of the linking group of a chain structure include ethylene and propylene. Structures in which such alkylenes are connected to each other via an ester bond can also be enumerated as a preferred structure.

Above all, it is preferable that the linking group represented by R² in the formula (i) is a hydrocarbon group having a valence of (n + 1) and having an aliphatic cyclic structure having from 3 to 30 carbon atoms. More specifically, a hydrocarbon group having a valence of (n + 1) resulting from elimination of (n + 1) hydrogen atoms on arbitrary carbon atoms constituting a compound having an aliphatic cyclic structure, which may be substituted with one or more arbitrary substituents, such as cyclopropane, cyclopentane, cyclohexane, cycloheptane, cyclooctane, cyclodecane, dicyclohexyl, tercyclohexyl, and norbornane can be enumerated. Furthermore, it is preferable that R² has from 3 to 30 carbon atoms including the substituent.

One or more arbitrary carbon atoms of a compound constituting an aliphatic cyclic structure may be substituted with a hetero atom selected from a nitrogen atom, an oxygen atom, and a sulfur atom. In view of printing resistance, R² is preferably a hydrocarbon group having a valence of (n + 1) and having an optionally substituted aliphatic cyclic structure, which has from 5 to 30 carbon atoms and contains two or more rings, such as fused polycyclic aliphatic hydrocarbons, crosslinked alicyclic hydrocarbons, spiro aliphatic hydrocarbons, and aliphatic hydrocarbon ring agglomerations (in which plural rings are connected to each other via a bond or a linking group). In this case, the number of carbon atoms is one including the number of carbon atoms which the substituent has, too.

As the linking group represented by R², a linking group having the number of atoms constituting the principal skeleton of the linking group of from 5 to 10 is preferable. With respect to the structure, a linking group having a chain structure and containing an ester bond in the structure thereof and a linking group having the foregoing cyclic structure are preferable.

As the substituent which can be introduced into the linking group represented by R², a monovalent non-metallic atomic group excluding hydrogen can be enumerated. Examples thereof include a halogen atom (for example, -F, -Br, -Cl, and -I), a hydroxyl group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, an ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycabonylamino group, an N-aryl-N-alkoxycarbonylamino group, an N-aryl-N-aryloxycarbonylamino group, a formyl group, an acyl group, a carboxyl group and its conjugated base group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group, an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, an N-acylsulfamoyl group and its conjugated base group, an N-alkylsulfonylsulfamoyl group (-SO₂NHSO₂(alkyl)) and its conjugated base group, an N-arylsulfonylsulfamoyl group (-SO₂NHSO₂(aryl)) and its conjugated base group, an N-alkylsulfonylcarbamoyl group (-CONHSO₂(alkyl)) and its conjugated base group, an N-arylsulfonylcarbamoyl group (-CONHSO₂(aryl)) and its conjugated base group, an alkoxysilyl group (-Si(Oalkyl)₃), an aryloxysilyl group (-Si(Oaryl)₃), a hydroxysilyl group (-Si(OH)₃) and its conjugated base group, a phosphono group (-PO₃H₂) and its conjugated base group, a dialkylphosphono group (-PO₃(alkyl)₂) a diarylphosphono group (-PO₃(aryl)₂), an alkylarylphosphono group (-PO₃(alkyl)(aryl)), a monoalkylphosphono group (-PO₃H(alkyl)) and its conjugated base group, a monoarylphosphono group (-PO₃H(aryl)) and its conjugated base group, a phosphonoxy group (-OPO₃H₂) and its conjugated base group, a dialkylphosphonoxy group (-OPO₃(alkyl)₂), a diarylphosphonoxy group (-OPO₃(aryl)₂), an alkylarylphosphonoxy group (-OPO₃(alkyl)(aryl)), a monoalkylphosphonoxy group (-OPO₃H(alkyl)) and its conjugated base group, a monoarylphosphonoxy group (-OPO₃H(aryl)) and its conjugated base group, a cyano group, a nitro group, a dialkylboryl group (-B(alkyl)₂), a diarylboryl group (-B(aryl)₂), an alkylarylboryl group (-B(alkyl)(aryl)), a dihydroxyboryl group (-B(OH)₂) and its conjugated base group, an alkylhydroxyboryl group (-B(alkyl)(OH)) and its conjugated base group, an arylhydroxyboryl group (-B(aryl)(OH)) and its conjugated base group, an aryl group, an alkenyl group, and an alkynyl group.

In the photosensitive lithographic printing plate of the invention, a hydrogen-containing substituent which can undergo hydrogen bonding, and especially an acidic substituent having an acid dissociation constant (pKa) lower than carboxylic acids are not preferable because they are liable to lower the printing resistance, an aspect of which, however, varies depending upon the design of the photosensitive layer. On the other hand, a halogen atom and a hydrophobic substituent such as a hydrocarbon group (for example, an alkyl group, an aryl group, an alkenyl group, and an alkynyl group), an alkoxy group, and an aryloxy group are preferable because they are liable to enhance the printing resistance. In particular, in the case where the cyclic structure is a monocyclic aliphatic hydrocarbon constructed of not more than 6 members, such as cyclopentane and cyclohexane, it is preferable that such a hydrophobic substituent is contained therein. If possible, such substituents may be bonded together or bonded to a hydrocarbon group as substituted to form a ring. The substituent may be further substituted.

When A in the formula (i) is NR³-, R³ represents a hydrogen atom or a monovalent hydrocarbon group having from 1 to 10 carbon atoms. Examples of the monovalent hydrocarbon group having from 1 to 10 carbon atoms as represented by R³ include an alkyl group, an aryl group, an alkenyl group, and an alkynyl group.

Specific examples of the alkyl group include linear, branched or cyclic alkyl groups having from 1 to 10 carbon atoms such as a methyl group, an ethyl group, a propyl group, a butyl goup, a pentyl group, a hexyl group, a heptyl group, an octyl group, a nonyl group, a decyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclopentyl group, a cyclohexyl group, a 1-adamantyl group, and a 2-norbornyl group.

Specific examples of the aryl group include aryl groups having from 1 to 10 carbon atoms (for example, a phenyl group, a naphthyl group, and an indenyl group) and heteroaryl groups having from 1 to 10 carbon atoms and containing one hetero atom selected from the group consisting of a nitrogen atom, an oxygen atom, and a sulfur atom (for example, a furyl group, a thienyl group, a pyrrolyl group, a pyridyl group, and a quinolyl group).

Specific examples of the alkenyl group include linear, branched or cyclic alkenyl groups having from 1 to 10 carbon atoms such as a vinyl group, a 1-propenyl group, a 1-butenyl group, a 1-methyl-1-propenyl group, a 1-cyclopentenyl group, and a 1-cyclohexenyl group.

Specific examples of the alkynyl group include alkynyl groups having from 1 to 10 carbon atoms such as an ethynyl goup, a 1-propynyl group, a 1-butynyl group, and a 1-octynyl group. The substituent which R³ may contain is the same as the substituent which R² can introduce. However, the number of carbon atoms of R³ is from 1 to 10 inclusive of the number of carbon atoms of the substituent.

A in the formula (i) is preferably an oxygen atom or -NH- because of easiness of the synthesis.

n in the formula (i) represents an integer of from 1 to 5, and preferably 1 in view of printing resistance.

Preferred specific examples of the repeating unit represented by the formula (i) will be given below, though the invention is not construed as being restricted thereto.

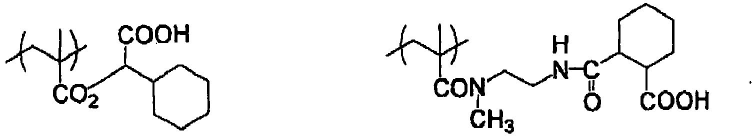

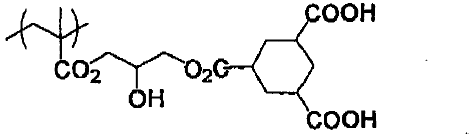

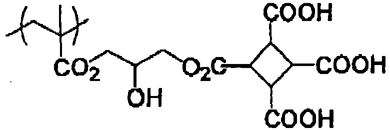

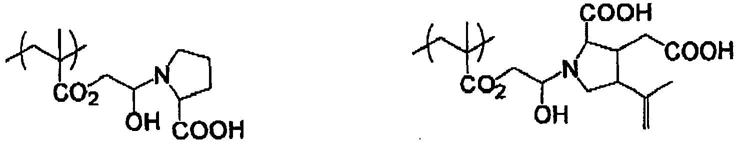

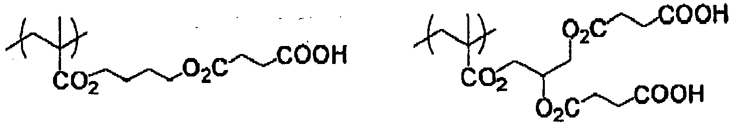

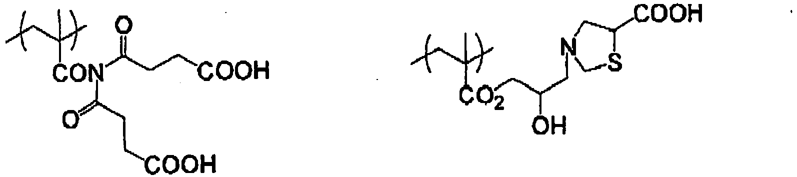

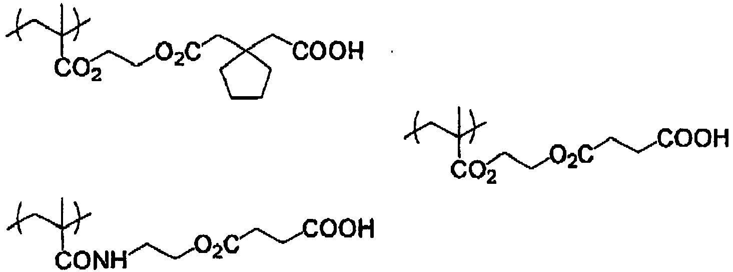

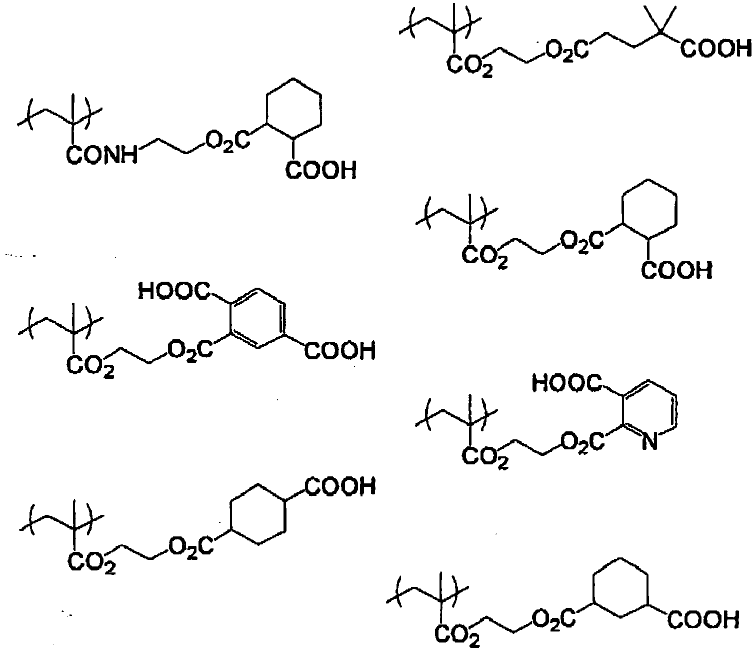

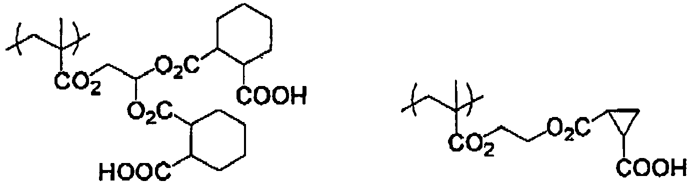

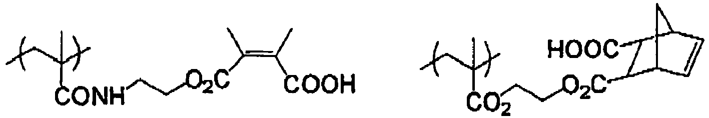

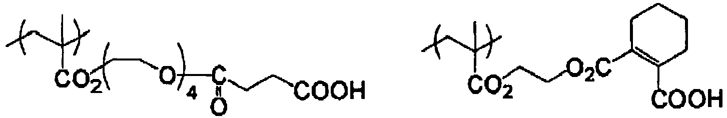

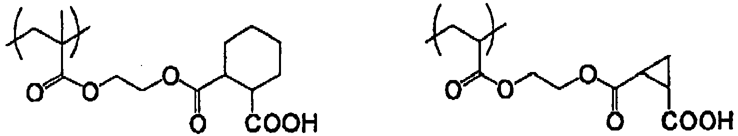

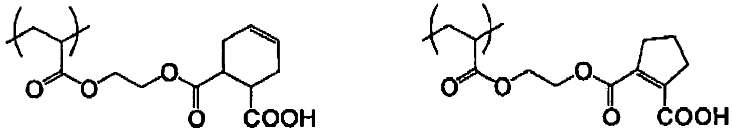

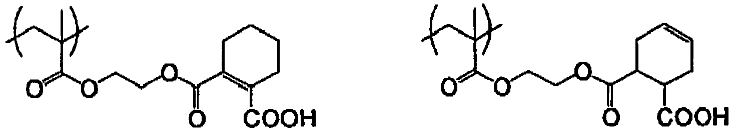

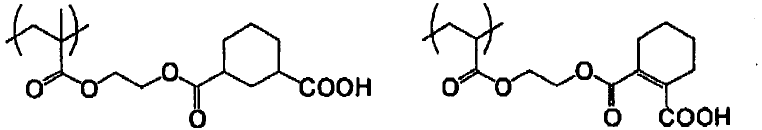

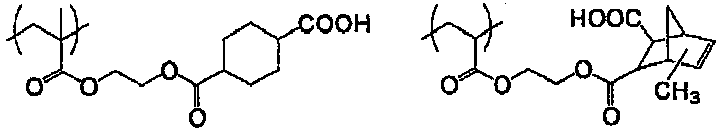

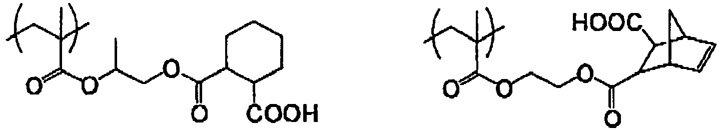

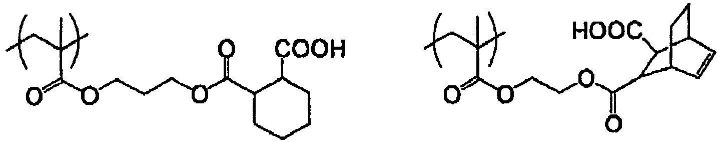

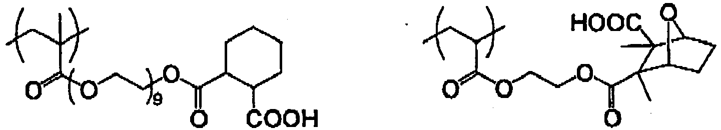

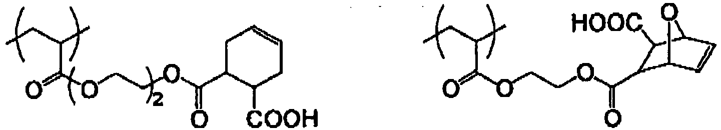

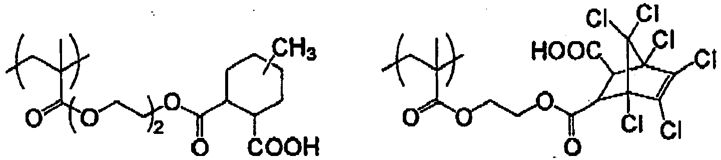

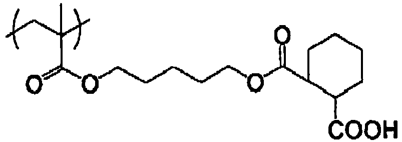

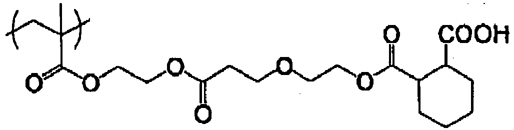

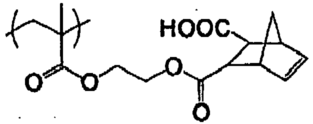

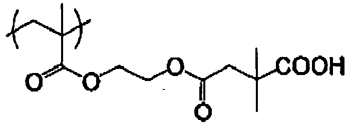

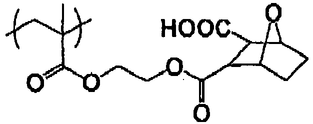

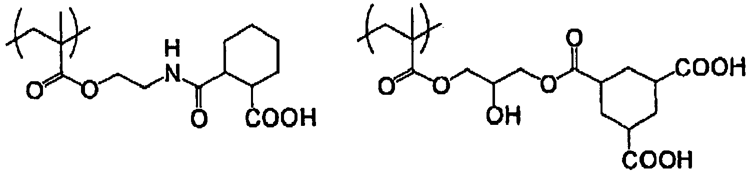

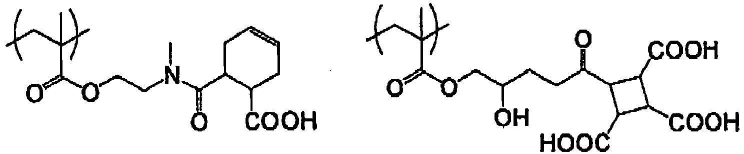

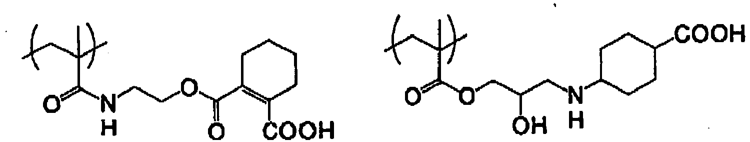

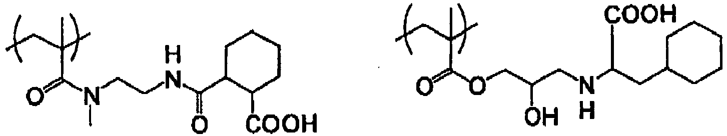

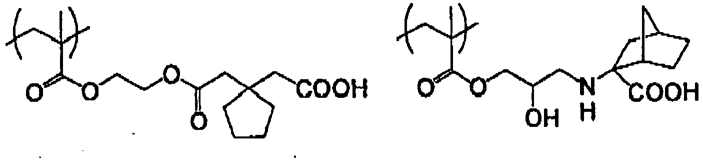

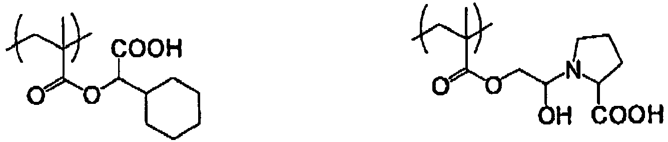

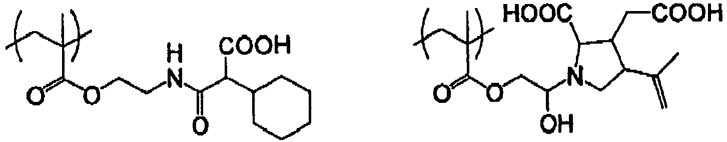

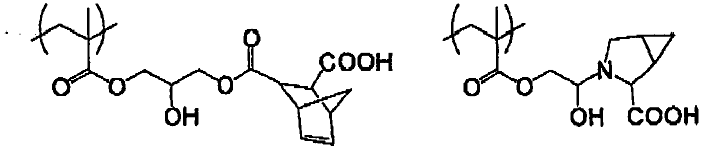

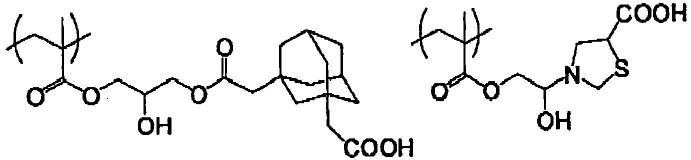

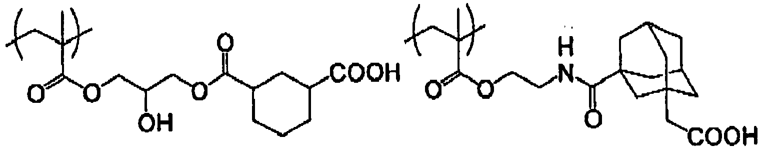

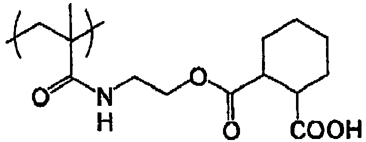

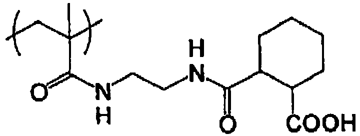

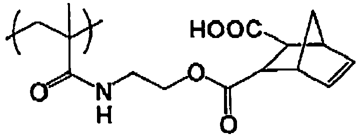

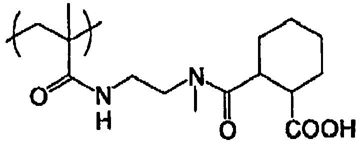

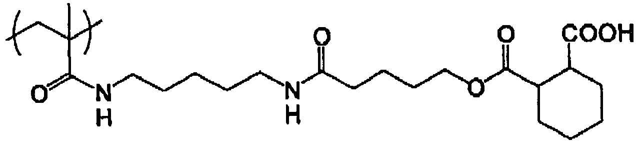

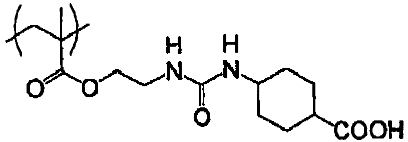

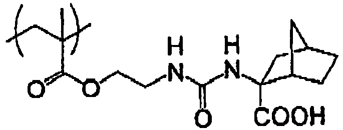

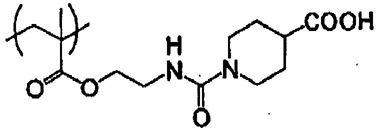

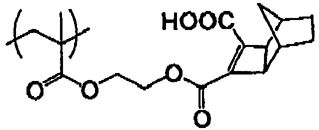

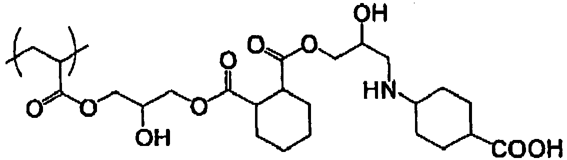

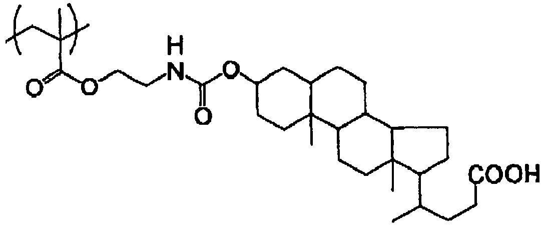

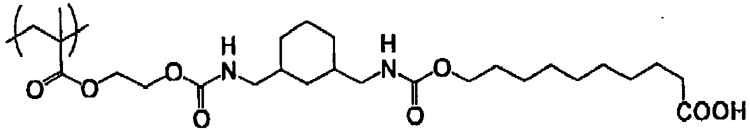

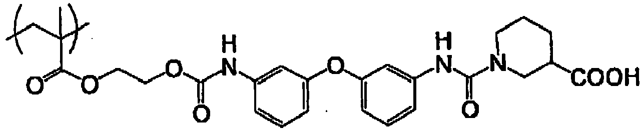

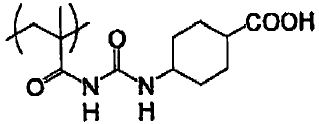

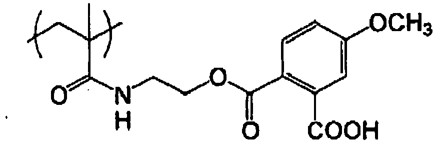

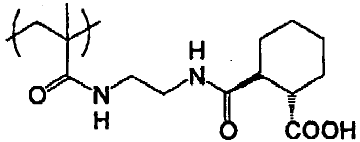

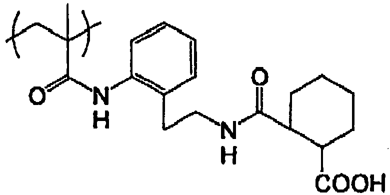

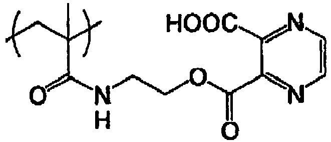

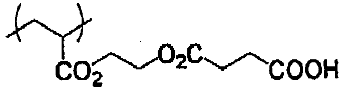

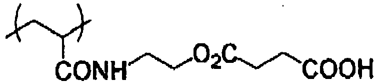

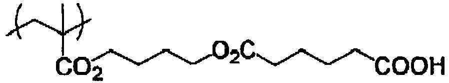

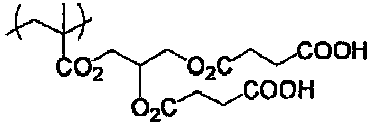

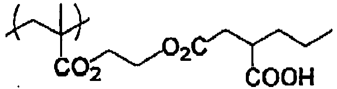

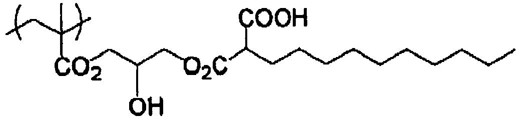

The specific (meth)acrylic resin used in the invention is preferably a copolymer composed of the repeating unit represented by the formula (i), the repeating unit having a crosslinking group in its side chain and, if desired, other copolymerizable component. The repeating unit represented by the formula (i) may be contained singly, or two or more kinds thereof may be coritained in the specific (meth)acrylic resin. The total content of the repeating unit represented by the formula (i) in the copolymer is properly determined by its structure, the design of the photopolymerizable composition and the like. The repeating unit represented by the formula (i) is contained preferably in an amount ranging from 1 to 99% by mole, more preferably from 5 to 40% by mole, and further preferably from 5 to 20% by mole based on the whole molar amount of the resin components.

Examples of the polymer having an ethylenically unsaturated bond, which is a crosslinking group, in its side chain include polymers which are acrylic or methacrylic ester or amide polymers wherein an ester or amide residue (R in -COOR or -CONHR) has an ethylenically unsaturated bond.

Examples of the residue having an ethylenically unsaturated bond (R as described above) include -(CH₂)ₙCR¹=CR²R³, -(CH₂O)ₙCH₂CR¹=CR²R³, -(CH₂CHO)CH₂CR¹=CR²R³, -(CH₂)ₙNH-CO-O-CH₂CR¹=CR²R³, -(CH₂)ₙ-O-CO-CR¹=CR²R³ and -(CH₂CH₂O)₂-X (wherein R¹ to R³ represent each a hydrogen atom, a halogen atom or an alkyl group, an aryl group, an alkoxy group or an aryloxy group having from 1 to 20 carbon atoms; R¹ and R² or R³ may be bonded together to form a ring; n represents an integer of from 1 to 10; and X represents a dicyclopentadienyl residue).

Specific examples of the ester residue include -CH₂CH=CH₂ (described in JP-B-7-21633), -CH₂CH₂O-CH₂CH=CH₂, -CH₂C(CH₃)=CH₂, -CH₂CH=CH-C₆H₅, -CH₂CH₂OCOCH=CH-C₆H₅, -CH₂CH₂-NHCOO-CH₂CH=CH₂ and -CH₂CH₂O-X (wherein X represents a dicyclopentadienyl residue).

Specific examples of the amide group include -CH₂CH=CH₂, -CH₂CH₂-Y (wherein Y represents a cyclohexene residue) and -CH₂CH₂-OCO-CH=CH₂.

The binder polymer having a crosslinking group cures as follows. For example, a free radical (a polymerization initiator radical or a radical growing in the course of the polymerization of a polymerizable compound) is added to the crosslinking functional group and thus addition polymerization arises either directly between polymers or mediated by chain polymerization of the polymerizable compound so that a crosslinkage is formed between polymer molecules. Alternatively, an atom (for example, a hydrogen atom on a carbon atom adjacent to the functional crosslinking group) is withdrawn by a free radical to form a polymer radical. Such polymer radicals are bonded together to form a crosslinkage between polymer molecules, thereby causing curing.

The content of the crosslinking group in the binder polymer (the amount of radical-polymerizable unsaturated double bond determined by iodometry) preferably ranges from 0.1 to 10.0 mmol, more preferably from 1.0 to 7.0 mmol and most preferably from 2.0 to 5.5 mmol per gram of the binder polymer. A high sensitivity and a favorable storage stability can be established within this range.

As the other copolymerization component, conventionally known monomers can be used without limitations so far as they are a radical polymerizable monomer. Specifically, there are enumerated monomers as described in Kobunshi Deta Handobukku: Kiso-Hen (edited by The Society of Polymer Science, Japan and published by Baifukan Co., Ltd., 1986). Such copolymerization components may be used singly or in combination of two or more kinds thereof

Though the amount of the crosslinking group-containing polymer binder in the photopolymerizable composition can be properly determined, it is usually in the range of from 10 to 90% by weight, preferably from 20 to 80% by weight, and more preferably from 30 to 70% by weight based on the total weight of non-volatile components in the photopolymerizable composition.

Furthermore, the weight ratio of the photopolymerizable ethylenically unsaturated bond-containing compound to the crosslinking group-containing polymer binder is preferably in the range of from 1/9 to 9/1, more preferably from 2/8 to 8/2, and further preferably from 3/7 to 7/3.

As the binder, one or more kinds of other resins may be used jointly with the crosslinking group-containing polymer binder.

The resin to be used jointly is used generally in an amount of not more than 50 % by weight, and preferably not more than 30 % by weight based on the weight of the crosslinking group-containing polymer binder.

The molecular weight of the polymer binder used in the invention is properly determined from the viewpoints of image forming properties and printing resistance. The molecular weight is preferably in the range of from 2,000 to 1,000,000, more preferably from 5,000 to 500,000, and further preferably from 10,000 to 200,000.

The polymer binder which is used in the invention may be used singly or in combination of two or more kinds thereof. In addition, the polymer binder may be used jointly with one or more kinds of other crosslinking group-free binder polymer as a mixture. As the binder polymer which can be used jointly, conventionally known alkali-soluble or swelling binders can be used without limitations. Specifically, for example, acrylic-main chain binders and urethane binders which are frequently used in the art are preferably used.

While the total amount of the polymer binder and the binder polymer which may be used jointly in the photosensitive layer can be properly determined, it is usually in the range of from 10 to 90% by weight, preferably from 20 to 80% by weight, and more preferably from 30 to 70% by weight based on the total weight of non-volatile components in the photosensitive layer.

### [Polymerization initiations system]

As the polymerization initiation system to be contained in the photosensitive layer used in the invention, either a photopolymerization initiation system (a photon mode initiation system) or a heat mode initiation system can be used.

### (photopolymerization initiation system)

As the photopolymerization initiation system (initiator) to be contained in the photosensitive layer used in the invention, use can be made of an appropriate one selected from among various publicly known photopolymerization initiators reported in patents and documents or a system comprising a combination of two or more photopolymerization initiators (a photopolymerization initiator system) depending on the wavelength of a light source to be employed.

In the case of using visible rays of 400 nm or above, Ar laser, the second higher harmonic wave of semiconductor laser or SHG-YAG laser as a light source, there have been proposed various photopolymerization initiation systems, for example, a specific photoreductive dye such as rose bengal, eosin or erythrosine or a system comprising a combination of dye with an initiator described in USP 2,850,445, a composite initiation system comprising, for example, a dye with an amine (JP-B-44-20189), a system comprising a combination of hexaarylbiimidazole, a radical generator and a dye (JP-B-45-37377), a system comprising hexaarylbiimidazole and p-dialkylaminobenzylidene ketone (JP-B-47-2528 and JP-A-54-155292), a system comprising a cyclic cys-α-dicarbonyl compound and a dye (JP-A-48-84183), a system comprising cyclic triazine and a merocyanine colorant (JP-A-54-151024), a system comprising 3-ketocoumarin and an active agent (JP-A-52-112681 and JP-A-58-15503), a system comprising biimidazole, a styrene derivative and thiol (JP-A-59-140203), a system comprising an organic peroxide with a colorant (JP-A-59-1504, JP-A-59-140203, JP-A-59-189344, JP-A-62-174203, JP-B-62-1641 and USP 4,766,055), a system comprising a dye and an active halogen compound (JP-A-63-258903, JP-A-2-63054, etc.), a system comprising a dye and a borate compound (JP-A-62-143044, JP-A-150242, JP-A-64-13140, JP-A-64-13141, JP-A-64-13142, JP-A-64-13143, JP-A-64-13144, JP-A-64-17048, JP-A-1-229003, JP-A-1-298348, JP-A-1-138204, etc.), a system comprising a colorant having rhodanine ring and a radical generator (JP-A-2-179643 and JP-A-2-244050), a system comprising titanocene and a 3-ketocoumarin colorant (JP-A-63-221110), a system comprising a combination of titanocene with a xanthene colorant and an addition-polymerizable and ethylenically unsaturated compound having amino group or urethane group (JP-A-4-221958 and JP-A-4-219756), a system comprising titanocene and a specific merocyanine colorant (JP-A-6-295061), a system comprising titanocene and a colorant having benzopyran ring (JP-A-8-334897) and so on.

In recent years, lasers of 400 to 410 nm (violet lasers) have been developed and photopolymerization initiation systems showing a high sensitivity, i.e., being sensitive to wavelength of 450 nm or less, have been also developed. Use can be made of these photopolymerization systems too. Examples thereof include a cationic colorant/a borate system (JP-A-11-84647), a merocyanine colorant/titanocene system (JP-A-2000-147763), a carbazole colorant/titanocene system (JP-A-2001-42524) and so on. It is particularly preferable in the invention to employ a titanocene compound and a hexarylbiimidazole compound.

As a titanocene compound, various ones can be used. For example, it may be appropriately selected from among various titanocene compounds described in JP-A-59-152396 and JP-A-61-151197. More specifically speaking, there can be enumerated di-cyclopentadienyl-Ti-dichloride, di-cyclopentadienyl-Ti-bis-phenyl, di-cyclopentadienyl-Ti-bis-2,3,4,5,6-pentafluorophen-1-yl di-cyclopentadienyl-Ti-bis-2,3,5,6-tetrafluorpphen-1-yl, di-cyclopentadienyl-Ti-bis-2,4,6-tritluorophen-1-yl, di-cyclopentadienyl-Ti-bis-2,6-difluorophen-1-yl, di-cyclopentadienyl-Ti-bis-2,4-difluorophen-1-yl, di-methylcyclopentadienyl-Ti-bis-2,3,4,5,6-pentafluorophen-1-yl, di-methylcyclopentadienyl-Ti-bis-2,6-difluorophen-1-yl and bis(cyclopentadienyl)-bis(2,6-difluoro-3-(pyr-1 yl)phenyl)titanium.

As the hexaaryl biimidazole, a variety of compounds can be used. Examples thereof include lophine dimers as described in JP-B-45-37377 and JP-B-44-86516, for example, 2,2'-bis(o-chilorophenyl)-4,4',5,5'-tetraphenyl biimidazole, 2,2'-bis-(o-bromophenyl)-4,4',5,5'-tetraphenyl biimidazole, 2.2'-bis(o,p-dichlorophenyl)-4,4',5,5'-tetraphenyl biimidazole, 2,2'-bis(o-chlorophenyl)-4,4',5,5'-tetra(m-methoxyphenyl) biimidazole, 2,2'-bis(o,o'-dichlorophenyl)-4,4',5,5'-tetraphenyl biimidazole, 2,2'-bis(o-nitrophenyl)-4,4',5,5'-tetraphenyl biimidazole, 2,2'-bis(o-methylphenyl)-4,4',5,5'-tetraphenyl biimidazole, 2,2'-bis(o-trifluorophenyl)-4,4',5,5'-tetraphenyl biimidazole, 2,2'-bis-(o,m-dichlorophenyl)-4,4',5,5'-tetraphenyl biimidazole and 2,2'-bis-(o-chlorophenyl)-4,4',5,5'-tetra(p-bromophenyl) biimidazole.

Among all, 2,2'-bis(o-chlorophenyl)-4,4',5,5'-tetraphenyl biimidazole, 2,2'-bis(o,m-dichlorophenyl)-4,4',5,5'-tetraphenyl biimidazole and 2,2'-bis-(o-chlorophenyl)-4,4',5,5'-tetra(p-bromophenyl) biimidazole are preferred.

In addition, it is possible that the photopolymerization initiation system further contains a publicly known compound which is known as being capable of enhancing the photoinitiation ability when used together with a photopolymerization initiator, for example, a chain transfer agent and a sensitizer aid. Examples thereof include a hydrogen donating compound such as thiol compounds (for example, 2-mercaptobenzthiazole, 2-mercaptobenzimidazole and 2-mercaptobenzoxazole) and amine compounds (for example, N-phenylglycine and N,N-dialkylamino aromatic alkyl esters).

The photopolymerization initiation system (initiator) may be used in an amount of from 0.05 to 100 parts by weight, preferably from 0.1 to 70 parts by weight and more preferably from 0.2 to 50 parts by weight per 100 parts by weight of the ethylenically unsaturated compound as will be described hereinafter.

### (Heat mode initiation system)

A heat mode polymerization system is also applicable to the photosensitive lithographic printing plate of the invention. In the heat mode polymerization system, an infrared absorbing agent is combined with a polymerization initiator as a substitute for the photopolymerization initiation system as described above. If desired, a hydrogen donating agent and a chain transfer, which are the same as those cited above with respect to the photopolymerization initiation system, may be used to promote the polymerization.

### (1) Infrared absorbing agent

It is essentially required that the photosensitive composition of the invention contains an infrared absorbing agent. The infrared absorbing agent has a function of absorbing infrared rays and then converting them into heat. Owing to the heat thus generated, a polymerization initiator (a radical generator) as will be described hereinafter thermally decomposes and generates radicals. The infrared absorbing agent to be used in the invention is a dye or a pigment having an absorption peak at a wavelength of from 760 to 1,200 nm.

As the dye, use can be made of commercially available dyes and publicly known ones described in documents, for example, Senryo Binran (ed. by The Society of Synthetic Organic Chemistry, Japan, 1970), etc. Specific examples thereof include azo dyes, metal complex salt azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrilium salts, metal thiolate complexes and so on.

Examples of preferable dyes include cyanine dyes described in JP-A-58-125246, JP-A-59-84356, JP-A-60-78787, etc., methine dyes described in JP-A-58-173696, JP-A-58-181690, JP-A-58-194595, etc., naphthoquinone dyes described in JP-A-58-112793, JP-A-58-224793, JP-A-59-48187, JP-A-59-73996, JP-A-60-52940, JP-A-60-63744, etc., squarylium colorants described in JP-A-58-112792, etc., cyanine dyes described in British Patent 434,875, and so on.

Further, it is appropriate to use a near infrared absorbing sensitizer described in US Patent 5,156,938. Furthermore, use can be preferably made of substituted arylbenzo(thio)pyrilium salts described in US Patent 3,881,924, trimethine thiapyrilium salts described in JP-A-57-142645 (US Patent 4,327,169), pyrilium compounds described in JP-A-58-181051, JP-A-58-220143, JP-A-59-41363, JP-A-59-84248, JP-A-59-84249, JP-A-59-146063 and JP-A-59-146061, cyanine colorants described in JP-A-59-216146, pentamethine thiopyrilium salts described in US Patent 4,283,475 and pyrilium compounds described in JP-B-5-13514 and JP-B-5-19702. As preferable examples of the dye, it is also possible to cite near infrared absorbing dyes represented by formulae (I) and (II) in US Patent 4,756,993.

As other preferable examples of the infrared absorbing colorant usable in the invention, specific indolenine cyanine colorants described in JP-A-2002-278057 may be cited.

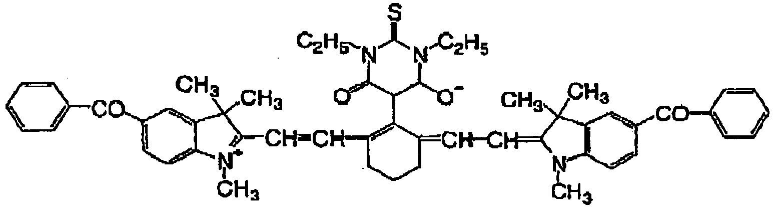

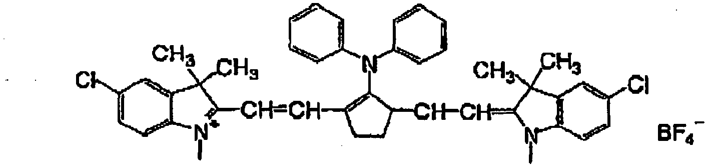

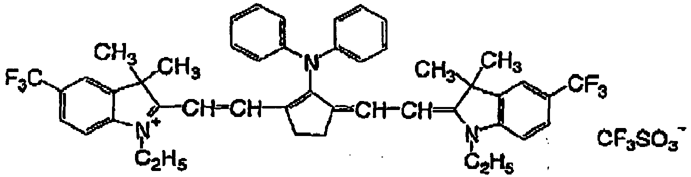

Among these dyes, particularly preferable examples include cyanine colorants, squarylium colorants, pyrilium salts, nickel thiolate complexes and indolenine cyanine colorants, and cyanine colorants and indolenine cyanine colorants are still preferable. Cyanine colorants represented by the following formula (a) can be cited as particularly preferable examples.

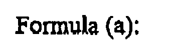

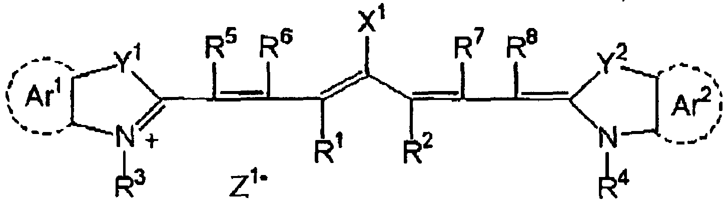

In the formula (a), X¹ represents a hydrogen atom, a halogen atom, -NPh₂, X²-L¹ or a group as will be described hereinafter. X² represents an oxygen atom, a nitrogen atom or a sulfur atom, while L¹ represents a hydrocarbon group having 1 to 12 carbon atoms, an aromatic ring having a hetero atom or a hydrocarbon group containing a hetero atom and having 1 to 12 carbon atoms. The term hetero atom as used herein means, N, S, O, a halogen atom or Se. Xa' has the same meaning as Z¹⁻ as will be defined hereinafter, and Ra represents a substituent selected from among a hydrogen atom, an alkyl group, an aryl group, a substituted or unsubstituted amino group and a halogen atom.

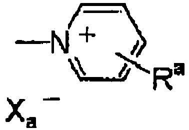

R¹ and R² each independently represents a hydrocarbon group having 1 to 12 carbon atoms. Taking the storage stability of the coating liquid for recording layer into consideration, it is preferable that R¹ and R² are each a hydrocarbon group having 2 or more carbon atoms. It is still preferable that R¹ and R² are bonded to each other to form a 5-membered ring or a 6-memebred ring.

Ar¹ and Ar² may be either the same or different and each represents an optionally substituted aromatic hydrocarbon group. Preferable examples of the aromatic hydrocarbon group include a benzene ring and a naphthalene ring. Preferable examples of the substituent include a hydrocarbon group having 12 or less carbon atoms, a halogen atom and an alkoxy group having 12 or less carbon atoms. Y¹ and Y² may be either the same or different and each represents a sulfur atom or a dialkylmethylene group having 12 or less carbon atoms. R³ and R⁴ may be either the same or different and each represents an optionally substituted hydrocarbon group having 20 or less carbon atoms. Preferable examples of the substituent include an alkoxy group having 12 or less carbon atoms, a carboxyl group and a sulfo group. R⁵, R⁶, R⁷ and R⁸ may be either the same or different and each represents a hydrogen atom or a hydrocarbon group having 12 or less carbon atoms. From the viewpoint of the availability of starting materials, a. hydrogen atom is favorable. Za represents a counter anion. However, Za is unnecessary in the case of a cyanine colorant represented by the formula (a) which has an anionic substituent in its structure and thus requires no neutralization of the charge. From the viewpoint of the storage stability of a coating liquid for recording layer, preferable examples of Za⁻ include a halogen ion, a perchlorate ion, a tetrafluoroborate ion, a hexafluorophosphate ion and a sulfonate ion. In particular, a perchlorate ion, a hexafluorophosphate ion and an arylsulfonate ion are preferable therefor.

Specific examples of the cyanine colorants represented by the formula (a) which are appropriately usable in the invention include those described in paragraphs [0017] to [0019] in JP-A-2001-133969.

As especially preferable examples thereof, there can be enumerated indolenine cyanine compounds described in JP-A-2002-278057 as described above.

As the pigment to be used in the invention, commercially available pigments and pigments described in Color Index (C.I.) Binran, Saishin Ganryo Binran (ed. by Nippon Ganryo Crijutsu Kyokai, 1977), Saishin Ganryo Oyo Gijutsu (CMC Shuppan, 1986) and Insatsu Inki Gijutsu (CMC Shuppan, 1984) may be employed.

Concerning the types of the pigments, use can be made of black pigments, yellow pigments, orange pigments, brown pigments, red pigments, purple pigments, blue pigments, green pigments, fluorescent pigments, metallic powder pigments, and polymer-binding pigments. More specifically speaking, use can be made of insoluble azo pigments, azo lake pigments, condensed azo pigments, chelate azo pigments, phthalocyanine-type pigments, anthraquinone-type pigments, perylene and perynone-type pigments, thioindigo-type pigments, quinacridone-type pigments, dioxazine-type pigments, isoindolinone-type pigments, quinophthaloae-type pigments, underglaze lake pigments, azine pigments, nitroso pigments, nitro pigments, natural pigments, fluorescent pigments, inorganic pigments, carbon black and so on. Among these pigments, carbon black is preferred.

Such a pigment may be used without any surface treatment. Alternatively, it may be surface-treated before using. As the surface-treatment method, a method of coating the surface with a resin or a wax, a method of attaching a surfactant, a method of bonding a reactive substance (for example, a silane coupling agent, an epoxy compound, a polyisocyanate or the like) to the surface of the pigment, etc. may be suggested. These surface-treatment methods are reported by Kinzoku Sekken no Seishitu to Oyo (Saiwai Shobo), Insatsu Inki Gijutsu (CMC Shuppan, 1984) and Saishin Ganryo Oyo Gijutsu (CMC Shuppan, 1986).

The particle diameter of the pigment preferably ranges from 0.01 to 10 µm, still preferably from 0.05 to 1 µm and particularly preferably from 0.1 to 1 µm. It is undesirable, from the viewpoint of the stability of the dispersion in a coating liquid of photosensitive layer, that the particle diameter of the pigment is less than 0.01 µm. On the other hand, it is undesirable from the viewpoint of the uniformity of the photosensitive layer that the particle diameter thereof exceeds 10 µm.

To disperse the pigment, use can be made of a publicly known dispersion technique having been employed in producing inks, toners, etc, Examples of a dispersing machine include an ultrasonic disperser, a sand mill, an attritor, a pearl mill, a super mill, a ball mill, an impeller, a disperser, a KD mill, a colloid mill, a dynatron, a three-roll mill, a pressure kneader and so on. Details are described in Saishin Ganryo Oyo Gijutsu (CMC Shuppan, 1986).

In the case of applying the photosensitive composition used in the invention to a photosensitive lithographic printing plate, the above-described infrared absorbing agent may be added to a single layer together with other components. Alternatively, it is also possible that another layer is formed and the infrared absorbing agent is added thereto. In forming the negative type lithographic printing plate, it is preferable that the infrared absorbing agent is added so that the photosensitive layer has an absorbance determined by the reflection method ranging from 0.5 to 1.2, preferably from 0.6 to 1.5, at the absorption maximum within the wavelength range of from 760 to 1200 nm. In the case where the absorbance does not fall within this range, the strength in the image part is lowered and the printing number is lessened in printing. Although the reason therefor is not clearly understood so far, it is estimated that, in the case where the absorbance is lower than 0.5, the irradiated infrared light cannot be sufficiently absorbed and, in its turn, the radical polymerization cannot fully proceed in the overall photosensitive layer. When the absorbance exceeds 1.2, the outermost face alone of the photosensitive layer absorbs the infrared light while no infrared light reaches around the support. As a result, no radical polymerization arises around the support and, therefore, the adhesion force between the support and the photosensitive layer seemingly becomes insufficient.

The absorbance of the photosensitive layer can be controlled depending on the addition level of the above-described infrared absorbing agent and the thickness of the photosensitive layer. The absorbance can be measured by a conventional method. Examples of the measurement method include a method wherein a photosensitive layer having such a thickness as being appropriately determined within a range so as to give a coating dose after drying required as a lithographic printing plate is formed on a reflective support such as an aluminum support and the optical density thereof is measured with an optical densitometer, and a method of measuring by the reflection method with the use of an integrating sphere by using a spectrophotometer.

### (2) Polymerization initiator

In the heat mode system, use is made of a polymerization initiator the combined use of which with the infrared absorbing agent as described above induces heat generation from the infrared absorbing agent when irradiated with infrared laser to thereby generate radical due to the heat. The polymerization initiator for the heat mode may be selected from among the polymerization initiators described above with respect to the photopolymerization initiation system. An onium salt is preferred therefor and a sulfonium salt polymerization initiator may be cited as particularly suitable one. In the invention, a high-sensitivity heat mode recording can be conducted by combining the infrared absorbing agent with the onium salt polymerization initiator.

As examples of the sulfonium salt polymerization initiator appropriately usable in the invention, there can be enumerated onium salts represented by the following formula (I).

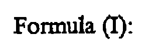

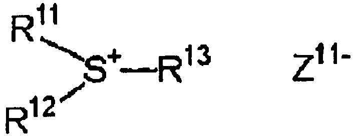

In the formula (I), R¹¹, R¹² and R¹³ may be either the same or different and each represents an optionally substituted hydrocarbon group having not more than 20 carbon atoms. Preferable examples of the substituent include a halogen atom, a nitro group, an alkyl group having not more than 12 carbon atoms, an alkoxy group having not more than 12 carbon atoms and an aryloxy groups having not more than 12 carbon atoms. Z¹¹⁻ represents a counter ion selected from the group consisting of a halogen ion, a perchlorate ion, a tetrafluoroborate ion, a hexafluorophosphate ion, a carboxylate ion and a sulfonate ion. It preferably represents a perchlorate ion, a hexafluorophosphate ion, a carboxylate ion or an arylsulfonate ion.

Next, specific examples of the onium salt represented by the formula (I) the onium salts represented by the formula (C) ([OS-1] to [OS-10]) will be presented, though the invention is not restricted thereto.

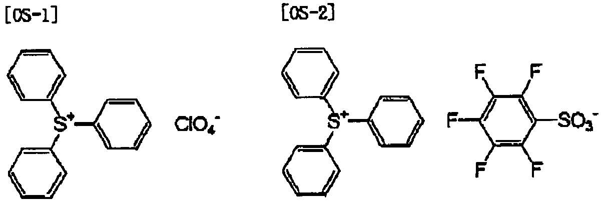

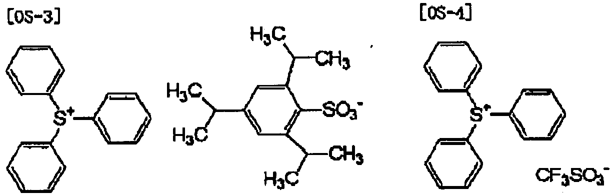

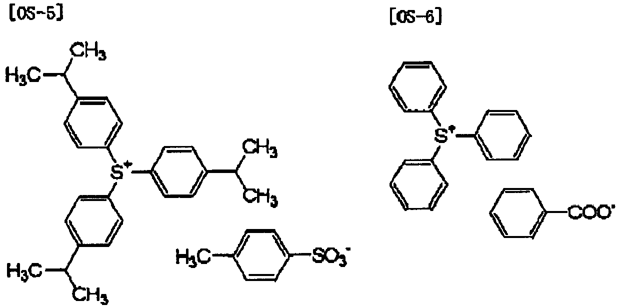

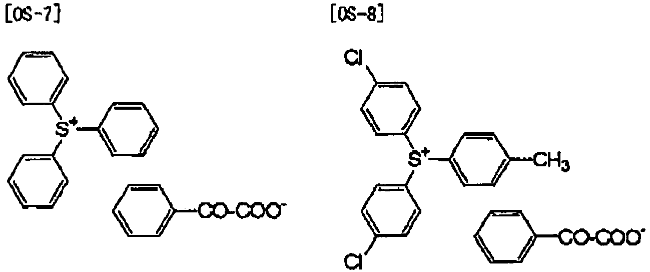

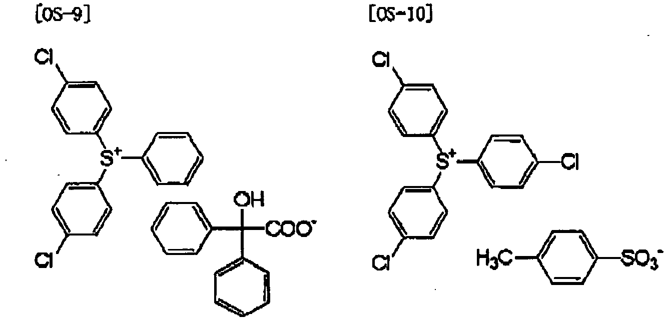

In addition to those cited above, use can be preferably made of specific aromatic sulfonium salts described in JP-A-2002-148790, JP-A-2002-148790, JP-A-2002-350207 and JP-A-2002-6482.

In the invention, it is also appropriate to use onium salts other than the sulfonium salt polymerization initiator as described above.

Examples of such onium salts include an iodonium salt and a diazonium salt. More specifically speaking, there can be enumerated onium salts represented by the following formulae (II) and (III).

Formula (II) Ar²¹-I⁺-Ar²² Z²¹⁻

Formula (III) Ar³¹-N⁺≡N Z³¹⁻

In the formula (II), Ar²¹ and Ar²² each independently represents an optionally substituted aryl group having not more than 12 carbon atoms. In the case where the aryl group is substituted, preferable examples of the substituent include a halogen atom, a nitro group, an alkyl group having not more than 12 carbon atoms, an alkoxy group having not more than 12 carbon atoms or an aryloxy group having not more than 12 carbon atoms. Z²¹⁻ represents a counter ion having the same meaning as Z¹¹⁻.

In the formula (III), Ar³¹ represents an optionally substituted aryl group having not more than 20 carbon atoms. Preferable examples of the substituent include a halogen atom, a nitro group, an alkyl group having not more than 12 carbon atoms, an alkoxy group having not more than 12 carbon atoms, an aryloxy group having not more than 12 carbon atoms, an alkylamino group having not more than 12 carbon atoms, a dialkylamino group having not more than 12 carbon atoms, an arylamino group having not more than 12 carbon atoms or a diarylamino group having not more than 12 carbon atoms. Z³¹⁻ represents a counter ion having the same meaning as Z¹¹⁻.

Next, there will be enumerated particular examples of the onium salt represented by the formula (II) (OI-1] to [OI-10]) and particular examples of the onium salt represented by the formula (III) ([ON-1] to [ON-5]) appropriately usable in the invention, though the invention is not restricted thereto.

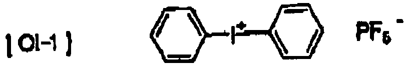

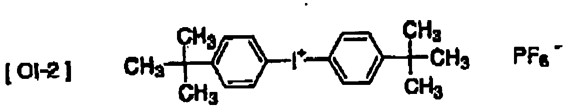

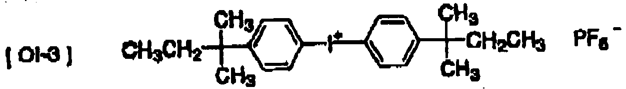

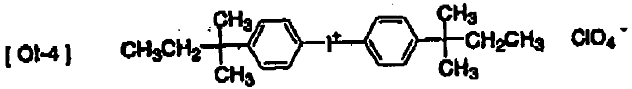

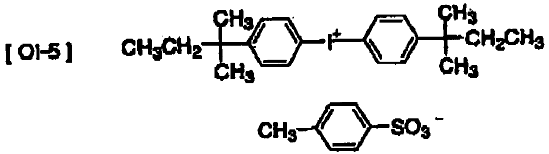

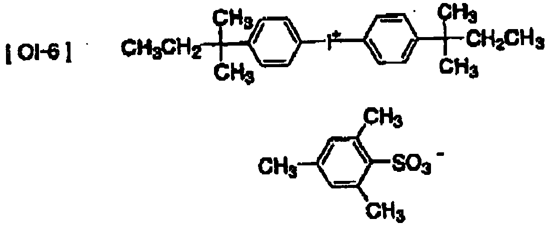

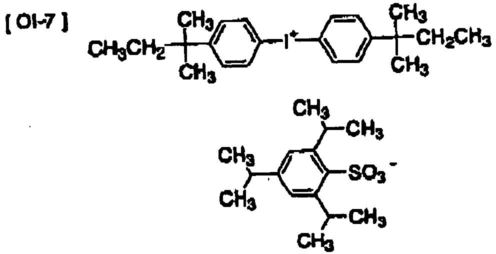

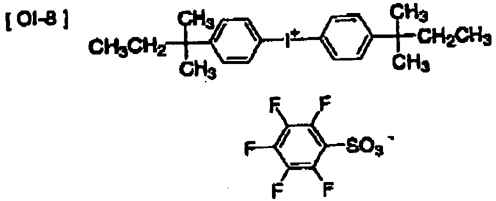

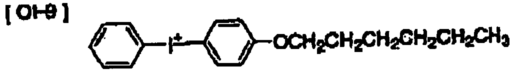

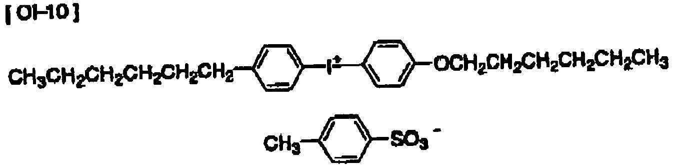

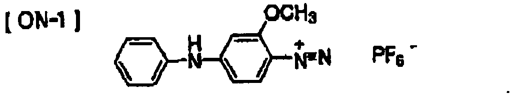

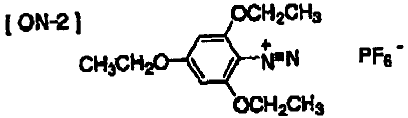

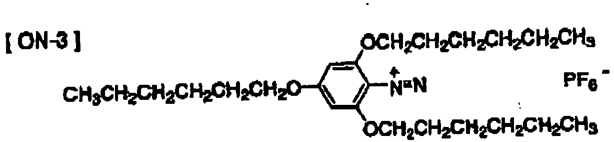

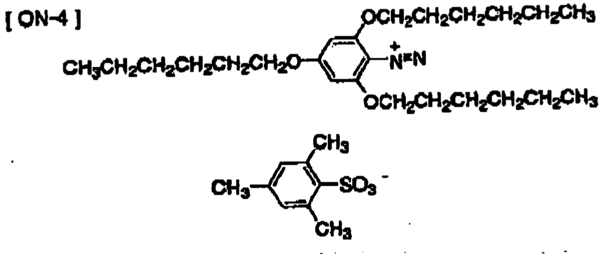

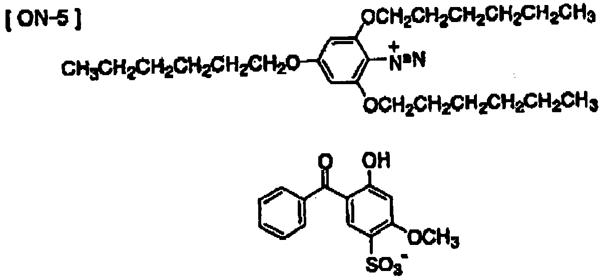

As specific examples of the onium salt appropriately usable as a polymerization initiator in the invention, there can be enumerated those described in JP-A-2001-133969.

It is preferable that the polymerization initiator (radical generator) to be used in the invention has a maximum absorption wavelength of 400 nm or less, still preferably 360 nm or less. By thus controlling the maximum absorption wavelength within the ultraviolet region, the lithographic printing plate can be handled under white light,

The total content of the above polymerization initiators in the photosensitive layer is from 0.1 to 50% by weight, preferably from 0.5 to 30% by weight and still preferably from 1 to 20% by weight, based on the total solid content.

### (Thermal polymerization inhibitor)

In addition to the fundamental components as discussed above, it is preferable in the invention to add a small amount of a thermal polymerization inhibitor to inhibit the unnecessary thermal polymerization of the polymerizable ethylenically unsaturated bond-containing compound during the production or storage of the photopolymerizable composition. Appropriate examples of the thermal polymerization inhibitor include hydroquinone, p-methoxyphenol, di-t-butyl-p-cresol, pyrogallol, t-butyl catechol, benzoquinone, 4,4'-thiobis(3-methyl-6-t-butylphenol), 2,2'-methylenebis(4-methyl-6-t-butylphenol), N-nitrosophenylhydroxyamine primary cerium salt, N-nitrosophenylhydroxyamine aluminum salt and so on.

It is preferable to add the thermal polymerization initiator in an amount of from about 0.01% by weight to about 5% by weight based on the total weight of the solid components constituting the photosensitive layer. If necessary, a higher fatty acid derivative such as behenic acid or behenic acid amide, which is localized on the surface of the photosensitive layer in the course of the drying following the coating, may be added to prevent the inhibition of the polymerization by oxygen. It is preferable that the content of the higher fatty acid derivative ranges from about 0.5% by weight to about 10% by weight based on the solid components constituting the photosensitive layer.

### (Other additives)

To color, the photosensitive layer may further contain a colorant. Specific examples of the colorant include pigments such as phthalocyanine pigments (C.I. Pigments Blue 15:3, 15:4, 15:6, etc.), azo pigments, carbon black and titanium oxide and dyes such as ethyl violet, crystal violet, azo dyes, anthraquinone dyes and cyanine dyes. It is preferable that a dye and a pigment are added in an amount of from about 0.5% by weight to about 5% by weight based on the whole composition. To improve the hardened coating, it is also possible to add an inorganic filler or a plasticizer such as dioctyl phthalate, dimethyl phthalate or tricresyl phosphate. The addition level thereof is preferably 10% by weight or less based on the whole composition.

### [Coating liquid]

In coating the photosensitive layer, the foregoing respective components are dissolved in a solvent to form a coating liquid. Examples of the solvent which is used herein include organic solvents such as acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetyl acetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate-3-methoxypropyl acetate, N,N-dimethylformamide, dimethyl sulfoxide, γ-butyrolactone, methyl lactate, and ethyl lactate. Such a solvent can be used singly or in admixture.

The concentration of solids in the coating liquid is usually from 1 to 50% by weight.

Furthermore, for the purpose of enhancing the coating surface quality, it is possible to add a surfactant.

The coating amount of the photosensitive layer is usually from about 0.1 to about 10 g/m², preferably from 0.3 to 5 g/m², and more preferably from 0.5 to 3 g/m² in terms of weighting after drying.

### <Support>

In the invention, the foregoing photosensitive layer is provided on a support having hydrophilic surface. As the hydrophilic support, conventionally known hydrophilic supports which are useful in lithographic printing plates can be used without limitations. It is preferable that the support to be used is a dimensionally stable plate-like material. Examples of the support include papers, papers laminated with a plastic (for example, polyethylene, polypropylene, and polystyrene), metal plates (for example, aluminum, zinc, and copper), plastic films (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonates, and polyvinyl acetal), and papers or plastic films having the foregoing metal laminated or vapor deposited thereon. If desired, the surface of such a support may be subjected to a proper known physical or chemical treatment for the purposes of imparting hydrophilicity, enhancing the strength, and so on.

In particular, as the preferred support, there are enumerated papers, polyester films, and aluminum plates. Of these, aluminum plates which have good dimensional stability, are relatively cheap and can provide a surface having more excellent hydrophilicity and strength by a surface treatment as the need arises are especially preferable. Furthermore, a composite sheet having an aluminum sheet coupled on a polyethylene terephthalate film as described in JP-B-48-18327 is also preferable.

The aluminum substrate is a dimensionally stable metal plate containing aluminum as the major component and selected from among pure aluminum plates, alloy plates containing aluminum as the major component and a slight amount of foreign elements, and plastic films or papers having aluminum (alloy) laminated or vapor deposited thereon.

In the following description, the foregoing substrate made of aluminum or an aluminum alloy is named generically as an aluminum substrate and used. Examples of the foreign elements in the alloy include silicon, iron, manganese, copper, magnesium, chromium, zinc, bismuth, nickel, and titanium. The content of the foreign elements in the alloy is not more than 10% by weight. In the invention, while a pure aluminum plate is suitable, since it is difficult to produce completely pure aluminum according to the smelting technology, a slight amount of foreign elements may be contained.

With respect to the aluminum plate which is applied in the invention, its composition is not specified, but conventionally known and publicly used raw materials such as JIS A 1050, JIS A 1100, JIS A 3103, and JIS A 3005 can be properly utilized. Furthermore, the thickness of the aluminum substrate which is used in the invention is from about 0.1. mm to 0.6 mm, preferably from 0.15 mm to 0.4 mm, and especially preferably from 0.2 mm to 0.3 mm. This thickness can be properly varied depending upon the size of a printing machine, the size of a printing plate, and the desire of a user. The aluminum substrate may be properly subjected to a substrate surface treatment as described later as the need arises. As a matter of course, the aluminum substrate may not be subjected to a substrate surface treatment.

The aluminum substrate is usually subjected to a surface roughing treatment. Examples of the surface roughing treatment include mechanical surface roughing, chemical etching, and electrolytic graining as disclosed in JP-A-56-28893. In addition, an electrochemical surface roughing method of performing electrochemical surface roughing in a hydrochloric acid or nitric acid electrolytic liquid and a mechanical surface roughing method such as a wire brush graining method of scratching the aluminum surface by a metallic wire, a ball graining method of graining the aluminum surface by an abrasive ball and an abrasive material, and a brush graining method of subjecting the surface to surface roughing by a nylon brush and an abrasive material are employable. The foregoing surface roughing methods can be carried out singly or in combination. Above all, the method which is usually employed is an electrochemical method of performing chemical surface roughing in a hydrochloric acid or nitric acid electrolytic liquid. The quantity of electricity at the time of anode is suitably in the range of from 50 C/dm² to 400 C/dm². More specifically, it is preferable that alternating current and/or direct current electrolysis is carried out in an electrolytic liquid containing from 0.1 to 50% by weight of hydrochloric acid or nitric acid under conditions at a temperature of from 20 to 80 °C for a period of time of from 1 second to 30 minutes in a current density of from 100 C/dm² to 400 C/dm².

The thus surface roughed aluminum substrate may be chemically etched with an acid or an alkali. Examples of an etching agent which is suitably used include sodium hydroxide, sodium carbonate, sodium aluminate, sodium metasilicate, sodium phosphate, potassium hydroxide, and lithium hydroxide. Preferred ranges of the concentration and temperature are from 1 to 50% weight and from 20 to 100°C, respectively. After the etching, for the purpose of removing stains (smuts) remaining on the surface, acid washing is carried out. Examples of the acid to be used include nitric acid, sulfuric acid, phosphoric acid, chromic acid, hydrofluoric acid, and borofluoric acid. In particular, as the method for removing smuts after the electrochemical surface roughing treatment, a method of bringing it into contact with sulfuric acid of from 15 to 65% by weight at a temperature of from 50 to 90°C as described in JP-A-53-12739 and an alkaline etching method as described in JP-B-48-28123 are preferable. So far as after such treatments, the treated surface has a center line average roughness (Ra) of from 0.2 to 0.5 µm, the method and conditions are not particularly limited.

The thus surface roughed aluminum substrate is then subjected to an anodic oxidation treatment to form an oxidized film. For the anodic oxidation treatment, an aqueous solution of sulfuric acid, phosphoric acid, oxalic acid, or boric acid/sodium borate is used singly, or a combination of plural kinds thereof is used as the major component of an electrolytic bath. As a matter of course, the electrolytic liquid may contain components which are usually at least contained in Al alloy plate, electrodes, tap water, ground water, or the like. In addition, a second or third component may be added. Examples of the second or third component as referred to herein include cations such as ions of metals (for example, Na, K, Mg, Li, Ca, Ti, Al, V, Cr, Mn, Fe, Co, Ni, Cu, and Zn) and an ammonium ion; and anions such as nitrate ion, carbonate ion, chlorine ion, phosphate ion, fluorine ion, phosphate ion, titanate ion, silicate ion and borate ion. The second or third component may be contained in a concentration of from approximately 0 to 10,000 ppm. Though the conditions of the anodic oxidation treatment are not particularly limited, the anodic oxidation treatment is carried out by direct current or alternating current electrolysis in a concentration ranging from 30 to 500 g/liter at a treatment temperature ranging from 10 to 70°C in a current density ranging from 0.1 to 40 A/m². The thickness of the formed anodically oxidized film is in the range of from 0.5 to 1.5 µm, and preferably in the range of from 0.5 to 1.0 µm.

In addition, after carrying out these treatments, a treatment of undercoating a water-soluble resin (for example, polyvinyl phosphonic acid, polymers or copolymers having a sulfonic group in the side chain thereof, and polyacrylic acid), a water-soluble metal salt (for example, zinc borate), a yellow dye, an amine salt, etc. is suitable. Moreover, a sol-gel treated substrate which has been subjected to covalent bonding with a functional group capable of causing addition reaction by a radical as disclosed in JP-A-7-159983 is suitably used.

As other preferred examples, there can be enumerated ones in which a waterproof hydrophilic layer is provided as a surface layer on an arbitrary support. Examples of such a surface layer include layers comprising an inorganic pigment and a binder as described in U.S. Patent No. 3,055,295 and JP-A-56-13168, hydrophilic swelling layers as described in JP-A-9-80744, and sol-gel films comprising titanium oxide, polyvinyl alcohol, and a silicic acid as described in JP-T-8-507727. Such a hydrophilic treatment is carried out for the purposes of, in addition to making the surface of the support hydrophilic, preventing harmful reaction of the photopolymerizable composition to be provided thereon and enhancing adhesion of the photosensitive layer.

### <Interlayer>

For the purpose of improving adhesion between the photosensitive layer and the substrate and stainproof properties, the photosensitive lithographic printing plate in the invention may be provided with an interlayer. Specific examples of the such an interlayer include ones as described in JP-B-50-7481, JP-A-54-72104, JP-A-59-101651, JP-A-60-149491, JP-A-60-232998, JP-A-3-56177, JP-A-4-282637, JP-A-5-16558, JP-A-5-246171, JP-A-7-159983, JP-A-7-314937, JP-A-8-202025, JP-A-8-320551, JP-A-9-34104, JP-A-9-236911, JP-A-9-269593, JP-A-10-69092, JP-A-10-115931, JP-A-10-161317, JP-A-10-260536, JP-A-10-282692, JP-A-11-84674, JP-A-11-38635, JP-A-11-38629, JP-A-10-282645, JP-A-10-301262, JP-A-11-24277, JP-A-11-109641, JP-A-10-319600, JP-A-11-327152, JP-A-2000-10292, JP-A-2000-235254, JP-A-2000-352824, JP-A-2001-209170, and so on.

### <Paper board>

It has been a common practice to store, hold or transport photosensitive lithographic printing plates after inserting paper boards between printing plates so as to prevent mechanical impact during storage or relieve undesired impact during transportation and various paper boards are known. In the case of the photosensitive lithographic printing plate' of the invention, it is also preferred to employ paper boards for preventing the protective layer from damages in the course of storage or transportation.

As the paper materials to be used in the paper boards, use can be made of wood pulp, synthetic pulp (polyethylene fiber), natural fibers such as linen, regenerated cellulose and so on.

As the paper boards, low-cost materials are frequently selected so as to suppress the material cost. For example, it is possible to employ papers made of 100% wood pulp, papers made by blending wood pulp with synthetic pulp, such papers having a low-density or high-density polyethylene layer on the surface, etc. In particular, paper materials free from synthetic pulp or polyethylene layer are less expensive and, therefore, paper boards can be produced at a low cost.

As a specific example, there can be enumerated a paper manufactured from a stock prepared by beating bleached craft pulp, diluting the stock to a concentration of 4% by weight, adding 0.1% by weight of a sizing agent and 0.2% by weight of a strengthening agent each based on the stock and then adding aluminum sulfate to give a pH value of 5.0. The weighting thereof is from 20 to 60 g/m², preferably from 25 to 50 g/m² (measured according to the method defined in JIS P8124), while the thickness thereof is from 42 to 80 µm, preferably from 45 to 55 µm and more preferably from 40 to 50 µm (each measured according to the method defined in JIS P8118). Regarding chemical factors, use is preferably made of a paper board from which no NH₃ gas is detected by a NH₃ gas detection method which comprises cutting 20 g of a sample into small pieces, putting the pieces into 100 g of purified water, heating at 110°C for 10 minutes in a sealed state and then measuring NH₃ gas by using a KTTAGAWA's gas detecting tube (for 20 ppm), and which shows no clouding in a chloride detection method comprising putting 3 ml of a paper board material into 6 ml of distilled water, adding two drops of a 1% by weight silver nitrate solution thereto and observing the presence/absence of clouding. In the paper board specification as discussed above, those having a weighting of from 30 to 60 g/m², a smoothness measured by Bekk smoothness measurement method as specified in JIS 8119 of from 10 to 100 sec, a moisture content measured by the moisture content measurement method as specified in JIS 8127 of from 4 to 8% by weight and a density of from 0.7 to 0.9 g/cm³ are particularly preferred.

In the invention, use can be made of a paper board appropriately selected from these publicly known ones.

### <Plate-making process>

Next, a plate-making process of the photosensitive lithographic printing plate of the invention will be hereunder described in detail. After image exposure, the foregoing photosensitive lithographic printing plate is developed with an alkaline aqueous solution. The developing solution which is used in the plate-making process used in the invention will be described below.

### [Developing solution]

Though the developing solution to be used in the plate-making process of the photosensitive lithographic printing plate of the invention is not particularly limited, for example, a developing solution containing an inorganic alkaline salt and a nonionic surfactant and usually having a pH of from 11.0 to 12.5 is suitably used.

The inorganic alkaline salt can be properly used. Examples thereof include inorganic alkaline agents such as sodium hydroxide, potassium hydroxide, ammonium hydroxide, lithium hydroxide, sodium silicate, potassium silicate, ammonium silicate, lithium silicate, sodium triphosphate, potassium triphosphate, ammonium triphosphate, sodium carbonate, potassium carbonate, ammonium carbonate, sodium hydrogencarbonate, potassium hydrogencarbonate, ammonium hydrogenearbonate, sodium borate, potassium borate, and ammonium borate. These inorganic alkaline agents may be used singly or in combination of two or more kinds thereof.

In the case where a silicate is used, it is possible to easily adjust developability by regulating a mixing ratio and a concentration of silicon oxide SiO₂ as a component of the silicate and an alkaline oxide M₂O (wherein M represents an alkali metal or an ammonium group). Among the foregoing alkaline aqueous solutions, ones having a mixing ratio of the foregoing silicon oxide SiO₂ and the alkaline oxide M₂O (a molar ratio of SiO₂/M₂O) of from 0.5 to 3.0 are preferable, and ones having the subject mixing ratio of from 1.0 to 2.0 are more preferable. The amount of addition of the foregoing SiO₂/M₂O mixture is preferably from 1 to 10% by weight, more preferably from 3 to 8% by weight, and most preferably from 4 to 7% by weight based on the weight of the alkaline aqueous solution. When this concentration falls within the foregoing range, the developability and treatment ability are not lowered, the generation of precipitation or the formation of a crystal does not occur, and gelation does not occur during neutralization at the time of discharging a waste liquid so that the treatment of waste liquid is not impaired.

Furthermore, for the purposes of finely regulating the alkaline concentration and assisting the solubility of the photosensitive layer, an organic alkaline agent may be auxiliarily used jointly. Examples of the organic alkaline agent which can be used jointly include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide. These alkaline agents are used singly or in combination of two or more kinds thereof.

The surfactant can be properly used. Examples thereof include nonionic surfactants such as polyoxyalkylene ether group-containing nonionic surfactants, polyoxyethylene alkyl esters (for example, polyoxyethylene stearate), sorbitan alkyl esters (for example, sorbitan monolaurate, sorbitan monostearate, sorbitan distearate, sorbitan monooleate, sorbitan sesquioleate, and sorbitan trioleate), and monoglyceride alkyl esters (for example, glycerol monostearate and glycerol monooleate); anionic surfactants such as alkylbenzenesulfonic acid salts (for example, sodium dodecylbenzenesulfonate), alkylnaphthalenesulfonic acid salts (for example, sodium butylnaphthalenesulfonate, sodium pentylnaphthalenesulfonate, sodium hexylnaphthalenesulfonate, and sodium octylnaphthalenesulfonate), alkylsulfuric acid salts (for example, sodium laurylsulfate), alkylsulfonic acid salts (for example, sodium dodecylsulfonate), and sulfosuccinic acid ester salts (for example, sodium dilaurylsulfosuccinate); and ampholytic surfactants such as alkyl betaines (for example, lauryl betaine and stearyl betaine) and amino acids. Of these, polyoxyalkylene ether group-containing nonionic surfactants are especially preferable.

As the polyoxyalkylene ether group-containing surfactant, ones having a structure represented by the following formula (IV) are suitably fused.

R⁴⁰-O-(R⁴¹-O)ₚH (IV)

In the foregoing formula (IV), R⁴⁰ represents an alkyl group having from 3 to 15 carbon atoms, an aromatic hydrocarbon group having from 6 to 15 carbon atoms, or a heteroaromatic ring group having from 4 to 15 carbon atoms (incidentally, examples of the substituent include an alkylene group having from 1 to 20 carbon atoms, a halogen atom (for example, Br, Cl, and I), an aromatic hydrocarbon group having from 6 to 15 carbon atoms, an aralkyl group having from 7 to 17 carbon atoms, an alkoxy group having from 1 to 20 carbon atoms, an alkoxycarbonyl group having from 2 to 20 carbon atoms, and an acyl group having from 2 to 15 carbon atoms); R⁴¹ represents an alkylene group having from 1 to 100 carbon atoms; and p represents an integer of from 1 to 100. Incidentally, these respective groups may contain a substituent, and examples of the substituent include an alkyl group having from 1 to 20 carbon atoms and an aromatic hydrocarbon group having from 6 to 15 carbon atoms.

In the definition of the foregoing formula (IV), specific examples of the "aromatic hydrocarbon group" include a phenyl group, a tolyl group, a naphthyl group, an anthryl group, a biphenyl group, and a phenanthryl group; and specific examples of the "heteroaromatic ring group" include a furyl group, a thienyl group, an oxazolyl group, an imidazolyl group, a pyranyl group, a pyridinyl group, an acridinyl group, a benzofuranyl group, a benzothienyl group, a benzopyranyl group, a benzoxazolyl group, and a beozimidazolyl group.

Furthermore, the (R⁴¹-O)ₚ moiety of the formula (IV) may be a combination of two or three kinds of groups so far as it falls within the foregoing range. Specifically, there are enumerated random or block-like forms of a combination, for example, a combination of an ethyleneoxy group and a propyleneoxy group, a combination of an ethyleneoxy group and an isopropyloxy group, a combination of an ethyleneoxy group and a butyleneoxy group, and a combination of an ethyleneoxy group and an isobutylene group. In the invention, the polyoxyalkylene ether group-containing surfactant is used singly or in a composite system. It is effective to add the polyoxyalkylene ether group-containing surfactant in an amount of from 1 to 30% by weight, and preferably from 2 to 20% by weight in the developing solution. When the addition amount is too low, the developability may be possibly lowered, while it is too high, damage of the development is so strong that printing resistance of a printing plate may be possibly lowered.

Furthermore, examples of the polyoxyalkylene ether group-containing nonionic surfactant represented by the foregoing formula (IV) include polyoxyethylene alkyl ethers (for example, polyoxyethylene lauryl ether, polyoxyethylene cetyl ether, and polyoxyethylene stearyl ether), polyoxyethylene aryl ethers (for example, polyoxyethylene phenyl ether and polyoxyethylene naphthyl ether), and polyoxyethylene alkylaryl ethers (for example, polyoxyethylene methylphenyl ether, polyoxyethylene octylphenyl ether, and polyoxyethylene nonylphenyl ether).

Such a surfactant can be used singly or in combination. Furthermore, the content of such a surfactant in the developing solution is suitably in the range of from 0.1 to 20% by weight in terms of an active ingredient.

The pH of the developing solution which is used in the plate-making process used in the invention is usually from 11.0 to 12.7, and preferably from 11.5 to 12.5 in view of the image formation and development damage in the exposed area.

Furthermore, it is preferable that the developing solution which is used in the invention has a conductivity of from 3 to 30 mS/cm. When the conductivity is lower than the foregoing range, in general, elution of the photopolymerizable composition on the surface of the aluminum plate support becomes difficult, thereby causing staining during printing. On the other hand, when the conductivity exceeds the foregoing range, since the salt concentration is high, an elution rate of the photosensitive layer becomes extremely low so that a residual film may be possibly generated in an unexposed area. The conductivity is especially preferably in the range of from 5 to 20 mS/cm.

### [Exposure and development treatment]

By image exposing the photosensitive lithographic printing plate in the invention by conventionally known active rays such as a carbon arc lamp, a high pressure mercury vapor lamp, a xenon lamp, a metal halide lamp, a fluorescent lamp, a tungsten lamp, a halogen lamp, a helium-cadmium laser, an argon ion laser, an FD-YAG laser, a helium-neon laser, a semiconductor laser (from 350 nm to 600 nm) or a solid or semiconductor laser emitting infrared light (700 to 1200 nm) and then developing it, it is possible to form an image on the surface of the aluminum plate support.

For the purpose of enhancing a rate of curing of the photosensitive layer, a heating process to be carried out at a temperature of from 50°C to 140°C for a period of time of from 1 second to 5 minutes may be provided and carried out after the image exposure but before the development. When the heating temperature falls within the foregoing range, an effect of increasing the rate of curing is established, and a residual film due to dark polymerization in an unexposed area is not generated.

Furthermore, as described previously, the protective layer is provided on the photosensitive layer of the photosensitive lithographic printing plate in the invention. There is known a method for achieving the removal of the protective layer and the removal of the unexposed area of the photosensitive layer at the same time by using a developing solution, or a method for removing the protective layer with water or warm water and then removing the photosensitive layer in the unexposed area with a developing solution. An antiseptic, etc. as described in JP-A-10-10754 or an organic solvent, etc. as described in JP-A-8-278636 can be contained in such water or warm water.

The development of the photosensitive lithographic printing plate in the invention with the foregoing developing solution is carried out according to a usual method at a temperature of from about 0 to 60°C, and preferably from about 15 to 40°C by, for example, dipping the exposed photosensitive lithographic printing plate in the developing solution and rubbing it by a brush or other means.

In addition, in the case where the development treatment is carried out by using an automatic processor, since the developing solution fatigues corresponding to the amount of treatment, treatment ability may be recovered by using a replenisher or a fresh developing solution. The thus developed photosensitive lithographic printing plate is subjected to post treatments with washing water, a rinse liquid containing a surfactant, etc., and a desensitizing liquid containing gum arabic, a starch derivative, etc. as described in JP-A-54-8002, JP-A-55-115045, JP-A-59-58431, and the like. In the invention, for the post treatments of the photosensitive lithographic printing plate, a combination of a variety of these treatments can be employed.

In the printing plate as obtained by the foregoing treatments, its printing resistance can be enhanced by a post exposure treatment or a heating treatment such as burning as described in JP-A-2000-89478.

The lithographic printing plate as obtained by these treatments is set in an offset printing machine and provided for printing of a number of sheets.

### EXAMPLES

The invention will be hereunder described in detail with reference to the following Examples, but as a matter of course, it should not be construed that the invention is limited thereto.

### [Examples 1 to 8 and Comparative Example 1]

### (Preparation of aluminum support)

An aluminum plate having a thickness of 0.3 mm was etched by dipping in a 10% by weight aqueous solution of sodium hydroxide at 60°C for 25 seconds, washed with running water, neutralized and washed with a 20% by weight aqueous solution of nitric acid, and then washed with water.

This aluminum plate was subjected to an electrolytic surface roughing treatment in a quantity of electricity at the time of anode of 300 coulombs/dm² in a 1% by weight aqueous solution of nitric acid using an alternating waveform current of sine wave. Subsequently, the resulting aluminum plate was dipped in a 1% by weight aqueous solution of sodium hydroxide at 40°C for 5 seconds; dipped in a 30% by weight aqueous solution of sulfuric acid; subjected to a desmutting treatment at 60°C for 40 seconds; and then subjected to an anodic oxidation treatment in a 20% by weight aqueous solution of sulfuric acid for 2 minutes in a current density of 2 A/dm² such that the anodically oxidized film had a thickness of 2.7 g/m². A surface roughness thereof was measured and found to be 0.3 µm (in terms of an Ra expression according to JIS B0601).

### (Formation of interlayer)

On the thus treated aluminum plate, the following interlayer liquid was first coated using a bar coater and then dried at 80°C for 20 seconds. A coating weight of the interlayer after drying was 10 mg/m².

### Interlayer liquid

- Sol liquid as described below: 100 g
- Methanol: 900 g Sol liquid
- PHOSMER PE (manufactured by Uni-Chemical Co., Ltd.): 5 g
- Methanol: 45 g
- Water: 10 g
- 85% by weight phosphoric acid: 5 g
- Tetraethoxysilane: 20 g
- 3-Methacryloxypropyltrimethoxysilane: 15 g

### (Formation of photosensitive layer)

A highly sensitive photopolymerizable composition P-1 having the following composition was coated on this interlayer in a dry coating weight of 1.4 g/m² and dried at 100°C for one minute to form a photosensitive layer.

### Photopolymerizable composition P-1

| | |
|---|---|
| Ethylenically unsaturated bond-containing compound (A1): | 4.2 parts by weight |
| Linear organic high molecular polymer (polymer binder) (B1): | 3,6 parts by weight |
| Sensitizer (C1): | 0.21 parts by weight |
| Photopolymerization initiator (D1): | 0.81 parts by weight |
| Chain transfer agent (E1): | 0.3 parts by weight |
| ε-Phthalocyanine dispersion: | 0.76 parts by weight |
| Fluorine based nonionic surfactant, MEGAFAC F780 (manufactured by Dainippon Ink and Chemicals, Incorporated) | 0.05 parts by weight |
| Methyl ethyl ketone: | 58 parts by weight |
| Propylene glycol monomethyl ether acetate: | 53 parts by weight |

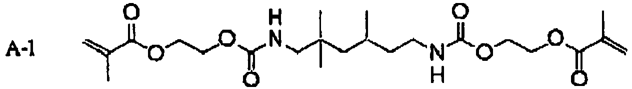

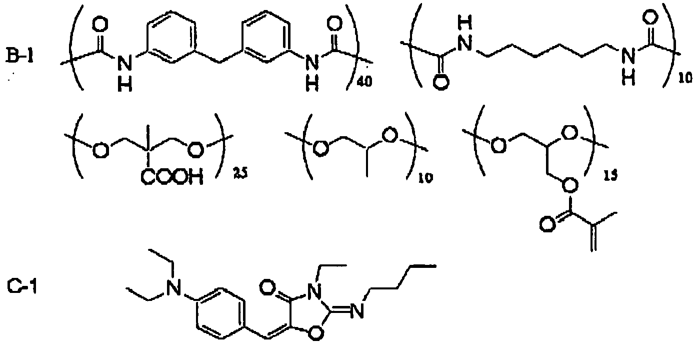

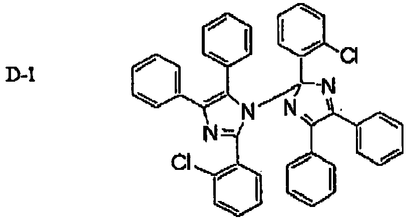

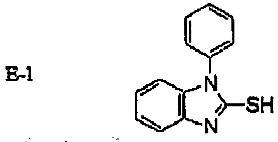

### (Formation of protective layer)

A composition as described in Table 1 was coated on this photosensitive layer and dried to form a protective layer, thereby giving a negative photosensitive lithographic printing plate. The drying was conducted at 120°C for one minute and the a dry coating weight of the protective layer was 2.35 g/m².

**Table 1: Composition of protective layer (expressed in g)**

| Component | | Protective layer 1 | Protective layer 2 | Protective layer 3 | Protective layer 4 | Protective layer 5 | Protective layer 6 | Protective layer 7 | Protective layer 8 | Comparative protective layer 1 |
|---|---|---|---|---|---|---|---|---|---|---|
| PVA | PVA105 | 80 | 67 | 52 | 63 | 61 | 61 | 61 | 61 | 92 |
| Poly(melh)acrylic ester | F-1 | 12 | 25 | 40 | 25 | 25 | 0 | 0 | 0 | 0 |
| | F-4 | 0 | 0 | 0 | 0 | 0 | 25 | 0 | 0 | 0 |
| | F-6 | 0 | 0 | 0 | 0 | 0 | 0 | 25 | 0 | 0 |
| | F-8 | 0 | 0 | 0 | 0 | 0 | 0 | 0 | 25 | 0 |
| Polymer added | PVPK30 | 3.5 | 3.5 | 3.5 | 0 | 0 | 0 | 0 | 0 | 3.5 |
| | Luvitec VA64W | 2.5 | 2.5 | 2.5 | 0 | 0 | 0 | 0 | 0 | 2.5 |
| Surfactant | SURFLON S-112 | 0 | 0 | 0 | 2 | 2 | 2 | 2 | 2 | 0 |
| | EMALEX 710 | 2 | 2 | 2 | 2 | 2 | 2 | 2 | 2 | 2 |
| Solvent | water | 1600 | 1600 | 1600 | 1600 | 1600 | 1600 | 1600 | 1600 | 1600 |

| | | | | | | | | | | |
|---|---|---|---|---|---|---|---|---|---|---|
| PVA-105: manufactured by Kuraray, (degree of saponification 98% by mol, degree of polymerization 500). PVPK30: manufactured by Wako Pure Chemical Industries, Ltd. polyvinylpyrrolidone. Luvitec VA64W: (vinylpyrrolidone-vinyl acetate copolymer, manufactured by ICP). EMALEX 710: manufactured by Nihon Emulsion K.K, surfactant. SURFLON S-112: manufactured by Asahi Glass Co., Ltd., perfluoroalkyl phosphoric ester. | | | | | | | | | | |

### [Evaluation]

### (Sensitivity)

The resulting photosensitive lithographic printing plate was imagewise drawn by a plate setter Vx9600CTP (light source wavelength: 405 nm) manufactured by Fuji Photo Film Co., Ltd. while regulating the exposure amount on the photographic material at 0.05 mJ/cm². Thereafter, the photosensitive lithographic printing plate was developed for a development time of 28 seconds by using a PS processor IP850HD manufactured G&J in which an alkaline developing solution having the following composition had been charged while keeping a liquid temperature at 25°C. Then the half tone dot area ratio of the obtained image was measured. The half tone dot area ratio was measured by measuring the half tone dot image on the plate corresponding to the half tone dot area ratio of 50% of the original image by using a Gretag D19C reflection densitometer (manufactured by Gretag Macbeth) while regarding the halftone dot area ratio mode as a cyan mode. Sensitivity was evaluated based on the data. A higher value measured indicates a higher sensitivity. Table 2 shows the evaluation results.

### Composition of alkaline developing solution

| | |
|---|---|
| Potassium hydroxide: | 0.15 g |
| Polyoxyethylene naphthyl ether (n = 13): | 5.0 g |
| CHELEST 400 (chelating agent): | 0.1 g |
| Water: | 94.75 g |

### (Printing resistance)

A lithographic printing plate was obtained by exposing and developing a photosensitive lithographic printing plate as in the evaluation of the sensitivity. Then it was printed with an ink of DIC-GEOS(N) SUMI manufactured by Dainippon Ink and Chemical, Incorporated by using a LITHRONE printing machine manufactured by Komori Corporation. The printing resistance was printed in terms of the number of printed sheets at the point when the density of a solid image was visually observed to begin to fade. Table 2 shows the evaluation results.

### (Storage stability)

The foregoing photosensitive lithographic printing plate and a paper board were sealed with aluminum craft paper and allowed to stand at 60 °C for 3 days (forced lapse of time). Next, the half tone dot area ratio was measured in the same manner as in evaluating the sensitivity. Then the difference in the half tone dot area ratio of the photosensitive lithographic printing plate after the forced lapse of time and that of the photosensitive lithographic printing plate without the forced lapse of time was taken, thereby measuring a half tone dot fluctuation (Δ %) with the forced lapse of time. A smaller absolute value of this numeral indicates the less influence due to the forced lapse of time, namely a higher storage stability. Table 2 shows the results.

As the paper board, use was made of one having a weighting of 50 g/m², a smoothness measured by Bekk smoothness measurement method as specified in JIS 8119 of 70 sec, a moisture content measured by the moisture content measurement method as specified in JIS 8127 of 6% by weight and a density of 0.8 g/cm³ are particularly preferred.

**[Table 2]**

| | Protective layer | Sensitivity (half tone dot are ratio) | Printing resistance (x10⁴ sheets) | Storage stability (Δ%) |
|---|---|---|---|---|
| Ex. 1 | Protective layer 1 | 55 | 14 | 0 |
| Ex. 2 | Protective layer 2 | 54 | 15 | 0 |
| Ex. 3 | Protective layer 3 | 55 | 14 | 0 |
| Ex. 4 | Protective layer 4 | 55 | 14 | 0 |
| Ex. 5 | Protective layer 5 | 54 | 14 | 0 |
| Ex. 6 | Protective layer 6 | 55 | 14 | 0 |
| Ex. 7 | Protective layer 7 | 55 | 16 | 1 |
| Ex. 8 | Protective layer 8 | 55 | 14 | 1 |
| Comp.Ex. 1 | Comparative protective layer 1 | 55 | 16 | 9 |

### [Examples 9 to 1 and Comparative Example 2]

Lithographic printing plates of Examples 9 to 10 and Comparative Example 2 were obtained in the same manner as in Example 1, but substituting the polymer binder B-1 in the photopolymerizable composition P-1 by B-2 as will be described hereinafter and then forming the protective layers listed in Table 3. Then, evaluation was conducted as in Example 1. Table 3 shows the evaluation results.

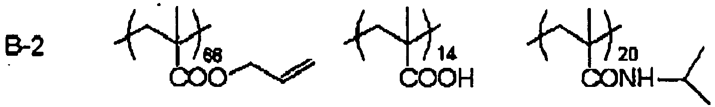

**[Table 3]**

| | Protective layer | Sensitivity (half tone dot are) | Printing resistance (x10⁴ sheets) | Storage stability (Δ%) |
|---|---|---|---|---|
| Ex. 9 | Protective layer 1 | 52 | 14 | 0 |
| Ex. 10 | Protective layer 2 | 52 | 15 | 0 |
| Comp. Ex. 2 | Comparative protective layer 1 | 52 | 15 | 9 |

As Tables 2 and 3 clearly indicate, all of the photosensitive lithographic printing plates of the invention were excellent in sensitivity and printing resistance and showed favorable storage stability, i.e., establishing satisfactory results.

### [Examples 11 to 19 and Comparative Example 3]

As in Example 1, interlayers and photosensitive layers were formed on aluminum supports.

On the photosensitive layers, compositions listed in Table 4 were coated and dried to form protective layers, thereby giving negative photosensitive lithographic printing plates, The drying was conducted at 120°C for 1 minute and the coating amount of the protective layers on the dry basis was 2.35 g/m².

**Table 4: Composition of protective laver**

| Component | | Protective layer 11 | Protective layer 12 | Protective layer 13 | Protective layer 14 | Protective layer 15 | Protective layer 16 | Protective layer 17 | Protective layer 18 | Protective layer 19 | Comparative Protective layer 2 |
|---|---|---|---|---|---|---|---|---|---|---|---|
| PVA | PVA105 | 82 | 68 | 52 | 68 | 68 | 68 | 68 | 68 | 68 | 94 |
| Poly(methacrylic ester | F-1 | 12 | 25 | 40 | 25 | 25 | 25 | | | | |
| | F-4 | | | | | | | 25 | | | |
| | F-6 | | | | | | | | 25 | | |
| | F-8 | | | | | | | | | 25 | |
| Polymer added | Luvitec VA64W | 3.5 | 3.5 | 3.5 | 3.5 | 3.5 | 3.5 | 3.5 | 3.5 | 3.5 | 3.5 |
| Fluorinated surfactant | SURFLON S-111N* | 0.35 | 3 | 9 | | | | 3 | 3 | 3 | |
| | SURFLON S-121* | | | | 3 | | | | | | |
| | SURFLON S-131* | | | | | 3 | | | | | |
| | SURFLON S-141* | | | | | | 3 | | | | |
| Surfactant | EMALE X 710 | 2 | 2 | 2 | 2 | 2 | 2 | 2 | 2 | 2 | 2 |
| Solvent | water | 1600 | 1600 | 1600 | 1600 | 1600 | 1600 | 1600 | 1600 | 1600 | 1600 |

| | | | | | | | | | | | |
|---|---|---|---|---|---|---|---|---|---|---|---|
| PVA-105: manufactured by Kuraray, (degree of saponification 98% by mol, degree of polymerization 500). Luvitec VA64W: (vinylpyrrolidone-vinyl acetate copolymer, manufactured by ICP). EMALEX 710: manufactured by Nihon Emulsion K.K., surfactant. SURFLON S-111N*: manufactured by SEI CHEMICAL Co., Ltd., perfluoroalkylcarbonic salt. *: 30% solution. SURFLON S-121*: manufactured by SEI CHEMICAL Co., Ltd., perfluoroalkylphosphoric ester. *: 30% solution. SURFLON S-131*: manufactured by SEI CHEMICAL Co., Ltd., perlluaroalkylbetaine. *: 30% solution. SURFLON S-141*: manufactured by SEI CHEMICAL Co., Ltd., perfluoroalkylamine oxide. *: 30% solution. | | | | | | | | | | | |

### [Evaluation]

The resulting photosensitive lithographic printing plates were evaluated in sensitivity, printing resistance and storage stability as in Example 1. Moreover, feeding properties (autoloader suitability) were evaluated in the following manner. Table 5 shows the evaluation results.

### (Feeding properties: Autoloader suitability)

500 sheets of a laminate composed of a photosensitive lithographic printing plate and a paper board were loaded on a cassette and fed from the cassette to the development and exposure parts with an autoloader. Then the number of sheets which were not properly fed (jamming) was examined.

**Table 5**

| | Ex.11 | Ex.12 | Ex.13 | Ex.14 | Ex.15 | Ex.16 | Ex.17 | Ex.18 | Ex.19 | C.Ex.3 |
|---|---|---|---|---|---|---|---|---|---|---|
| Protective layer | 11 | 12 | 13 | 14 | 15 | 16 | 17 | 18 | 19 | Comparative protective layer 2. |
| Sensitivity (half tone dot area) | 55 | 54 | 55 | 55 | 54 | 55 | 55 | 55 | 55 | 55 |
| Printing resistance (x 10⁴ sheets) | 14 | 15 | 14 | 14 | 14 | 14 | 16 | 14 | 14 | 16 |
| Storage stability: half tone dot fluctuation (%): | 0 | 0 | 0 | 0 | 0 | 0 | 1 | 1 | 1 | 9 |
| Autoloader suitability | 0 | 0 | 1 | 0 | 1 | 0 | 0 | 0 | 0 | 12 |

### [Examples 20 to 21 and Comparative Example 4]

Lithographic printing plates of Examples 20 to 21 and Comparative Example 4 were obtained in the same manner as in Example 11, but substituting the polymer binder B-1 in the photopolymerizable composition P-1 by B-2 as will be described hereinafter and then forming the protective layers listed in Table 6. Then, evaluation was conducted as in Example 11. Table 6 shows the evaluation results.

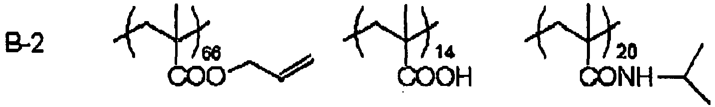

**[Table 6]**

| | Protective layer | Sensitivity (halftone dot are) | Printing resistance (x10⁴ sheets) | Storage stability: half tone dot fluctuation (%) | Autoloader suitability |
|---|---|---|---|---|---|
| Ex. 9 | 11 | 52 | 14 | 0 | 0 |
| Ex. 10 | 12 | 52 | 15 | 0 | 0 |
| Comp.Ex. 4 | Comparative protective layer 2 | 52 | 15 | 9 | 14 |

As Tables 5 and 6 clearly indicate, all of the photosensitive lithographic printing plates of the invention were excellent in sensitivity and printing resistance and showed favorable storage stability and favorable autoloader suitability, i.e., establishing satisfactory results.

## Claims

1. A photosensitive lithographic printing plate comprising:
a hydrophilic support; a photosensitive layer; and a protective layer, provided in this order; the photosensitive layer comprising a compound having an ethylenically unsaturated double bond and a polymer binder, and the protective layer containing a water-soluble poly(meth)acrylic ester;
**characterised in that** the water-soluble poly(meth)acrylic ester is a compound represented by the following formula (P): 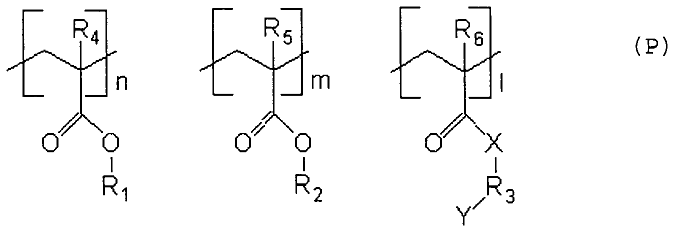 wherein R₁ and R₂ each independently represents an alkyl group having not more than 5 carbon atoms; R₃ represents a linking group; R₄, R₅ and
R₆ each independently represents a hydrogen atom or a methyl group; X represents an oxygen atom, a sulphur atom or NH; Y represents -SO₃M, -PO₃M or -COOM; M represents an alkali metal or ammonium; and the indices n, m and l represent the ratios of the three units constituting the ester (P) with the proviso that either n or m may be 0.

2. A photosensitive lithographic printing plate according to Claim 1, wherein the protective layer further contains a fluorine-containing surfactant.

3. A photosensitive lithographic printing plate according to Claim 2, wherein the fluorine-containing surfactant is a compound having a perfluoroalkyl group.

4. A photosensitive lithographic printing plate according to any preceding claim, wherein the water-soluble poly(meth)acrylic ester has at least one group capable of imparting water solubility which is a sulphonic acid salt, a phosphoric acid salt or a carboxylic acid salt.

5. A photosensitive lithographic printing plate according to any preceding claim, wherein the polymer binder is an alkaline water-soluble or swelling binder.

6. A photosensitive lithographic printing plate according to Claim 5, wherein the alkaline water-soluble or swelling polymer binder has a crosslinking group.

7. A photosensitive lithographic printing plate according to any preceding claim, wherein the compound having an ethylenically unsaturated double bond has two or more ethylenically unsaturated double bonds.

## Patentansprüche

1. Lichtempfindliche Lithografiedruckplatte, umfassend:
einen hydrophilen Träger, eine lichtempfindliche Schicht und eine Schutzschicht, die in dieser Reihenfolge angeordnet sind; wobei die lichtempfindliche Schicht eine Verbindung mit einer ethylenisch ungesättigten Doppelbindung und ein polymeres Bindemittel umfasst und
die Schutzschicht einen wasserlöslichen Poly(meth)acrylsäureester enthält;
**dadurch gekennzeichnet, dass** der wasserlösliche Poly(meth)acrylsäureester eine Verbindung mit der folgenden Formel (P) ist: 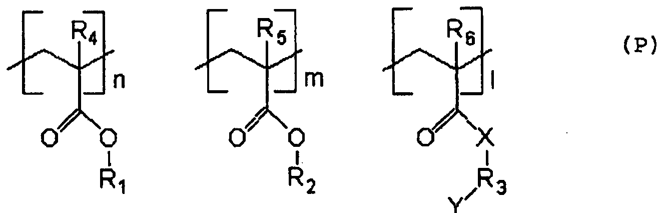 worin R₁ und R₂ jeweils unabhängig voneinander für eine Alkylgruppe mit nicht mehr als 5 Kohlenstoffatomen stehen; R₃ für eine verbindende Gruppe steht; R₄, R₅ und R₆ jeweils unabhängig voneinander für ein Wasserstoffatom oder eine Methylgruppe stehen; X für ein Sauerstoffatom, ein Schwefelatom oder NH steht; Y für -SO₃M, -PO₃M oder -COOM steht; M für ein Alkalimetall oder Ammonium steht; und die Indizes n, m und 1 für die Verhältnisse der drei den Ester (P) bildenden Einheiten stehen, mit der Maßgabe, dass entweder n oder m = 0 sein darf.

2. Lichtempfindliche Lithografiedruckplatte gemäß Anspruch 1, in der die Schutzschicht zusätzlich ein fluorhaltiges Tensid enthält.

3. Lichtempfindliche Lithografiedruckplatte gemäß Anspruch 2, in der das fluorhaltige Tensid eine Verbindung mit einer Perfluoralkylgruppe ist.

4. Lichtempfindliche Lithografiedruckplatte gemäß einem der vorhergehenden Ansprüche, in der der wasserlösliche Poly(meth)acrylsäureester mindestens eine Gruppe zur Wasserlöslichkeitsvermittlung aufweist, die ein Sulfonsäuresalz, ein Phosphorsäuresalz oder ein Carbonsäuresalz ist.

5. Lichtempfindliche Lithografiedruckplatte gemäß einem der vorhergehenden Ansprüche, in der das polymere Bindemittel ein alkalisches wasserlösliches Bindemittel oder ein Quellbindemittel ist.

6. Lichtempfindliche Lithografiedruckplatte gemäß Anspruch 5, in der das alkalische wasserlösliche Bindemittel oder das Quellbindemittel eine vernetzbare Gruppe aufweist.

7. Lichtempfindliche Lithografiedruckplatte gemäß einem der vorhergehenden Ansprüche, in der die Verbindung mit einer ethylenisch ungesättigten Doppelbindung zwei oder mehr ethylenisch ungesättigte Doppelbindungen aufweist.

## Revendications

1. Plaque d'impression lithographique photosensible comprenant un support hydrophile, une couche photosensible, et une couche de protection, prévus dans cet ordre ; la couche photosensible comprenant un composé ayant une liaison double éthyléniquement insaturée et un liant polymère, et la couche de protection contenant un ester poly(méth)acrylique soluble dans l'eau ;
**caractérisée en ce que** l'ester poly(méth)acrylique soluble dans l'eau est un composé représenté par la formule (P) suivante : 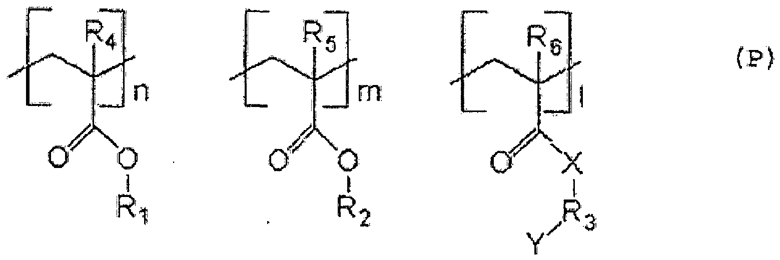 dans laquelle R₁ et R₂ représentent chacun indépendamment un groupe alkyle n'ayant pas plus de 5 atomes de carbone ; R₃ représente un groupe de liaison ; R₄, R₅ et R₆ représentent chacun indépendamment un atome d'hydrogène ou un groupe méthyle ; X représente un atome d'oxygène, un atome de soufre ou NH ; Y représente - SO₃M, -PO₃M ou -COOM ; M représente un métal alcalin ou un ammonium ; et les indices n, m et 1 représentent les rapports des trois unités constituant l'ester (P) à condition que soit n, soit m puisse être 0.

2. Plaque d'impression lithographique photosensible selon la revendication 1, dans laquelle la couche de protection contient en outre un agent tensioactif contenant du fluor.

3. Plaque d'impression lithographique photosensible selon la revendication 2, dans laquelle l'agent tensioactif contenant du fluor est un composé ayant un groupe perfluoroalkyle.

4. Plaque d'impression lithographique photosensible selon une quelconque revendication précédente, dans laquelle l'ester poly(méth)acrylique soluble dans l'eau a au moins un groupe apte à impartir une solubilité dans l'eau qui est un sel d'acide sulfonique, un sel d'acide phosphorique ou un sel d'acide carboxylique.

5. Plaque d'impression lithographique photosensible selon une quelconque revendication précédente, dans laquelle le liant polymère est un liant alcalin soluble dans l'eau ou gonflant.

6. Plaque d'impression lithographique photosensible selon la revendication 5, dans laquelle le liant polymère alcalin soluble dans l'eau ou gonflant a un groupe de réticulation.

7. Plaque d'impression lithographique photosensible selon une quelconque revendication précédente, dans laquelle le composé ayant une liaison double éthyléniquement insaturée a deux liaisons doubles éthyléniquement insaturées ou plus.
